(19) Europäisches Patentamt / European Patent Office / Office européen des brevets

(11) **EP 1 995 294 A1**

(12) **EUROPEAN PATENT APPLICATION**
published in accordance with Art. 158(3) EPC

(43) Date of publication:
**26.11.2008 Bulletin 2008/48**

(51) Int Cl.:
**C09K 11/59** *(2006.01)*  **C09K 11/08** *(2006.01)*
**H01L 33/00** *(2006.01)*  **H01J 61/44** *(2006.01)*

(21) Application number: **07714017.6**

(22) Date of filing: **09.02.2007**

(86) International application number:
**PCT/JP2007/052405**

(87) International publication number:
**WO 2007/091687 (16.08.2007 Gazette 2007/33)**

(84) Designated Contracting States:
**DE**

(30) Priority: **10.02.2006 JP 2006034393**
**07.09.2006 JP 2006243165**

(71) Applicant: **Mitsubishi Chemical Corporation**
**Minato-ku**
**Tokyo 108-0014 (JP)**

(72) Inventors:
• **YOSHINO, Masahiko**
**Yokohama-shi**
**Kanagawa 227-8502 (JP)**

• **MIURA, Chisato**
**Yokohama-shi**
**Kanagawa 227-8502 (JP)**
• **KIJIMA, Naoto**
**Yokohama-shi**
**Kanagawa 227-8502 (JP)**
• **KOMURO, Naoyuki**
**Ushiku-shi**
**Ibaraki 300-1295 (JP)**

(74) Representative: **HOFFMANN EITLE**
**Patent- und Rechtsanwälte**
**Arabellastrasse 4**
**81925 München (DE)**

(54) **PHOSPHOR, METHOD FOR PRODUCING SAME, PHOSPHOR-CONTAINING COMPOSITION, LIGHT-EMITTING DEVICE, IMAGE DISPLAY, AND ILLUMINATING DEVICE**

(57) To provide a phosphor emitting green fluorescence and having such superior characteristics as excellent conversion efficiency of blue light or near-ultraviolet light and excellent color purity,
a phosphor satisfying the following conditions (i) to (v) :
(i) the wavelength of emission peak thereof is 510 nm or longer and 542 nm or shorter, when excited with light of 400 nm or 455 nm
(ii) the full width at half maximum of emission peak thereof is 75 nm or narrower, when excited with light of 400 nm or 455 nm,
(iii) the external quantum efficiency, which is defined by the formula below, is 0.42 or larger, when excited with light of 400 nm or 455 nm,

$$(\text{external quantum efficiency}) = (\text{internal quantum efficiency}) \times (\text{absorption efficiency})$$

(iv) a part of its surface comprises substance containing oxygen, and
(v) it contains a bivalent and trivalent metal element ($M^{II}$ element), and its molar ratio to the total bivalent elements is larger than 1 % and smaller than 15 %.

EP 1 995 294 A1

## Description

Technical Field

The present invention relates to a phosphor that emits green fluorescence and a production method thereof, a phosphor-containing composition and light emitting device using the phosphor, and a display and lighting system using the light emitting device. More particularly, it relates to a green phosphor suitable for a back-lighting of a liquid crystal, a phosphor-containing composition and light emitting device using the green phosphor, and a display and lighting system using the light emitting device.

Background Art

White light, which is essential in use for a lighting system and display, is generally obtained by mixing blue, green and red light emissions in accordance with the additive mixing principle of light. In a back-lighting of a color liquid-crystal display, which is a field of use for displays, it is desirable that each of blue, green and red luminous bodies has as high emission intensity as possible and good color purity, in order to reproduce colors having wide range of color coordinates efficiently. For example, NTSC (National Television Standard Committee) is known, which is a standard of color reproduction range of TV.

In these years, attempts have been made to use semiconductor light emitting devices as light sources of these three colors. However, use of semiconductor light emitting devices for all the three colors is not common because it requires a circuit for compensating a color shift occurring during use. Therefore, it is practical to obtain desired colors of blue, green and red using phosphors by the wavelength conversion of light which is emitted from a semiconductor luminous element. Specifically, methods are known, in which blue, green and red luminescences are obtained using a light source of near-ultraviolet semiconductor luminous element, and in which blue light from the semiconductor luminous element is used just as it is and green and red lights are obtained by wavelength conversion using phosphors.

Among these three colors, green is particularly important compared to the other two colors because it is especially high in luminosity factor to human eyes and it greatly contributes brightness of the entire display.

A phosphor emitting green fluorescence (hereinafter referred to as "green phosphor" as appropriate) has desirably the center wavelength of its fluorescence in the range of usually 498 nm or longer, preferably 510 nm or longer, and usually 550 nm or shorter, preferably 540 nm or shorter. As such green phosphor, the following can be cited, for example: europium-activated alkaline-earth silicon oxynitrides phosphors represented by $(Mg,Ca,Sr,Ba)Si_2O_2N_2:Eu$, and europium-activated alkaline-earth magnesium silicate phosphors represented by $(Ba,Ca,Sr,Mg)_2SiO_4:Eu$.

However, it is difficult for these previously known green phosphors to meet requirements about brightness or chromaticity, therefore they have not been put to practical uses so far.

Patent Document 1 discloses $SrBaSiO_4:Eu$, as a known art of a phosphor that can emit green light by wavelength conversion of near-ultraviolet light or blue light from a semiconductor luminous element.

However, these phosphors in this Patent Document 1 contain 0.0001 weight % to 5 weight % of Eu, more specifically, 0.9 weight % of Eu in Example 1 and 0.8 weight % in Example 2, both of which have about 1 mole percent of Eu contents relative to the total amount of bivalent elements. The phosphors are low in brightnesses as well as narrow in color reproduction ranges, and thus they are insufficient for the above requirements.

In addition, Patent Document 1 discloses that change in compositions of Ba, Sr and Ca of that phosphor can vary the wavelength. However, any of the phosphors that are prepared with such compositions and producing methods as described in the Examples can not meet the requirements about both color reproduction range and brightness, due to their low conversion efficiencies of blue light and near-ultraviolet light.

Patent Document 1: U.S. Patent No. 6982045

Disclosure of the Invention

Problem to Be Solved by the Invention

An wavelength of emission peak present at around 525 nm, high emission efficiency and as narrow full width at half maximum as possible are demanded of green phosphor to be used for lighting systems and displays. However, existing green phosphors, typified by the one described in the above Patent Document 1, are insufficient both in conversion efficiency of blue or near-ultraviolet light and in color purity. Therefore, a green phosphor having superior characteristics enough to satisfy the above requirements has been desired.

The present invention has been made in view of the above problems. The object thereof is to provide a phosphor which emits green fluorescence, having such superior characteristics as excellent conversion efficiency of blue or near-ultraviolet light and excellent color purity, as well as to provide a phosphor-containing composition and light emitting device using the phosphor, and further to provide a display and lighting system using the light emitting device.

Means for Solving the Problem

The present inventors have made an elaborate investigation on the constituent ratios of alkaline-earth metal elements and activation elements in view of the above problems. In consequence, they have found that a phosphor with a specific composition range and a non-luminous object color satisfying a specific condition shows a preferable chromaticity for a green phosphor, as well as high color purity and brightness.

A phosphor that satisfies the above requirements can be characterized in that the peak shape of its emission spectrum is sharp. The phosphor found by the present inventors is narrow in full width at half maximum of its emission spectrum peak, and therefore it meets the above requirements.

Furthermore, the present inventors have found that the phosphor exhibits excellent characteristics enough to be used as a green light source and thus it can be preferably used for a light emitting device or the like, which led to the completion of the present invention.

Namely, the subject matter of the present invention lies in a phosphor satisfying the following conditions (i) to (v) (Claim 1):

(i) the wavelength of emission peak thereof is 510 nm or longer and 542 nm or shorter, when excited with a light of which peak wavelength is 400 nm or 455 nm,

(ii) the full width at half maximum of the emission peak thereof is 75 nm or narrower, when excited with a light of which peak wavelength is 400 nm or 455 nm,

(iii) the external quantum efficiency, which is defined by the formula below, is 0.42 or larger, when excited with a light of which peak wavelength is 400 nm or 455 nm,

$$\text{(external quantum efficiency)} = \text{(internal quantum efficiency)} \times \text{(absorption efficiency)}$$

(iv) at least a part of the surface of said phosphor comprises substance containing oxygen, and

(v) said phosphor contains a metal element (hereinafter referred to as "$M^{II}$ element") of which valence can be 2 or 3 and the molar ratio of said $M^{II}$ element, to the total number of moles of bivalent elements contained in said phosphor, is larger than 1 % and smaller than 15 %.

In this case, it is preferable that the CIE color coordinates x and y of its luminescent color falls within the following ranges respectively, when excited with a light of which peak wavelength is 400 nm or 455 nm (Claim 2).
$0.210 \leq x \leq 0.330$, and
$0.480 \leq y \leq 0.670$

Further, it is preferable that said phosphor contains at least Ba as the bivalent element (hereinafter referred to as "$M^{I}$ element"), and the molar ratios of Ba and Sr, represented by [Ba] and [Sr] respectively, to the whole $M^{I}$ elements satisfy the condition of

$$0.5 < \{[Ba]/([Ba]+[Sr])\} \leq 1$$

(Claim 3).

Another subject matter of the present invention lies in a phosphor having a chemical composition represented by the formula [1] below, wherein $L^{*}$, $a^{*}$ and $b^{*}$, when the non-luminous object color is represented by $L^{*}$, $a^{*}$ and $b^{*}$ color space (sic), satisfy the conditions of
$L^{*} \geq 90$,
$a^{*} \leq -20$,
$b^{*} \geq 30$, and

$$\{a^{*}/b^{*}\} \leq -0.45$$

(Claim 4).

[Chemical Formula 1]

$$(M^{I}{}_{(1-x)}M^{II}{}_{x})_{\alpha}SiO_{\beta} \qquad [1]$$

(In the above formula [1],

$M^{I}$ represents one or more element(s) selected from the group consisting of Ba, Ca, Sr, Zn and Mg,

$M^{II}$ represents one or more metal(s) element of which valence can be 2 or 3, and

$x$, $\alpha$ and $\beta$ are the numbers falling within the following ranges, respectively:

$0.01 < x < 0.3$,

$1.5 \leq \alpha \leq 2.5$, and

$3.5 \leq \beta \leq 4.5$.)

In this case, it is preferable that said phosphor is produced by firing a phosphor precursor in the presence of a flux (Claim 5).

Further, it is preferable that said phosphor is produced by firing a phosphor precursor in a highly reducing atmosphere (Claim 6).

Further, it is preferable that, in the above formula [1], $M^{I}$ contains at least Ba, and the molar ratio of said Ba to the entire $M^{I}$ is 0.5 or larger and smaller than 1 (Claim 7).

Further, it is preferable that in the above formula [1], $M^{I}$ contains at least Ba and Sr, and the molar ratios of Ba and Sr, represented by [Ba] and [Sr] respectively, to the whole $M^{I}$ elements satisfy the condition of

$$0.5 < \{[Ba]/([Ba]+[Sr])\} \leq 1$$

(Claim 8).

Further, it is preferable that the weight-average median diameter of said phosphor is 10 $\mu$m or larger and 30 $\mu$m or smaller (Claim 9).

Further, it is preferable that, other than the elements included in the above formula [1], at least one element selected from the group consisting of elements having valence of 1, 2, 3, -1 and -3 is further contained, and the total content of such element is 1 ppm or more (Claim 10).

Particularly, it is preferable that, other than the elements included in the above formula [1], at least one element selected from the group consisting of alkali metal element, alkaline-earth metal element, zinc (Zn), yttrium (Y), aluminium (Al), scandium (Sc), phosphorus (P), nitrogen (N), rare-earth element and halogen element is further contained, and the total content of such element is 1 ppm or more (Claim 11).

Another subject matter of the present invention lies in a method for producing the above-mentioned phosphor, comprising a step of: firing a phosphor precursor in an atmosphere of which oxygen concentration is 100 ppm or lower (Claim 12).

Still another subject matter of the present invention lies in a method for producing the above-mentioned phosphor, comprising a step of: firing a phosphor precursor in the presence of a solid carbon (Claim 13).

In this case, it is preferable that other than sources for the $M^{I}$, $M^{II}$ and Si, two or more kinds of compounds are used, which are selected from the group consisting of a compound including monovalent element or atomic group and minus monovalent element, compound including monovalent element or atomic group and minus trivalent element or atomic group, compound including bivalent element and minus monovalent element, compound including bivalent element and minus trivalent element or atomic group, compound including trivalent element and minus monovalent element, and compound including trivalent element and minus trivalent element or atomic group (Claim 14).

Further, it is preferable that other than sources for the $M^{I}$, $M^{II}$ and Si, two or more kinds of compounds are used, which are selected from the group consisting of an alkali metal halide, alkaline-earth metal halide, zinc halide, halide of trivalent element selected from the group consisting of Y, Al, Sc and rare-earth element, alkali metal phosphate, alkaline-earth metal phosphate, zinc phosphate, and phosphate of trivalent element selected from the group consisting of Y, Al, La and Sc (Claim 15).

Further, it is preferable that a flux having crystal growth promoting effect and a flux having crystal growth inhibiting effect are used in combination (Claim 16).

Still another subject matter of the present invention lies in a phosphor-containing composition comprising the above-mentioned phosphor and a liquid medium (Claim 17).

Still another subject matter of the present invention lies in a light emitting device comprising a first luminous body and a second luminous body which emits visible light when irradiated with light from said first luminous body, wherein said second luminous body comprises, as a first phosphor, at least one kind of the above-mentioned phosphor (Claim 18).

In this case, it is preferable that said second luminous body comprises, as a second phosphor, at least one kind of a phosphor of which wavelength of emission peak is different from that of said first phosphor (Claim 19).

In that case, it is preferable that said first luminous body has an emission peak in the range of 420 nm or longer and 500 nm or shorter, and said second luminous body comprises, as the second phosphor, at least one kind of a phosphor having an emission peak in the range of 570 nm or longer and 780 nm (Claim 20) or shorter.

Further, it is preferable that said first luminous body has an emission peak in the range of 300 nm or longer and 420 nm or shorter, and said second luminous body comprises, as the second phosphor, at least one kind of a phosphor having an emission peak in the range of 420 nm or longer and 470 nm or shorter and at least one kind of a phosphor having an emission peak in the range of 570 nm or longer and 780 nm or shorter (Claim 21).

Further, it is preferable that said first luminous body has an emission peak in the range of 420 nm or longer and 500 nm or shorter, and said second luminous body comprises, as the second phosphor, at least one kind of a phosphor having an emission peak in the range of 580 nm or longer and 620 nm or shorter(Claim 22).

Still another subject matter of the present invention lies in a display comprising the above-mentioned light emitting device as a light source (Claim 23).

Still another subject matter of the present invention lies in a lighting system comprising the above-mentioned light emitting device as a light source (Claim 24).

Advantageous Effect of the Invention

According to the present invention, a phosphor which emits green fluorescence and has such superior characteristics as excellent conversion efficiency of blue light or near-ultraviolet light and excellent color purity can be provided. In addition, use of a composition containing the phosphor can provide a light emitting device with high efficiency and superior characteristics. This light emitting device can be preferably used for a display or a lighting system.

Brief Description of the Drawings

[Fig. 1] Fig. 1 is a schematic perspective view illustrating the positional relationship between an excitation light source (first luminous body) and a phosphor-containing part (second luminous body), in an example of the light emitting device of the present invention.

[Fig. 2] Both Fig. 2(a) and Fig. 2(b) are schematic sectional views illustrating an example of the light emitting device comprising an excitation light source (first luminous body) and a phosphor-containing part (second luminous body).

[Fig. 3] Fig. 3 is a sectional view schematically illustrating an embodiment of the lighting system of the present invention.

[Fig. 4] Fig. 4 is an exploded sectional view schematically illustrating the substantial part of the display of an embodiment of the present invention.

[Fig. 5] Fig. 5 is an exploded sectional view schematically illustrating the substantial part of the display of another embodiment of the present invention.

[Fig. 6] Fig. 6 is a graph illustrating the emission spectra of the phosphors in Examples 4, 6 and Comparative Examples 1, 2.

[Fig. 7] Fig. 7 is a graph illustrating the excitation spectra of the phosphors in Examples 12 and 22.

[Fig. 8] Fig. 8 is a graph illustrating the emission spectrum of white light of the light emitting device in Example 40.

[Fig. 9] Fig. 9 is a graph illustrating the emission spectrum of the light emitting device in Example 41. [Fig. 10] Fig. 10 is a graph illustrating the emission spectrum of white light of the light emitting device in Example 42.

[Fig. 11] Fig. 11 is a graph illustrating the emission spectrum of white light of the light emitting device in Example 43.

[Fig. 12] Fig. 12 is graphs illustrating the X-ray powder diffraction spectrum of the phosphor in Reference Example 2A.

[Fig. 13] Fig. 13 is graphs illustrating the X-ray powder diffraction spectrum of the phosphor in Reference Example 2B.

[Fig. 14] Fig. 14 is a graph illustrating the emission spectra of the phosphors in Reference Examples 2A, 2B when excited by a light with 455 nm-wavelength.

Explanation of Letters or Numerals

1: second luminous body
2: surface emitting type GaN-based LD
3: substrate
4: light emitting device
5: mount lead
6: inner lead
7: first luminous body
8: phosphor-containing resinous part
9: conductive wire
10: mold member
11: surface-emitting lighting system
12: holding case
13: light emitting device
14: diffusion plate
15: display
16: light source
17R, 17G, 17B: phosphor parts
17-1: transparent substrate
17-2: black matrix layer
18: frame
19: polarizer
20: optical shutter
20-1: back electrode
20-2: liquid crystal layer
20-3: front electrode
21: analyzer
22: first luminous body
23: phosphor-containing resinous part
24: frame
25: conductive wire
26,27: electrode

Best Modes for Carrying Out the Invention

The present invention will be described in detail below. However, the present invention is not at all limited to the below description, but any modification can be made without departing from the scope of the invention.

Each composition formula of phosphors in this Description is punctuated by a comma (,).Further, when two or more elements are juxtaposed with a comma (,) in between, one kind of or two or more kinds of the juxtaposed elements can be contained in any combination and in any composition. In this context, the total content of the elements juxtaposed in parentheses is 1 mol. For example, a composition formula "$(Ba,Sr,Ca)Al_2O_4:Eu$" inclusively indicates all of "$BaAl_2O_4:Eu$", "$SrAl_2O_4:Eu$", "$CaAl_2O_4:Eu$", "$Ba_{1-x}Sr_xAl_2O_4:Eu$", "$Ba_{1-x}Ca_xAl_2O_4:Eu$", "$Sr_{1-x}Ca_xAl_2O_4:Eu$" and "$Ba_{1-x-y}Sr_xCa_yAl_2O_4:Eu$" (here, in these formulae, $0<x<1$, $0<y<1$, $0<x+y<1$).

All the relationships between color names and their color coordinates in this Description comply with Japanese Industrial Standards (JIS Z8110 and JIS Z8701).

[1. Phosphor]

The phosphor according to an aspect of the present invention (hereinafter referred to as "specific-property phosphor of the present invention" or simply as "specific-property phosphor" as appropriate) satisfies the requirements to be described later regarding its wavelength of emission peak, full width at half maximum of the emission peak, external quantum efficiency, at the time of excitation with light of a specific wavelength, and its composition.

The phosphor according to another aspect of the present invention (hereinafter referred to as "specific-composition phosphor of the present invention" or simply as "specific-composition phosphor" as appropriate) satisfies the requirements to be described later regarding its composition and non-luminous object color.

The phosphor of the present invention corresponds either to the "specific-property phosphor" or to the "specific-composition phosphor". However, it is preferable that it corresponds to both of the "specific-property phosphor" and "specific-composition phosphor".

In the following, explanation will be given on each of the "specific-property phosphor" and "specific-composition phosphor" separately, if necessary. When the "specific-property phosphor" and "specific-composition phosphor" are not specially distinguished, they are collectively referred to as "phosphor of the present invention".

In this context, it should be noted that the words "specific-property phosphor" and "specific-composition phosphor" are used just for convenience of explanation, and therefore they have no influences on the phosphor of the present invention.

[1-1. Specific-property phosphor]

The specific-property phosphor of the present invention has such properties as described below.

<Properties regarding emission spectrum>

The specific-property phosphor has the following properties regarding emission spectrum when excited with light of 400nm or 455nm peak wavelength, in consideration of its application to a green phosphor.

First, the specific-property phosphor has the peak wavelength $\lambda_p$ (nm) of the above-mentioned emission spectrum in the range of usually 510 nm or longer, preferably 518 nm or longer, more preferably 520 nm or longer, and usually 542 nm or shorter, preferably 528 nm or shorter, more preferably 525 nm or shorter (hereinafter this requirement will be called "requirement (i)" as appropriate). When the wavelength of emission peak $\lambda_p$ is too short, the color tends to be bluish green. On the other hand, when it is too long, the color tends to be yellowish green. In both cases, its characteristics, at the time of use for emitting green light, may deteriorate.

In addition, the relative intensity of emission peak (hereinafter referred to as "relative emission-peak intensity" as appropriate) of the specific-property phosphor is usually 75 or larger, preferably 85 or larger, and more preferably 95 or larger. This relative emission-peak intensity is shown by the ratio of its emission intensity, when the emission intensity of the luminescence of $BaMgAl_{10}O_{17}$:Eu (product number: LP-B4) manufactured by Kasei Optonics, Ltd. at the time of excitation with 365nm wavelength light is 100. The higher the relative emission-peak intensity is, the more preferable.

Furthermore, the specific-property phosphor has a characteristic of narrow full width at half maximum (hereinafter abbreviated as "FWHM" as appropriate) of the emission peak in the above-mentioned emission spectrum. A phosphor with narrow FWMH, which means superior color purity, can be excellently used for a back-lighting, for example.

More specifically, FWHM of the specific-property phosphor is in the range of usually 10 nm or wider, preferably 20 nm or wider, more preferably 25 nm or wider, and usually 75 nm or narrower, preferably 70 nm or narrower, more preferably 65 nm or narrower, still more preferably 60 nm or narrower (hereinafter this requirement will be called "requirement (ii)" as appropriate). When FWHM is too narrow, the brightness may decrease. When it is too wide, the color purity may decrease.

For exciting a phosphor with light having peak wavelength of 400 nm or 455 nm, a GaN-based light-emitting diode can be used, for example.

The measurement of emission spectrum of a phosphor and the calculation of its wavelength of emission peak, relative peak intensity and full width at half maximum of the peak can be carried out, for example, by using a fluorescence measurement apparatus (manufactured by JASCO corporation) equipped with an excitation light source of 150W xenon lamp and a spectrum measurement apparatus of multichannel CCD detector C7041 (manufactured by Hamamatsu Photonics K.K.).

<Absorption efficiency $\alpha_q$, internal quantum efficiency $\eta_i$, external quantum efficiency $\eta_o$>

(Absorption efficiency $\alpha_q$)

The absorption efficiency (hereinafter represented by "$\alpha_q$" as appropriate) means the ratio of the number of photons absorbed in a phosphor to the number of photons in the light (excitation light) emitted from the excitation light source (which corresponds to the "first luminous body" to be described later).

The higher its absorption efficiency $\alpha_q$ is, the more preferable the specific-property phosphor is. Concretely, it is preferable that the absorption efficiency $\alpha_q$, when exciting the specific-property phosphor with a light having peak wavelength of 400 nm or 455 nm, is usually 0.55 or larger, preferably 0.6 or larger, and more preferably 0.75 or larger. When the absorption efficiency $\alpha_q$ of a phosphor is too small, the quantity of the excitation light necessary for a predetermined level of phosphor emission tends to be too large, leading to a large amount of energy consumption. Method for measuring the absorption efficiency $\alpha_q$ of a phosphor is as described later.

(Internal quantum efficiency $\eta_i$)

The internal quantum efficiency (hereinafter represented by "$\eta_i$" as appropriate) means the ratio of the number of photons emitted from a phosphor to the number of photons in the excitation light absorbed into the phosphor.

The higher its internal quantum efficiency $\eta_i$ is, the more preferable the specific-property phosphor is. Concretely, it is preferable that the internal quantum efficiency $\eta_i$, when exciting the specific-property phosphor with a light having peak wavelength of 400 nm or 455 nm, is usually 0.57 or larger, preferably 0.69 or larger, and more preferably 0.79 or larger. When the internal quantum efficiency $\eta_i$ of a phosphor is too small, the quantity of the excitation light necessary for a predetermined level of phosphor emission tends to be too large, leading to a large amount of energy consumption.
Method for measuring the internal quantum efficiency $\eta_i$ of a phosphor is as described later.

(External quantum efficiency $\eta_o$)

The external quantum efficiency (hereinafter represented by "$\eta_o$" as appropriate) means the ratio of the number of photons emitted from a phosphor to the number of photons in the excitation light. This value corresponds to the product of the aforementioned absorption efficiency $\alpha_q$ and the aforementioned internal quantum efficiency $\eta_i$. Namely, the external quantum efficiency $\eta_o$ is defined by the following formula.

$$(\text{External quantum efficiency } \eta_o) = (\text{internal quantum efficiency } \eta_i) \times (\text{absorption efficiency } \alpha_q)$$

The specific-property phosphor is characterized by high external quantum efficiency $\eta_o$.
Concretely, the external quantum efficiency $\eta_o$, when exciting the specific-property phosphor with a light having peak wavelength of 400 nm or 455 nm, is usually 0.42 or larger, preferably 0.50 or larger, more preferably 0.55 or larger, and still more preferably 0.65 or larger (hereinafter this requirement will be called "requirement (iii)" as appropriate). When the external quantum efficiency $\eta_o$ of a phosphor is too small, the quantity of the excitation light necessary for a predetermined level of phosphor emission tends to be too large, leading to a large amount of energy consumption.
Method for measuring the external quantum efficiency $\eta_o$ of a phosphor is as described later.

<Method for measuring absorption efficiency $\alpha_q$, internal quantum efficiency $\eta_i$ and external quantum efficiency $\eta_o$>

In the following, methods for determining the absorption efficiency $\alpha_q$, internal quantum efficiency $\eta_i$ and external quantum efficiency $\eta_o$ of a phosphor will be described.
First, a phosphor sample to be measured (for example powder of a phosphor) is stuffed up in a cell with its surface smoothed sufficiently enough to keep high measurement accuracy, and then it is set on a condenser such as an integrating sphere. The reason for using a condenser such as an integrating sphere is to count up all the photons both reflected at the phosphor sample and emitted by the fluorescence phenomenon from the phosphor sample. In other words, it is to prevent the failure in counting photons going out of the measurement system.
A light emission source for exciting the phosphor sample is attached on the condenser. An Xe lamp can be used as the light emission source, for example. This light emission source is adjusted using a filter, monochromator (grating monochromator) or the like so that the wavelength of emission peak thereof will be that of a monochromatic light of, for example, 405 nm or 455 nm.
Then the spectra including those of emitted light (fluorescence) and reflected light is measured, using a spectrometer (such as MCPD7000 manufactured by Otsuka Electronics Co., Ltd.) by irradiating the phosphor sample to be measured with the above-mentioned light from the light emission source, of which wavelength of emission peak is adjusted. The light, of which spectrum is measured here, actually includes reflected lights that are not absorbed in the phosphor and lights (fluorescences) having different wavelengths which are emitted, by a fluorescence phenomenon from the phosphor which absorbed the excitation light, among lights from the excitation light source (hereinafter simply referred to as "excitation lights"). Namely, the region of the excitation light corresponds to the reflection spectrum, and the region of longer wavelengths than that corresponds to the fluorescence spectrum (it is occasionally referred to as "emission spectrum").
Absorption efficiency $\alpha_q$ is calculated by dividing $N_{abs}$ by $N$, wherein $N_{abs}$ is the number of photons of the excitation light that is absorbed in the phosphor sample and $N$ is the number of all the photons in the excitation light. A concrete calculation method is as follows.
First, the latter one, the total number $N$ of all the photons in the excitation light is determined as follows. That is, the reflection spectrum (hereinafter represented by "$I_{ref}(\lambda)$") is measured, using the above spectrometer, for a substance having reflectance $R$ of approximately 100 % to the excitation light, such as a white reflection plate "Spectralon" manufactured by Labsphere (with 98 % of reflectance to an excitation light of 450 nm wavelength), by means of attaching it to the above-mentioned condenser in the same disposition as the phosphor sample.

Then the numeric value represented by the (formula I) below is determined from this reflection spectrum $I_{ref}$ ($\lambda$). The numeric value represented by the (formula I) below is proportional to N, the total number of photons in the excitation light.

[Mathematical Formula 1]

$$\frac{1}{R}\int \lambda \cdot I_{ref}(\lambda)d\lambda$$

(formula I)

In the above formula (I), the integration may be performed limitedly at such intervals that $I_{ref}(\lambda)$ takes a substantially significant value.

On the other hand, $N_{abs}$, the number of photons of the excitation light that is absorbed in the phosphor sample, is proportional to the amount calculated by the following (formula II).

[Mathematical Formula 2]

$$\frac{1}{R}\int \lambda \cdot I_{ref}(\lambda)d\lambda - \int \lambda \cdot I(\lambda)d\lambda$$

(formula II)

In the above (formula II), "$I(\lambda)$" is a reflection spectrum at a time when the phosphor sample, of which absorption efficiency $\alpha_q$ is intended to be measured, is attached to the condenser.

The integration interval in the above (formula II) is set in the same way as in the above (formula I). By restricting the integration interval as above, the second term in the above (formula II) comes to the value corresponding to the number of photons coming from the measurement object, phosphor sample, by reflection of the excitation light. In other words, it comes to the value corresponding to the number of all photons coming from the measurement object, phosphor sample, except the number of photons originating from fluorescence phenomenon. Because the actual measurement value of the spectrum is generally obtained as digital data which are divided by a certain finite band width which is related to $\lambda$, the integrations of the above (formula I) and (formula II) are calculated as finite sum, based on the band width.

Consequently, the absorption efficiency $\alpha_q$ can be determined by the following formula.

Absorption efficiency $\alpha_q$ = $N_{abs}/N$ = (formula II)/(formula I)

Next, a method for determining internal quantum efficiency $\eta_i$ will be described.

The internal quantum efficiency $\eta_i$ takes the value calculated by dividing $N_{PL}$ by $N_{abs}$, wherein $N_{PL}$ is the number of photons originating from the fluorescence phenomenon and $N_{abs}$ is the number of photons absorbed in the phosphor sample.

Here, $N_{PL}$ is proportional to the amount calculated by the following (formula III).

[Mathematical Formula 3]

$$\int \lambda \cdot I(\lambda)d\lambda$$

(formula III)

At this point, the integration interval of the above (formula III) is restricted to the wavelength region of photons that originates from the fluorescence phenomenon of the phosphor sample. This is because contribution of the reflecting photons from the phosphor sample should be eliminated from $I(\lambda)$.

More specifically, the lower limit of the integration interval in the above (formula III) takes the value of upper limit of the integration interval in the above (formula I), and the upper limit thereof takes the value that is necessary and sufficient for including photons originating from the fluorescence.

Consequently, the internal quantum efficiency $\alpha_q$ (sic) can be determined by the following formula.

$$\eta_i = (formula\ III)/(formula\ II)$$

Incidentally, the integration from spectra expressed by digital data can be performed in the same way as when absorption efficiency $\alpha_q$ is calculated.

The external quantum efficiency $\eta_o$ can be determined as the product of the absorption efficiency $\alpha_q$ and internal quantum efficiency $\eta_i$, which are obtained by the above-mentioned procedure.

The external quantum efficiency $\eta_o$ can also be calculated by the following relational expression.

$$\eta_o = (formula\ III)/(formula\ I)$$

Namely, the external quantum efficiency $\eta_o$ is equal the value calculated by dividing $N_{PL}$ by $N$, wherein $N_{PL}$ is the number of photons originating from the fluorescence and $N$ is the number of total photons in the excitation light.

<Surface property of phosphor>

At least a part of, or preferably substantially entire the surface of the specific-property phosphor comprises substance containing oxygen (hereinafter this requirement will be called "requirement (iv)" as appropriate).

For example when the specific-property phosphor is an oxide phosphor or an oxynitride phosphor, the surface of the phosphor will naturally comprise substance containing oxygen. Further on the surface of such oxide phosphor or oxynitride phosphor, a coating of calcium phosphate, silica or the like can be applied.

On the other hand, when the specific-property phosphor is a nitride phosphor or a sulfide phosphor, it is preferred that at least a part of the surface of the phosphor is made to comprise substance containing oxygen by coating the surface with calcium phosphate, silica or the like. However, if the surface of the phosphor is oxidized to form an oxide film during pulverization process or the like, such a coating is not done in a positive manner.

When a substance containing oxygen in the surface of the specific-property phosphor is in a state of a film, it is preferable that the thickness of the film is usually 10 nm or longer, preferably 30 nm or longer, and usually 1 $\mu$m or shorter, preferably 500 nm or shorter.

<Metal element of which valence can be 2 or 3>

The specific-property phosphor contains, as its one component, one or more kinds of metal element(s) (hereinafter referred to as "$M^{II}$" as appropriate) of which valence can be 2 or 3. $M^{II}$ serves as activation element. As concrete examples of $M^{II}$, the following can be cited: transition metal elements such as Cr and Mn; and rare-earth elements such as Eu, Sm, Tm and Yb. $M^{II}$ can include any one kind of these elements singly or two or more kinds of them in any combination and in any ratio. Among them, Sm, Eu and Yb are preferable as the $M^{II}$. Particularly preferable is Eu.

It is preferable that the molar ratio of the bivalent elements to the whole $M^{II}$ (namely, the sum of the bivalent elements and trivalent elements) is usually 0.5 or larger, preferably 0.7 or larger, and more preferably 0.8 or larger. It is usually smaller than 1. The closer to 1 it is, the more preferable. When the molar ratio of the bivalent elements to the whole $M^{II}$ is too small, the emission efficiency tends to be lower. This is probably because the trivalent elements absorb emission energy in the crystal, though both bivalent and trivalent elements are taken up in the crystal lattice.

Concerning the content of $M^{II}$ in the specific-property phosphor, the molar ratio of the $M^{II}$, to the total number of moles of bivalent elements contained in the specific-property phosphor, is in the range of usually larger than 1 %, preferably 4 % or larger, more preferably 6 % or larger, and usually smaller than 15 %, preferably 10 % or smaller, more preferably 8 % or smaller (hereinafter this requirement will be called "requirement (v)" as appropriate). When the content of the $M^{II}$ is too small, the emission intensity tends to be lower. On the other hand, when the content of the $M^{II}$ is too large, the emission intensity tends to decrease.

<Color coordinate>

The luminescent color of the specific-property phosphor can be expressed using an x and y color system (CIE 1931 color system), which is one of CIE color coordinate.

Concretely, it is preferable that the CIE color coordinate x of the specific-property phosphor is usually 0.210 or larger, preferably 0.240 or larger, more preferably 0.263 or larger, and usually 0.330 or smaller, preferably 0.310 or smaller, more preferably 0.300 or smaller.

In addition, it is preferable that the CIE color coordinate y of the specific-property phosphor is usually 0.480 or larger, preferably 0.490 or larger, more preferably 0.495 or larger, and usually 0.670 or smaller, preferably 0.660 or smaller, more preferably 0.655 or smaller.

When the CIE color coordinates x and y are within the above ranges, such an advantage as wide color reproduction range, at the time of white light synthesis, can be achieved.

The CIE color coordinates x and y of a phosphor can be calculated from the emission spectrum in the wavelength range of from 480 nm to 800 nm in accordance with JIS Z8724.

<Composition>

The specific-property phosphor contains, as its one component, at least one kind of metal element ($M^{II}$) of which valence can be 2 or 3, as described above. It may further comprise other elements.

As elements which the specific-property phosphor may contain other than $M^{II}$, the following can be cited: Si, Ge, Ga, Al, B, P, Tb, Pr, Ag, La, Sm, O, N, S, bivalent elements other than $M^{II}$ (hereinafter referred to as "$M^I$" as appropriately) and the like. The specific-property phosphor can include any one kind of these elements other than $M^{II}$ singly or two or more kinds of them in any combination and in any ratio. Among them, it is preferable Si and $M^I$ are contained in the specific-property phosphor.

Preferable examples of $M^I$ include Ba, Ca, Sr, Zn and Mg. The specific-property phosphor can include any one kind of these $M^I$s singly or two or more kinds of them in any combination and in any ratio. Among these $M^I$s, it is preferable that at least Ba is contained in the specific-property phosphor. It is more preferable that at least Ba and Sr are contained in it.

Concerning the molar ratios of Ba and Sr relative to the whole $M^I$ elements of the specific-property phosphor, represented by [Ba] and [Sr] respectively, it is preferable the [Ba] ratio to the sum of [Ba] and [Sr], namely the value of [Ba]/([Ba]+[Sr]), is usually larger than 0.5, preferably 0.6 or larger, more preferably 0.65 or larger, and usually 1 or smaller, preferably 0.9 or smaller, more preferably 0.8 or smaller. When the value of [Ba]/([Ba]+[Sr]) is too small (namely, when the proportion of Ba is too small), the wavelength of emission peak of the phosphor tends to shift to longer wavelength side and the full width at half maximum tends to increase. On the other hand, when the value of [Ba]/([Ba]+[Sr]) is too large (namely, when the proportion of Ba is too large), the wavelength of emission peak of the phosphor tends to shift to shorter wavelength side.

Furthermore, when the specific-property phosphor contains Sr as $M^I$, a part of the Sr may be substituted with Ca. Change in the proportion between Sr and Ca tends to vary the luminescent color, and therefore a proper adjustment of the proportion between Sr and Ca can change the luminescent color adequately. For example, as one preferable example of the proportion, molar ratio of Ca relative to Sr, contained in the specific-property phosphor, may be usually 20 % or smaller and preferably 10 % or smaller.

In addition to the above described properties, the specific-property phosphor may possess any one or more of the properties of the specific-composition phosphor to be described later. Moreover, the specific-property phosphor may correspond to the specific-composition phosphor to be described later.

[1-2. Specific-composition phosphor]

On the other hand, the specific-composition phosphor of the present invention has such properties as described below.

<Composition>

The specific-composition phosphor is characterized in that it has a chemical composition represented by the formula [1] below.
[Chemical Formula 2]

$$(M^I_{(1-x)} M^{II}_x)_\alpha Si O_\beta \qquad [1]$$

(In the above formula [1], $M^I$ represents one or more element(s) selected from the group consisting of Ba, Ca, Sr, Zn and Mg. $M^{II}$ represents one or more metal element(s) of which valence can be 2 or 3. x, $\alpha$ and $\beta$ are the numbers falling within the following ranges, respectively: $0.01<x<0.3$, $1.5\leq\alpha\leq2.5$, and $3.5\leq\beta\leq4.5$.)

In the above formula [1], $M^I$ represents one or more element(s) selected from the group consisting of Ba, Ca, Sr, Zn and Mg. $M^I$ can include any one kind of these elements singly or two or more kinds of them in any combination and in any ratio.

Among them, it is preferable that $M^I$ includes at least Ba. In this case, it is preferable that the molar ratio of Ba relative to the total $M^I$ is in the range of usually 0.5 or more, particularly 0.55 or more, more particularly 0.6 or more, and usually less than 1, particularly 0.97 or less, more particularly 0.9 or less, and still more particularly 0.8 or less. When the molar ratio of the Ba is too large, the wavelength of emission peak tends to shift to shorter wavelength side. On the other hand, when the molar ratio of the Ba is too small, the emission efficiency tends to be lower.

Particularly, it is preferable that $M^I$ includes at least Ba and Sr. Concerning the molar ratios of Ba and Sr to the whole $M^I$ elements, represented by [Ba] and [Sr] respectively, it is preferable the [Ba] ratio to the sum of [Ba] and [Sr], namely the value of [Ba]/([Ba]+[Sr]), is usually larger than 0.5, preferably 0.6 or larger, more preferably 0.65 or larger, and usually 1 or smaller, preferably 0.9 or smaller, more preferably 0.8 or smaller. When the value of [Ba]/([Ba]+[Sr]) is too small (namely, when the proportion of Ba is too small), the wavelength of emission peak of the phosphor tends to shift to longer wavelength side and the full width at half maximum tends to increase. On the other hand, when the value of [Ba]/([Ba]+[Sr]) is too large (namely, when the proportion of Ba is too large), the wavelength of emission peak of the phosphor tends to shift to shorter wavelength side.

In addition, it is preferable the relative ratio between [Ba] and [Sr], namely the value of [Ba]/[Sr], is usually larger than 1, particularly 1.2 or larger, more particularly 1.5 or larger, and still more particularly 1.8 or larger, and usually 15 or smaller, particularly 10 or smaller, more particularly 5 or smaller, still more particularly 3.5 or smaller. When the value of [Ba]/[Sr] is too small (namely, when the proportion of Ba is too small), the wavelength of emission peak of the phosphor tends to shift to longer wavelength side and the full width at half maximum tends to increase. On the other hand, when the value of [Ba]/[Sr] is too large (namely, when the proportion of Ba is too large), the wavelength of emission peak of the phosphor tends to shift to shorter wavelength side.

Furthermore, in the above formula [1], when the $M^I$ contains at least Sr, a part of the Sr may be substituted with Ca. In such a case, it is preferable that the substitution amount of Ca, in terms of molar ratio of Ca substitution amount to the total amount of Sr, is usually 10 % or smaller, particularly 5 % or smaller, more particularly 2 % or smaller. When the substitution ratio of Ca is too large, the luminescence tends to be yellowish, leading to lower emission efficiency.

A part of the Si may be substituted with some other element such as Ge. However, from the standpoint of the green emission intensity or the like, it is preferable that the substitution ratio of Si with other element is as low as possible. More specifically, the other element such as Ge may be contained in the ratio of 20 mole percent or lower relative to the amount of Si. More preferably, all elements are Si.

In the above formula [1], $M^{II}$, the component serving as activation element, represents one or more metal elements of which valence can be 2 or 3. Concrete examples of $M^{II}$ include: transition metal elements such as Cr and Mn; and rare-earth elements such as Eu, Sm, Tm and Yb. $M^{II}$ can include any one kind of these elements singly or two or more kinds of them in any combination and in any ratio. Among them, Sm, Eu and Yb are preferable as the $M^{II}$. Particularly preferable is Eu. It is preferable that the molar ratio of the bivalent elements to the whole $M^{II}$ (namely, the sum of the bivalent elements and trivalent elements) is usually 0.5 or larger, preferably 0.7 or larger, and more preferably 0.8 or larger. It is usually smaller than 1. The closer to 1 it is, the more preferable. When the molar ratio of the bivalent elements to the whole $M^{II}$ is too small, the emission efficiency tends to be lower. This is probably because the trivalent elements absorb emission energy in the crystal, though both bivalent and trivalent elements are taken up in the crystal lattice.

In the above formula [I], x represents the number of moles of $M^{II}$. Specifically, it is usually larger than 0.01, preferably 0.04 or larger, more preferably 0.05 or larger, still more particularly 0.06 or larger, and usually smaller than 0.3, preferably 0.2 or smaller, more preferably 0.16 or smaller. When the value x is too small, the emission intensity tends to be lower. On the other hand, when the value x is too large, the emission intensity tends to decrease.

In the above formula [1], $\alpha$ is preferably close to 2. Actually, it is in the range of usually 1.5 or larger, preferably 1.7 or larger, more preferably 1.8 or larger, and usually 2.5 or smaller, preferably 2.2 or smaller, more preferably 2.1 or smaller. When the value $\alpha$ is either too small or too large, a heterophase crystal tends to emerge, leading to decrease in luminescent characteristics.

In the above formula [1], $\beta$ is in the range of usually 3.5 or larger, preferably 3.8 or larger, more preferably 3.9 or larger, and usually 4.5 or smaller, preferably 4.4 or smaller, more preferably 4.1 or smaller. When the value $\beta$ is either too small or too large, a heterophase crystal tends to emerge, leading to decrease in luminescent characteristics.

The specific-composition phosphor may further contain, other than the elements included in the above formula [1], namely other than $M^I$, $M^{II}$, Si (silicon) and O (oxygen), an element (hereinafter referred to as "trace element" as appropriate) selected from the group consisting of elements having valence of 1, 2, 3, -1 or -3.

Particularly, as the trace element, at least one element selected from the group consisting of alkali metal element, alkaline-earth metal element, zinc (Zn), yttrium (Y), aluminium (Al), scandium (Sc), phosphorus (P), nitrogen (N), rare-earth element and halogen element may be preferably contained.

The total content of the above trace element is usually 1 ppm or more, preferably 3 ppm or more, more preferably 5 ppm or more, and usually 100 ppm or less, preferably 50 ppm or less, more preferably 30 ppm or less. When the specific-composition phosphor contains plural kinds of trace elements, the total amount of them is adjusted to be in the above range.

Concrete examples of preferable composition of the specific-composition phosphor are listed in the following Table 1. However, the composition of the specific-composition phosphor is not limited to the following examples.

[Table 1]

Table 1

| | $M^I$ | | $M^{II}$ | | | |
|---|---|---|---|---|---|---|
| | Ba | Sr | Eu | $\alpha$ | $M^{II}/\alpha$ | Ba/Sr |
| Example 1 | 1.39 | 0.46 | 0.15 | 2 | 0.075 | 2 |
| Example 2 | 1.28 | 0.64 | 0.075 | 2 | 0.038 | 2 |
| Example 3 | 1.29 | 0.65 | 0.060 | 2 | 0.030 | 2 |
| Example 4 | 1.80 | 0.14 | 0.060 | 2 | 0.030 | 2 |
| Example 5 | 1.31 | 0.66 | 0.025 | 2 | 0.013 | 2 |
| Example 6 | 1.85 | 0 | 0.15 | 2 | 0.075 | $\infty$ |

Further, the specific-composition phosphor may contain, other than the above-mentioned elements, one or more element(s) selected from the group consisting of Tb, Ag, La, Sm and Pr. Among these, it is preferable that Tb and/or Pr are contained.

When Tb is contained in the specific-composition phosphor, the brightness retention rate at high temperatures will increase and the temperature characteristics will be excellent. Furthermore, utilizing this phosphor, to be described later, durability increases and long-term illumination of a light emitting device becomes possible.

It is preferable that the content of Tb to 1 mole of the phosphor is usually 0.0001 mole percent or more, particularly 0.001 mole percent or more, more particularly 0.01 mole percent or more, and usually 5 mole percent or less, particularly 1 mole percent or less, more particularly 0.5 mole percent or less.

When the content of Tb is too large, the effect of improving temperature characteristics tends to decrease. When the content of Tb is too small, the effect of improving durability may decrease.

When Pr is contained in the specific-composition phosphor, the external quantum efficiency will be improved. It is preferable that the content of Pr to 1 mole of the phosphor is usually 0.0001 mole percent or more, particularly 0.001 mole percent or more, more particularly 0.01 mole percent or more, and usually 5 mole percent or less, particularly 1 mole percent or less, more particularly 0.5 mole percent or less.

When the content of Pr is too large, concentration quenching is likely to occur, leading to decrease in brightness. When the content of Pr is too small, the effect of improving external quantum efficiency may decrease.

Further, the specific-composition phosphor may contain Al, as other element than the above-mentioned elements. The content of Al is usually 1 ppm or more, preferably 5 ppm or more, more preferably 10 ppm or more, and usually 500 ppm or less, preferably 200 ppm or less, more preferably 100 ppm or less.

Further, the specific-composition phosphor may contain B (boron), as other element than the above-mentioned elements. The content of B is usually 1 ppm or more, preferably 3 ppm or more, more preferably 5 ppm or more, and usually 100 ppm or less, preferably 50 ppm or less, more preferably 30 ppm or less.

Further, the specific-composition phosphor may contain Fe, as other element than the above-mentioned elements. The content of Fe is usually 1 ppm or more, preferably 3 ppm or more, more preferably 5 ppm or more, and usually 100 ppm or less, preferably 50 ppm or less, more preferably 30 ppm or less.

Further, the specific-composition phosphor may contain N, as other element than the above-mentioned elements. The content of N to the amount of oxygen contained in the phosphor, is usually 10 mole percent or less, preferably 5 mole percent or less, more preferably 3 mole percent or less.

<Non-luminous object color>

Another characteristic of the specific-composition phosphor is that the values of L*, a* and b* of its non-luminous object color, which is represented by the $L^*$ $a^*$ and $b^*$ color space (CIE 1976 color space), satisfy the following formulae:
L*≥90,
a*≤-20,
b*≥30, and

$$\{a*/b*\} \leq -0.45.$$

With the non-luminous object color of the specific-composition phosphor satisfying the above-mentioned conditions, a light emitting device to be described later, utilizing the phosphor, having high emission efficiency can be achieved.

More specifically, the upper limit of a* of the specific-composition phosphor is usually -20 or smaller, preferably -22 or smaller, more preferably - 24 or smaller, still more preferably -30 or smaller. A phosphor with too large a* has a tendency of its entire luminous flux becoming smaller. Also from the standpoint of higher brightness, it is preferable that the value a* is smaller.

The value b* of the specific-composition phosphor is usually 30 or larger, preferably 40 or larger, more preferably 45 or larger, still more preferably 50 or larger. When the b* is too small, the brightness tends to decrease. On the other hand, the upper limit of b* is theoretically 200 or smaller, but it is preferable that it is usually 120 or smaller. When the b* is too large, the luminous wavelength tends to shift to longer wavelength side, leading possibly to decrease in emission intensity.

The ratio between a* and b* of the specific-composition phosphor, namely the value represented by a*/b*, is in the range of usually -0.45 or smaller, preferably -0.5 or smaller, more preferably -0.55 or smaller. With too large a*/b*, the non-luminous object color tends to be yellowish, as well as the brightness tends to decrease.

The value L* of the specific-composition phosphor is usually 90 or larger, and preferably 95 or larger. When the value L* is too small, the emission tends to be weaker. On the other hand, the upper limit of L* does not exceed 100 because the measurement objects of L* are usually non-luminous objects, which do not generally emit lights by excitation of irradiation lights. However, in the specific-composition phosphor, since luminescence excited by the irradiation light is superimposed on the reflected light, the value L* thereof may exceed 100. Specifically, the upper limit of L* of the specific-composition phosphor is usually 115 or smaller.

The non-luminous object color of the specific-composition phosphor can be measured with, for example, a commercially available apparatus for measuring non-luminous object color (such as CR-300, manufactured by MINOLTA).

The non-luminous object color means a color of a substance when light is reflected thereon. In the present invention, the values of L*, a* and b* are determined by irradiating the measurement object (namely, the phosphor) with a predetermined light source (a white light source, for example, standard illuminant $D_{65}$) and separating the obtained reflected light with a filter.

The non-luminous object color relates to the reduction degree (which is indicated by the molar ratio of the bivalent elements relative to the total $M^{II}$, for example) of the phosphor material. It is thought that a phosphor with high reduction degree (for example, a phosphor with high molar ratio of bivalent elements relative to the total $M^{II}$) shows a non-luminous object color in the above-mentioned range. A phosphor having a non-luminous object color in the above-mentioned range can be obtained by the production method of the present invention including firing the phosphor material in a highly reducing atmosphere such as in the presence of a solid carbon or the like, as described later.

<Characteristics about excitation wavelength>

There is no special limitation on the excitation wavelength of the specific-composition phosphor. However, it is preferable that it can be excited by a light of which wavelength range is usually 300 nm or longer, particularly 350 nm or longer, more particularly 380 nm or longer, and usually 500 nm or shorter, particularly 480 nm or shorter, more particularly 470 or shorter. For example when it can be excited by a light of blue region and/or near-ultraviolet region, it can be preferably used for a light emitting device of which first luminous body is a semiconductor luminous element or the like.

Incidentally, the excitation spectrum can be measured using a fluorescence spectrophotometer of F-4500 type (manufactured by Hitachi, Ltd.) at room temperatures such as 25 °C. From the obtained excitation spectrum, the excitation peak wavelength can be calculated.

<Weight median diameter>

It is preferable that the weight-average median diameter of the specific-composition phosphor is in the range of usually 10 $\mu$m or larger, preferably 12 $\mu$m or larger, and usually 30 $\mu$m or smaller, preferably 25 $\mu$m or smaller. When the weight-average median diameter is too small, the brightness tends to decrease and the phosphor particles tend to aggregate. On the other hand, the weight-average median diameter is too large, unevenness in coating, clogging in a dispenser or the like tend to occur. The weight-average median diameter of the specific-composition phosphor can be measured using a laser diffraction/scattering particle size distribution analyzer, for example.

<Crystallite diameter>

The larger the crystallite diameter of the specific-composition phosphor is, the more preferable. It is preferable that it is usually 20 nm or larger, and particularly 100 nm or larger. In this context, a crystallite diameter can be determined by measuring the full width at half maximum in the X-ray powder diffraction. It is thought that, at interfaces between crystallites, non-radiative deactivations occur and emission energies are converted to thermal energies. When a crystallite is large, the amount of thermal energy converted will be small, due to the small crystallite interface, leading to high brightness.

<Temperature characteristics>

Some specific-composition phosphors are also superior in temperature characteristics, for example when they contain Tb as mentioned above. More specifically, when irradiated with light having wavelength of 455 nm, the ratio of the peak intensity value of the emission at 100 °C in the emission spectral map to the brightness at 25 °C, is usually 50 % or more, preferably 60 % or more, and particularly preferably 70 % or more.

Furthermore, though it is hard to be considered that this ratio of a usual phosphor exceeds 100 % because its emission intensity decreases with increasing temperature, it can exceed 100 % for some reason. However, over 150 % of that ratio tends to lead color shift due to the temperature change.

The above-mentioned temperature characteristics can be examined as follows, for example, using an emission spectrum measurement device of multi-channel spectrum analyzer, MCPD7000, manufactured by Otsuka Electronics Co., Ltd., a stage equipped with a cooling mechanism using a peltier device and a heating mechanism using a heater, and a light source device equipped with a 150W xenon lamp. A cell holding the phosphor sample is put on the stage, and the temperature is changed within the range of from 20 °C to 180 °C. After verifying the surface temperature of the phosphor is held constant at the predetermined temperature, the emission spectrum of the phosphor is measured, which is excited with a light from the light source having wavelength of 455 nm, separated using a diffraction grating. Then the emission peak intensity can be decided from the measured emission spectrum. At this point, as the measurement value of the surface temperature of the phosphor, a value corrected by utilizing temperature values measured with a radiation thermometer and a thermocouple was used.

<Durability>

The specific-composition phosphor is also superior in durability. It is more superior in durability particularly when it contains Tb as mentioned above. Specifically, it is preferable that the value of "emission intensity of green peak / emission intensity of blue peak" of a light emitting device constructed using the specific-composition phosphor at the time of 1000 hours, when the value of "emission intensity of green peak / emission intensity of blue peak" at the time just after turning on (0 hour) is 100%, is usually 85 % or larger, more preferably 90 % or larger, still more preferably 95 % or larger.

Incidentally, the above-mentioned durability can be measured for example by the following procedure. At the time just after turning on (hereinafter referred to as "0 hour") of the light emitting device, the emission spectrum and color coordinate are measured using a fiber multi-channel spectroscope (USB2000, manufactured by Ocean Optics, Inc.). After the light emitting device is lit on continuously for 1000 hours with driving current of 20 mA at a temperature of 85 °C and relative humidity of 85 %, using an aging system, LED AGING SYSTEM 100ch LED environment tester (YEL-51005, manufactured by Yamakatsu Electronics Industry Co., Ltd.), the emission spectrum and color coordinate are measured again using a fiber multi-channel spectroscope (USB2000, manufactured by Ocean Optics, Inc.). By calculating the ratio of the emission intensity of the green peak (originating from the phosphor) to the emission intensity of the blue peak (originating from the LED), namely "emission intensity of green peak / emission intensity of blue peak", of each measured emission spectrum, the value of the "emission intensity of green peak / emission intensity of blue peak" at the time of 1000 hours, when the value of the "emission intensity of green peak / emission intensity of blue peak" at 0 hour is 100%, is determined.

In addition to the above described characteristics, the specific-composition phosphor may possess any one or more of the properties of the specific-property phosphor described before. Moreover, the specific-composition phosphor may correspond to the specific-property phosphor described before.

[1-3. Production method of phosphor]

Materials, production method and the like, for obtaining the phosphor of the present invention, are as follows.

The production method of the phosphor of the present invention is not particularly limited. For example, the phosphor of the present invention, represented by the aforementioned formula [1], can be produced as follows. After weighing out each of material of metal element $M^I$ (hereinafter referred to as "$M^I$ source" as appropriate), material of Si (hereinafter referred to as "Si source" as appropriate) and material of activation element $M^{II}$ (hereinafter referred to as "$M^{II}$ source" as appropriate), they are mixed (mixing step). The mixture obtained (hereinafter referred to as "phosphor precursor" as appropriate) is fired under the predetermined firing condition (firing step). Then the fired product is given such treatments as pulverization, washing and surface treatment, as needed.

When the phosphor of the present invention has constituent elements different from those described as the aforementioned formula [1], an appropriate change in materials or the like enables the production by the following production method.

<Phosphor material>

Examples of $M^I$ source, Si source and $M^{II}$ source, used to produce the phosphor of the present invention include: oxide, hydroxide, carbonate, nitrate, sulfate, oxalate, carboxylate and halide of each element of $M^I$, Si and $M^{II}$. Of these compounds, preferable ones are to be selected in consideration of reactivity to composite oxide and the amount of $NO_x$, $SO_x$ or the like generated at the time of firing.

Concrete examples of $M^I$ source that can be listed in terms of kinds of $M^I$ metals are as follows.

Concrete examples of Ba source include: BaO, $Ba(OH)_2 \cdot 8H_2O$, $BaCO_3$, $Ba(NO_3)_2$, $BaSO_4$, $Ba(C_2O_4) \cdot 2H_2O$, $Ba(OCOCH_3)_2$ and $BaCl_2$. Among them, $BaCO_3$, $BaCl_2$ and the like are preferable. $BaCO_3$ is particularly preferable from the standpoint of easy handling. This is because it is stable in air and easily decomposed by heat, resulting in making it hard to leave any undesirable elements, and its highly purified material is easily available. When carbonate is used as the material, it is preferable to calcine temporarily the carbonate preliminarily before used as material.

Concrete examples of Ca source include CaO, $Ca(OH)_2$, $CaCO_3$, $Ca(NO_3)_2 \cdot 4H_2O$, $CaSO_4 \cdot 2H_2O$, $Ca(C_2O_4) \cdot H_2O$, $Ca(OCOCH_3)_2 \cdot H_2O$ and $CaCl_2$. Of these, preferable are $CaCO_3$, $CaCl_2$ and the like. When carbonate is used as the material, it is preferable to calcine temporarily the carbonate preliminarily before used as material.

Concrete examples of Sr source include SrO, $Sr(OH)_2 \cdot 8H_2O$, $SrCO_3$, $Sr(NO_3)_2$, $SrSO_4$, $Sr(C_2O_4) \cdot H_2O$, $Sr(OCOCH_3)_2 \cdot 0.5H_2O$ and $SrCl_2$. Of these, preferable are $SrCO_3$, $SrCl_2$ and the like. $SrCO_3$ is particularly preferable. This is because it is stable in air and easily decomposed by heat, resulting in making it hard to leave no undesirable elements, and its highly purified material is easily available. When carbonate is used as the material, it is preferable to calcine temporarily the carbonate preliminarily before used as material.

Concrete examples of Zn source include: ZnO, $Zn(C_2O_4) \cdot 2H_2O$ and $ZnSO_4 \cdot 7H_2O$.

Concrete examples of Mg source include: $MgCO_3$, MgO, $MgSO_4$ and $Mg(C_2O_4) \cdot 2H_2O$. When carbonate is used as the material, it is preferable to calcine temporarily the carbonate preliminarily before used as material.

These $M^I$ sources can be used either as a single one or as a mixture of two or more kinds in any combination and in any ratio.

Concrete examples of Si source include: $SiO_2$, $H_4SiO_4$ and $Si(OCOCH_3)_4$. Among them, preferable are $SiO_2$ and the like.

These Si sources can be used either as a single one or as a mixture of two or more kinds in any combination and in any ratio.

Among the $M^{II}$ sources, concrete examples of Eu source include $Eu_2O_3$, $Eu_2(SO_4)_3$, $Eu_2(C_2O_4)_3$, $EuCl_2$, $EuCl_3$ and $Eu(NO_3)_3 \cdot 6H_2O$. Among them, preferable are $Eu_2O_3$, $EuCl_2$ and the like.

Concrete examples of the sources of Sm, Tm, Yb and the like include the compounds cited as the concrete examples of the Eu source, in which Eu is replaced by Sm, Tm, Yb and the like respectively.

These $M^{II}$ sources can be used either as a single one or as a mixture of two or more kinds in any combination and in any ratio.

In addition, compounds containing other elements can be used as materials, depending on the composition of the phosphor of the present invention to be obtained.

For example when producing a phosphor containing Ge in its composition, concrete examples of the Ge source include: $GeO_2$, $Ge(OH)_4$, $Ge(OCOCH_3)_4$ and $GeCl_4$. Among them, preferable are $GeO_2$ and the like.

For example when producing a phosphor containing Tb in its composition, concrete examples of the Tb source include: $Tb_4O_7$, $TbCl_3$ (including its hydrate), $TbF_3$, $Tb(NO_3)_3 \cdot nH_2O$, $Tb_2(SiO_4)_3$ and $Tb_2(C_2O_4)_3 \cdot 10H_2O$. Among them, preferable are $Tb_4O_7$, $TbCl_3$ and $TbF_3$, and particularly preferable is $Tb_4O_7$. For example when producing a phosphor containing Pr in its composition, concrete examples of the Pr source include $Pr_2O_3$, $PrCl_3$, $PrF_3$, $Pr(NO_3)_3 \cdot 6H_2O$, $Pr_2(SiO_4)_3$ and $Pr_2(C_2O_4)_3 \cdot 10H_2O$. Among them, preferable are $Pr_2O_3$, $PrCl_3$ and $PrF_3$, and particularly preferable is $Pr_2O_3$. For example when producing a phosphor containing Ga in its composition, concrete examples of the Ga source include $Ga_2O_3$, $Ga(OH)_3$, $Ga(NO_3)_3 \cdot nH_2O$, $Ga_2(SO_4)_3$ and $GaCl_3$. For example when producing a phosphor containing Al in its composition, concrete examples of the Al source include $Al_2O_3$ such as $\alpha$-$Al_2O_3$ and $\gamma$-$Al_2O_3$, $Al(OH)_3$, AlOOH, $Al(NO_3)_3 \cdot 9H_2O$, $Al_2(SO_4)_3$ and $AlCl_3$. For example when producing a phosphor containing P in its composition, concrete examples of the P source include: $P_2O_5$, $Ba_3(PO_4)_2$, $Sr_3(PO_4)_2$ and $(NH_4)_3PO_4$. For example when producing a phosphor containing B in its composition, concrete examples of the B source include: $B_2O_3$ and $H_3BO_3$.

These compounds containing other elements can be used either as a single one or as a mixture of two or more kinds in any combination and in any ratio.

<Mixing step>

No particular limitation is imposed on the method of mixing the $M^I$ source, Si source and $M^{II}$ source. As its concrete examples, the following (A) dry-type methods and (B) wet-type methods can be cited.

(A) Dry-type mixing methods in which the above-mentioned materials are pulverized and mixed by combining pulverization, which is done by means of a dry-type pulverizer such as a hammer mill, roll mill, ball mill and jet mill, or pestle / mortar, and mixing, which is done by means of a mixing apparatus such as ribbon blender, V type blender and Henschel mixer, or pestle / mortar.

(B) Wet-type mixing methods in which solvents or dispersion media such as water, methanol or ethanol are added to the above-mentioned materials, and mixing is done by means of a pulverizer, pestle / mortar, evaporation dish / stirring rod or the like, to make a solution or slurry, followed by drying the solution or slurry by such method as spray dry, heated dry or air dry.

<Firing step>

The firing step is usually done by the following procedure. Namely, the mixture obtained in the above-mentioned mixing step is filled into a heat-resistant vessel such as a crucible or tray which is made of material unlikely to react with each phosphor material and then fired. Material examples of such heat-resistant vessel used at the time of firing include ceramics such as alumina, quartz, boron nitride, silicon carbide, silicon nitride and magnesium oxide, metal such as platinum, molybdenum, tungsten, tantalum, niobium, iridium and rhodium, alloys mainly constituted of these metals and carbon (graphite). Of these, a heat-resistant vessel made of quartz can be used for heat treatment at relatively low temperatures such as 1200 °C or lower, and the preferable temperature range of its use is 1000 °C or lower. Among the above-cited materials of the heat-resistant vessel, preferable are alumina and metals.

The firing temperature is in the range of usually 850 °C or higher, preferably 950 °C or higher, and usually 1400 °C or lower, preferably 1350 °C or lower. When the firing temperature is too low, the crystal may not grow fully, leading possibly to the smaller particle diameter. On the other hand, when the firing temperature is too high, the crystal may grow to be too large, leading possibly to the too large particle diameter.

The pressure at the time of firing differs depending on such factors as firing temperature and therefore is not limited specially However, it is usually 0.01 MPa or higher, preferably 0.1 MPa or higher, and usually 200 MPa or lower, preferably 100 MPa or lower. Industrially, around from atmospheric pressure to 1 MPa is convenient and preferable from the standpoint of cost and convenience.

The firing time differs depending on the temperature or pressure at the time of firing and therefore is not limited specially. However, it is in the range of usually 10 minutes or longer, preferably 1 hour or longer, more preferably 3 hours or longer, still more preferably 4 hours or longer, and usually 24 hours or shorter, more preferably 15 hours or shorter.

No particular limitation is imposed on the kind of atmosphere at the time of firing. However, in the present invention, it is preferable that the firing is carried out under an atmosphere with low oxygen concentration as described later. The oxygen concentration at the time of firing is preferably 100 ppm or lower, more preferably 50 ppm or lower, and particularly preferably 20 ppm or lower. It is ideally preferable that no oxygen exists. Concretely, the firing is performed under an atmosphere consisting of either a single gas such as carbon monoxide, carbon dioxide, nitrogen, hydrogen and argon or a mixed atmosphere of two or more kinds of these gases, for example. Among them, it is preferable that the atmosphere contains a reducing gas such as carbon monoxide and hydrogen. It is particularly preferable that the firing is performed under nitrogen atmosphere containing hydrogen.

At this point, it is preferable that the hydrogen content in the above nitrogen atmosphere containing hydrogen is usually 1 volume % or more, preferably 2 volume % or more, and usually 5 volume % or less. The most preferable content of hydrogen is 4 volume %.When the atmosphere contains hydrogen too much, explosion may occur. When the content is too low, sufficient reducing atmosphere may not be secured.

Furthermore, at the time of firing of the present invention, it is desirable to make the atmosphere of firing a reducing atmosphere such hydrogen-containing nitrogen. It is further desirable to make the atmosphere highly reductive by the presence of solid carbon in the reaction system, for example, thus decreasing oxygen concentration. This will be described in more detail in and after the following section.

(Solid carbon)

In producing the phosphor of the present invention, an appropriate atmosphere is to be selected so that the activation element $M^{II}$ of the present invention is in an ion state (valence) contributing to light emission. For example, at least a part of activation element Eu, which is one of the preferable $M^{II}$ elements bringing about green light emission of the phosphor of the present invention, is preferably in a state of bivalent ion. Concretely, the ratio of $Eu^{2+}$ in the whole Eu, which is preferably as high as possible, is usually 50 % or higher, preferably 80 % or higher, more preferably 90 % or higher, the most preferably 95 % or higher. However, usually, compounds containing trivalent Eu ion such as $Eu_2O_3$ are used as source of Eu. Therefore, in order to obtain a phosphor containing bivalent $Eu^{2+}$ and emitting green light, it has been previously ordinary to perform firing under a reducing atmosphere such as carbon monoxide, hydrogen-containing nitrogen or hydrogen to bring about reduction of trivalent $Eu^{3+}$ to bivalent $Eu^{2+}$. However, even under these firing atmospheres, it was difficult to decrease oxygen concentration sufficiently because of oxygen derived from such sources as materials used. Further, when Sm, Tm, Yb, or the like was used as $M^{II}$ element, there was a problem similar to that of Eu.

The inventors of the present invention have found that, by a keen investigation, when trivalent ion of $M^{II}$ element is reduced to bivalent ion and, at the same time, introduced into host crystals, it is effective to carry out firing in the presence of a solid carbon (namely, under more reductive conditions) in addition to usual reductive atmosphere. The phosphor thus obtained is characterized in that it exhibits light emission of high brightness in the wavelength region of 510 nm or longer and 542 nm or shorter with narrow emission spectrum width.

The non-luminous object color mentioned before is considered to be an index showing the extent of reduction of the $M^{II}$ element. Firing in a highly reducing atmosphere is considered to lead to sufficient reduction of $M^{II}$ element and the phosphor represented by the aforementioned formula [1] comes to possess a non-luminous object color in the range shown before.

No particular limitation is imposed on the kind of the solid carbon and any kind of solid carbon can be used. Examples include carbon black, activated carbon, pitch, coke and black lead (graphite). The reason why use of solid carbon is desirable is that oxygen in the firing atmosphere reacts with the solid carbon to produce carbon monoxide, and this carbon monoxide, in turn, reacts with oxygen in the firing atmosphere to form carbon dioxide and can thus reduce oxygen concentration in the firing atmosphere. Of the above examples, activated carbon, which is highly reactive with oxygen, is preferable. The shape of solid carbon can be powder, bead, particle block, or the like, and there is no special limitation.

The amount of solid carbon used depends on other firing conditions, but it is usually 0.1 weight % or more, to the weight of the phosphor, preferably 1 weight % or more, more preferably 10 weight % or more, still more preferably 30 weight % or more, the most preferably 50 weight % or more.

Further, by using a graphite crucible as firing vessel, it is possible to achieve the same effect as that when solid carbon is used. On the other hand, when a crucible made of material other than carbon such as alumina is used, it is preferable to have it coexist with the solid carbon such as bead, particle, block or the like made of graphite. Further, it is preferable to perform firing under tightly closed conditions such as with a lid placed on the crucible.

Here, "firing in the presence of a solid carbon" means a state in which phosphor materials and the solid carbon coexist in the same firing vessel, and it is not necessary to mix the phosphor materials and solid carbon for firing. In general, when carbon is mixed contained in a phosphor product, carbon, which is black, absorbs light emitted by the phosphor, and emission efficiency of the phosphor decreases. Examples of means of realizing coexistence of a solid carbon include: placing a solid carbon in a vessel different from one containing phosphor materials and placing these vessels in the same crucible (for example, positioning the solid carbon vessel above the material vessel); the solid carbon vessel is immersed in the phosphor materials; or on the contrary, placing a solid carbon around the vessel containing the phosphor material powders. When a large crucible is used, it is desirable to perform firing with solid carbon placed in the same vessel containing the phosphor materials. In all of these cases, it is necessary to take care so that the solid carbon does not contaminate the phosphor materials.

As means of obtaining bivalent ion of $M^{II}$ element, the following process can also be applied together with coexistence of solid carbon or in place of coexistence of a solid carbon. Namely, it is preferable that air which exists in a crucible together with the material powder is removed as far as possible to make oxygen concentration low. As concrete means, it is preferable to evacuate air from the crucible with predetermined materials charged in a vacuum furnace and introduce atmosphere gas used at the time of firing to restore pressure. It is further preferable to repeat this operation. Or an oxygen getter such as Mo can also be used as appropriate. Moreover, bivalent ion of $M^{II}$ element can be obtained by performing firing in an atmosphere of nitrogen containing 5 volume % or more of hydrogen, with sufficient safeguards.

Thus, by such means as securing the presence of solid carbon, it is possible to reduce oxygen concentration of the firing atmosphere, to make firing atmosphere highly reductive, and, as a result, to obtain a phosphor with high characteristics, which is preferable.

(Flux)

In the firing step, flux is preferably added to the reaction system in order to secure growth of good quality crystals. No particula'r limitation is imposed on the kind of flux. It is preferable that a compound is used as flux, which is selected from the group consisting of a compound including monovalent element or atomic group and minus monovalent element, compound including monovalent element or atomic group and minus trivalent element or atomic group, compound including bivalent element and minus monovalent element, compound including bivalent element and minus trivalent element or atomic group, compound including trivalent element and minus monovalent element, and compound including trivalent element and minus trivalent element or atomic group.

The monovalent element or atomic group is preferably at least one kind of element selected from the group consisting of, for example, alkali metal element and ammonium group ($NH_4$). More preferably it is cesium (Cs) or rubidium (Rb).

The bivalent element is preferably at least one kind of element selected from the group consisting of, for example, alkaline-earth metal element and zinc (Zn). More preferably it is strontium (Sr) or barium (Ba).

The trivalent element is preferably at least one kind of element selected from the group consisting of, for example, rare-earth element such as lanthanum (La), yttrium (Y), aluminum (Al) and scandium (Sc). More preferably it is yttrium (Y) or aluminum (Al).

The minus monovalent element is preferably at least one kind of element selected from the group consisting of, for example, halogen elements. Chlorine (Cl) or fluorine (F) is preferable.

The minus trivalent element or atomic group is preferably phosphate group ($PO_4$), for example.

Among above, it is preferable that a compound is used as flux, which is selected from the group consisting of an alkali metal halide, alkaline-earth metal halide, zinc halide, halide of trivalent element selected from the group consisting of yttrium (Y), aluminium (Al), scandium (Sc) and rare-earth element, alkali metal phosphate, alkaline-earth metal phosphate, zinc phosphate, and phosphate of trivalent element selected from the group consisting of yttrium (Y), aluminium (Al), lanthanum (La) and scandium (Sc).

More concrete examples are: chlorides such as $NH_4Cl$, $LiCl$, $NaCl$, $KCl$, $CsCl$, $CaCl_2$, $BaCl_2$, $SrCl_2$, $YCl_3 \cdot 6H_2O$ (anhydrous form is also acceptable), $ZnCl_2$, $MgCl_2 \cdot 6H_2O$ (anhydrous form is also acceptable) and $RbCl$; fluorides such as $LiF$, $NaF$, $KF$, $CsF$, $CaF_2$, $BaF_2$, $SrF_2$, $AlF_3$, $MgF_2$ and $YF_3$; phosphates such as $K_3PO_4$, $K_2HPO_4$, $KH_2PO_4$, $Na_3PO_4$, $Na_2HPO_4$, $NaH_2PO_4$, $Li_3PO_4$, $Li_2HPO_4$, $LiH_2PO_4$, $(NH_4)_3PO_4$, $(NH_4)_2HPO_4$ and $(NH_4)H_2PO_4$.

Of these, preferable are $LiCl$, $CsCl$, $BaCl_2$, $SrCl_2$ and $YF_3$. Particularly preferable are $CsCl$ and $SrCl_2$.

These fluxes can be used either as a single one or as a mixture of two or more kinds in any combination and in any ratio. However, the combination of two or more kinds has a following effect.

When there is flux coexisting in the phosphor materials, crystal growth of the phosphor is generally accelerated and a particle diameter of the phosphor tends to be large, although it depends on the kind of flux, firing conditions or the like. In addition, the brightness of the phosphor of the present invention tends to be higher as the particle diameter of the phosphor becomes large. From the above findings, inclusion of flux in the phosphor material seems preferable because it brings about higher brightness. But, when the particle diameter is too large, unevenness in coating or occlusion of a dispenser is liable to occur, and thus the phosphor becomes impaired to handle.

When two or more kinds of flux are used in combination, the use of compound containing bivalent element such as $SrCl_2$ or $BaCl_2$, among above-mentioned fluxes, leads to crystal growth promoting effect. On the other hand, use of compound containing monovalent or trivalent element such as $CsCl$, $LiCl$, $YCl_3 \cdot 6H_2O$, among above-mentioned fluxes, brings about crystal growth inhibiting effect. This has been clarified in' the present invention. Therefore, the combination of flux having crystal growth promoting effect and flux having crystal growth inhibiting effect can result in such a synergistic effect of both fluxes in which a phosphor having high brightness and inhibiting crystal growth with easy-to-handle weigh-average median diameter (concretely, 10 $\mu$m or larger and 25 $\mu$m or smaller) can be obtained, which is particularly preferable.

Examples of the desirable combination of two or more kinds of fluxes include $SrCl_2$ and $CsCl$, $SrCl_2$ and $LiCl$, $SrCl_2$ and $YCl_3 \cdot 6H_2O$, $SrCl_2$ and $BaCl_2$ and $CsCl$. Among them, particularly preferable is a combination of $SrCl_2$ and $CsCl$.

The amount of flux used (when two or more kinds of fluxes are used, its total amount) depends on the kind of material, kind of flux, firing temperature, firing atmosphere or the like. It is preferably in the range of usually 0.01 weight % or more, preferably 0.1 weight % or more, and usually 20 weight % or less, preferably 10 weight % or less. When the amount of the flux is too small, the effect of flux may not be exhibited. When the amount is too large, the effect of flux may be saturated, the particle diameter may become too large making handling impaired, or it may be taken up into host crystals resulting in the change in luminescent color and decrease in brightness.

When two or more kinds of flux are combined, it is preferable that the ratio (molar ratio) of compound containing monovalent or trivalent element, when the number of moles of compound containing bivalent element is 1, is usually 0.1 or larger, preferably 0.2 or larger, and usually 10 or smaller, preferably 5 or smaller.

It is to be noted that, when preferable flux such as $SrCl_2$ is used in an appropriate amount, it is possible to obtain the phosphor of the present invention even in a weakly reducing atmosphere (for example, hydrogen-containing nitrogen environment (nitrogen : hydrogen = 96 : 4 (volume ratio))) in the absence of solid carbon.

(Primary firing and secondary firing)

The firing step may be separated into primary firing and secondary firing. The mixture of materials obtained in the mixing step may be subjected to primary firing first, and after another pulverization using a ball mill or the like, subjected to secondary firing.

The temperature of the primary firing is in the range of usually 850 °C or higher, preferably 1000 °C or higher, more preferably 1050 °C or higher, and usually 1350 °C or lower, preferably 1200 °C or lower, more preferably 1150 °C or lower.

The length of time of the primary firing is in the range of usually 1 hourr or longer, preferably 2 hours or longer, more preferably 4 hours or longer, and usually 24 hours or shorter, more preferably 15 hours or shorter, more preferably 13 hours or shorter.

The conditions such as temperature and length of time of the secondary firing are basically the same as described earlier for the sections of (Firing condition), (Solid carbon) and (Flux).

Flux may be added either before the primary firing or before the secondary firing. Different firing conditions such as atmospheres may be employed for the primary firing and the secondary firing.

<Post-treatment>

After the heat treatment in the above firing step, the product is subjected to washing, drying, pulverization and classification treatment, if considered appropriate.

For pulverization treatment, pulverizers such as those cited in the above-mentioned mixing step can be used. Washing can be done using, water such as deionized water, organic solvent such as methanol and ethanol, and alkaline aqueous solution such as ammonia water or the like. Classification treatment is done by screening or in-water sieving. Various classifiers such as air current classifier or vibrating sieve can also be used. Of these, dry classification by means of a nylon mesh can be used to obtain the phosphor of good dispersibility with weight-average median diameter of around 20 μm.

It is preferable to perform drying, after the washing treatment. There is no particular limitation on the method of drying. However, it is preferable to select an appropriate drying method in accordance with the characteristics of the phosphor, if necessary. For example, the specific-composition phosphor may be partly changed into a carbonate in such a case as it is exposed in an atmosphere of high temperature and high humidity (for example, hot water) for a long period of time because a part of the surface of host material of the phosphor is dissolved, through a reaction between the dissolved portion and the carbon dioxide in the air. Therefore, the specific-composition phosphor is subjected to drying treatment preferably by means of low-temperature drying such as drying in vacuo, reduced-pressure drying and freeze drying, or short-time drying such as spray drying. In addition, it is preferably dried under an atmosphere without carbon dioxide, such as nitrogen gas or argon gas, or by air drying after its moisture content was substituted with low-boiling solvent.

<Surface treatment>

When the phosphor of the present invention, obtained in the above-mentioned procedure, is used to manufacture a light emitting device by a method described later, the surface of the phosphor may be subjected to surface treatment in which the surface is covered with some foreign substance or the like, in order to improve weatherability such as moisture resistance or to improve dispersibility in a resin in the phosphor-containing part of the light emitting device described later.

Examples of substance which can be applied to the surface of the phosphor (hereinafter referred to as "surface treatment substance" as appropriate) include organic compound, inorganic compound and glass material or the like.

Examples of the organic compound include thermofusible polymer such as acrylic resin, polycarbonate, polyamide and polyethylene, latex and polyorganosiloxane.

Examples of the inorganic compound include: metal oxide such as magnesium oxide, aluminum oxide, silicon oxide, titanium oxide, zirconium oxide, tin oxide, germanium oxide, tantalum oxide, niobium oxide, vanadium oxide, boron oxide, antimony oxide, zinc oxide, yttrium oxide, lanthanum oxide and bismuth oxide, metal nitride such as silicon nitride and aluminum nitride, orthophosphate such as calcium phosphate, barium phosphate and strontium phosphate, and polyphosphate.

Examples of the glass material include boron silicate, phosphorus silicate and alkali silicate.

These surface treatment substances can be used either as a single one or as a mixture of two or more kinds in any combination and in any ratio.

The surface-treated phosphor of the present invention has these surface treatment substances on its surface. The mode of existence of the surface treatment substances can be as follows, for example.

(i) The aforementioned surface treatment substances constitute a continuous layer and cover the surface of the phosphor of the present invention.

(ii) The aforementioned surface treatment substances are attached to the surface of the phosphor of the present invention as numerous microparticles and these microparticles cover the surface of the phosphor of the present invention.

It is preferable that the amount of the surface treatment substance which can cover or be attached to the surface of the phosphor of the present invention is, to the weight of the phosphor of the present invention, usually 0.1 weight % or more, preferably 1 weight % or more, more preferably 5 weight % or more, and usually 50 weight % or less, preferably 30 weight % or less, more preferably 15 weight % or less. When the amount of the surface treatment substance to that of the phosphor is too large, the luminescent characteristics of the phosphor may be impaired. When it is too small, the coverage of the surface may be insufficient, and moisture resistance and dispersibility may not be improved.

It is preferable that the film thickness (layer thickness) of the surface treatment substance formed by the surface treatment is usually 10 nm or thicker, preferably 50 nm or thicker, and usually 2000 nm or thinner, preferably 1000 nm or thinner. When the layer is too thick, the luminescent characteristics of the phosphor may be impaired. When it is too thin, the coverage of the surface may be insufficient, and moisture resistance and dispersibility may not be improved.

No particular limitation is imposed on the method of such surface treatment. As an example, the following coating treatment method using a metal oxide (silicon oxide) can be cited.

The phosphor of the present invention is added in an alcohol such as ethanol, and then stirred. To this alkaline aqueous solution such as ammonia water is added, followed by stirring. Hydrolyzable silicic acid alkyl ester such as tetraethyl orthosilicate is then added and the mixture is stirred. The solution obtained is allowed to stand for 3 to 60 minutes, and then the supernatant containing silicon oxide particles which remain unattached to the surface of the phosphor is removed by pipetting or the like. Then, adding alcohol, stirring, allowing to stand and removal of the supernatant are repeated several times and, after heating for 10 minutes to 5 hours at 120 °C to 150 °C, for example, 2 hours of drying process under reduced pressure, surface-treated phosphor is obtained.

Other surface treatment methods of phosphor include various known methods such as method in which spherical silicon oxide fine powder is attached to phosphor (Japanese Patent Laid-Open Publications No. Hei 2-209989 and No. Hei 2-233794), method in which a coating film of Si-compound is attached to phosphor (Japanese Patent Laid-Open Publication No. Hei 3-231987), method in which the surface of phosphor microparticle is covered with polymer microparticles (Japanese Patent Laid-Open Publication No. Hei 6-314593), method in which phosphor is coated with an organic, inorganic, glass or the like material (Japanese Patent Laid-Open Publication No. 2002-223008), method in which the surface of phosphor is covered by means of chemical vapor reaction (Japanese Patent Laid-Open Publication No. 2005-82788) and method in which particles of a metal compound is attached (Japanese Patent Laid-Open Publication No. 2006-28458).

[1-4. Application of phosphor]

The phosphor of the present invention can be used for any purpose that uses a phosphor. Particularly, it can be used preferably for various light emitting devices ("the light emitting device of the present invention" to be described later), making the most of such characteristics that it can be excited with a blue light or a near-ultraviolet light. By adjusting the kind or content of the phosphors used together, light emitting devices having various luminescent colors can be produced. Among them, combined use of an excitation light source emitting blue light and a phosphor emitting orange to red fluorescence (orange to red phosphor) can realize a white light emitting device, since the phosphor of the present invention is a green phosphor. In this case, the luminescent color can be modified freely by means of adjusting the luminous wavelength of the phosphor of the present invention or the orange to red phosphor used together. For example, even an emission spectrum that is similarly to so-called pseudo-white (for example, a luminescent color of a light emitting device having a blue LED and a yellow phosphor in combination) emission spectrum can be obtained. Furthermore, by incorporating a phosphor emitting red fluorescence (red phosphor) in this white light emitting device, a light emitting device that is extremely excellent in red color rendering or that emits light with a color of light bulb (a warm white color) can be realized. A white light emitting device can also be produced by combining an excitation light source which is emitting near-ultraviolet light, the phosphor of the present invention, a phosphor emitting blue fluorescence (blue phosphor) and a red phosphor.

The luminescent color of the light emitting device is not limited to white. Actually, light emitting devices emitting any color of light can be produced by combining, as needed, a yellow phosphor (a phosphor emitting yellow fluorescence), blue phosphor, orange to red phosphor or other kind of green phosphor and adjusting the kinds or the contents of the phosphors. The light emitting device obtained as above can be used for an illuminant portion (especially, back-lighting for a liquid crystal display) of a display or for a lighting system.

[2. Phosphor-containing composition]

The phosphor of the present invention can be used as a mixture with a liquid medium. Particularly when the phosphor of the present invention is used for a light emitting device or the like, it is preferably used as a dispersion in a liquid medium. The phosphor of the present invention that is dispersed in a liquid medium will be referred to as "the phosphor-containing composition of the present invention" as appropriate.

[2-1. Phosphor]

There is no limitation on the type of the phosphor of the present invention to be contained in the phosphor-containing composition of the present invention, and any of that can be selected from those described above. The phosphor of the present invention to be contained in the phosphor-containing composition of the present invention can be used as a single kind thereof or as a mixture of two or more kinds in any combination and in any ratio. Furthermore, in the phosphor-containing composition of the present invention, a phosphor other than the phosphor of the present invention can be contained, insofar as the advantage of the present invention is not significantly impaired.

[2-2. Liquid medium]

There is no special limitation on the kind of a liquid medium used for the phosphor-containing composition of the present invention, insofar as the performance of the phosphor can be sufficient enough to achieve the object of the present invention. For example, any inorganic material and/or organic material can be used, insofar as it exhibits liquid characteristics under a desired use condition and lets the phosphor of the present invention be dispersed preferably without any unfavorable reaction.

Examples of the inorganic materials include: metal alkoxide, a solution obtained by hydrolytic polymerization of a solution containing ceramic precursor polymer or metal alkoxide using a sol-gel method, or inorganic material obtained by curing a combination of these materials (such as an inorganic material containing siloxane bond).

Examples of the organic materials include: thermoplastic resin, thermosetting resin and light curing resin or the like. More specifically, the examples include: methacrylic resin such as polymethacrylate methyl; styrene resin such as polystyrene, styrene-acrylonitrile copolymer; polycarbonate resin; polyester resin; phenoxy resin; butyral resin; polyvinyl alcohol; cellulose resin such as ethyl cellulose, cellulose acetate and cellulose acetate butyrate; epoxy resin; phenol resin; and silicone resin.

Of these, a silicon-containing compound can be preferably used from the standpoint of high heat resistance, high light resistance and the like, particularly when the phosphor is used for a high-power light emitting device such as a lighting system.

Silicon-containing compound means a compound of which molecular contains a silicon atom. Examples thereof include: organic materials (silicone materials) such as polyorganosiloxane, inorganic materials such as silicon oxide, silicon nitride and silicon oxynitride, glass materials such as borosilicate, phosphosilicate and alkali silicate. Among them, silicone materials are preferably used from the standpoint of ease in handling or the like.

The above-mentioned silicone material usually indicates organic polymers having a siloxane bond as the main chain. Examples thereof include compounds represented by the following formula (i) and/or mixtures of them.

[Chemical Formula 3]

$$(R^1R^2R^3SiO_{1/2})_M (R^4R^5SiO_{2/2})_D (R^6SiO_{3/2})_T (SiO_{4/2})_Q$$

formula (i)

In the above formula (i), $R^1$ to $R^6$ can be the same as or different from each other, and are selected from the group consisting of organic functional group, hydroxyl group and hydrogen atom.
In addition, M, D, T and Q of the above-mentioned formula (i) are each number of 0 or greater and smaller than 1, and they satisfy M+D+T+Q=1.

For the silicone material used for sealing a semiconductor luminous element, a liquid silicone material can be used, by being cured with heat or light, after the sealing.

When categorizing silicone materials based on the curing mechanism, they usually fall into such categories as addition polymerization-curable type, polycondensation-curable type, ultraviolet ray-curable type and peroxide vulcanized type. Of these, preferable are addition polymerization-curable type (addition type silicone resin) and condensation-curable type (condensing type silicone resin) and ultraviolet ray-curable type. In the following, addition type silicone material and condensing type silicone material will be explained.

Addition type silicone material represents a material in which polyorganosiloxane chain is crosslinked by means of organic additional bond. A typical example can be a compound having a Si-C-C-Si bond as the crosslinking point which can be obtained through a reaction between vinylsilane and hydrosilane in the presence of an addition type catalyst such as Pt catalyst. As such compounds, commercially available ones can be used. For example, as concrete commercial names of an addition polymerization-curable type can be cited "LPS-1400", "LPS-2410" and "LPS-3400", manufactured by Shin-Etsu Chemical Co., Ltd.

On the other hand, an example of a condensing type silicone material a compound having an Si-O-Si bond as the crosslinking point, which can be obtained through hydrolysis and polycondensation of alkyl alkoxysilane can be cited. As a concrete example, a polycondensate obtained by performing hydrolysis and polycondensation of compounds represented by the following general formula (ii) and/or (iii), and/or an oligomer thereof can be cited.

$$M^{m+}X_n Y^1_{m-n} \quad (ii)$$

(In the formula (ii), M represents at least one element selected from silicon, aluminum, zirconium and titanium, X represents a hydrolyzable group, $Y^1$ represents a monovalent organic group, m represents an integer of 1 or larger representing the valence of M, and n represents an integer of 1 or larger representing the number of X groups, where m≥n.)

$$M^{s+}X_t Y^1_{s-t} \quad (iii)$$

(In the formula (iii), M represents at least one element selected from silicon, aluminum, zirconium and titanium, X represents a hydrolyzable group, $Y^1$ represents a monovalent organic group, $Y^2$ represents a u-valent organic group, s represents an integer of 1 or larger representing the valence of M, t represents an integer of 1 or larger and s-1 or smaller, and u represents an integer of 2 or larger.)

The condensing type silicone material may contain a curing catalyst. As the curing catalyst, a metal chelate compound can be used preferably, for example. The metal chelate compound preferably contains one or more of Ti, Ta and Zr, and more preferably contains Zr. The curing catalysts may be used either as a single kind thereof or as a mixture of two or more kinds in any combination and in any ratio.

As such condensing type silicone material, the following can be used preferably, for example: semiconductor light-emitting device members disclosed in Japanese Patent Applications No. 2006-47274 to No. 2006-47277 and Japanese Patent Application No. 2006-176468.

In the following, particularly preferable ones among condensing type silicone materials will be explained. Silicone materials generally have such problems as low adhesiveness to the semiconductor luminous element, the substrate at which the element is disposed, the package and the like. However, as a silicone material with high adhesion, a condensing type silicone material having one or more of the following characteristics [1] to [3] can be preferably cited.

[1] The silicon content is 20 weight % or more.
[2] In the solid Si-nuclear magnetic resonance spectrum (NMR), measured by a method to be described later in detail, it has at least one of Si-originated peaks of the following (a) and/or (b).

(a) A peak whose peak top position is in an area of a chemical shift of -40 ppm or more and 0 ppm or less, with reference to tetramethoxysilane, and whose full width at half maximum is 0.3 ppm or more and 3.0 ppm or less.
(b) A peak whose peak top position is in an area of a chemical shift of -80 ppm or more and less than -40 ppm, with reference to tetramethoxysilane, and whose full width at half maximum is 0.3 ppm or more and 5.0 ppm or less.

[3] The silanol content is 0.1 weight % or more and 10 weight % or less.

It is preferable that the silicone material in the present invention has the characteristic [1], among the above-mentioned characteristics [1] to [3], more preferable that the silicone material has the above-mentioned characteristics [1] and [2], and particularly preferable that the silicone material has all the above-mentioned characteristics [1] to [3]. In the following, the above-mentioned characteristics [1] to [3] will be explained.

<2-2-1. Characteristic [1] (silicon content)>

The basic skeleton of a conventional silicone material is an organic resin such as an epoxy resin having carbon-carbon and carbon-oxygen bonds as its basic skeleton. In contrast, the basic skeleton of the silicone material of the present invention is an inorganic siloxane bond which is the same as that of a glass (silicate glass). As is evident from the chemical bond comparison in Table 2 shown below, this siloxane bond has superior features listed below as a silicone material.

(I) Light resistance is superior because the bond energy is large and thus pyrolysis and photolysis are hard to occur.
(II) Electrically polarized slightly.
(III) The chain structure thereof has a high degree of freedom, leading to highly flexible structure and free rotation about the siloxane chain.
(IV) It has high degree of oxidizing so that further oxidization is impossible.
(V) It is high in electrical insulating properties.

[Table 2]

[Table 2: Chemical bond comparison table]

| Bond | Bond distance (Å) | Bond energy (kcal/mol) | Bond angle (°) |
|------|-------------------|------------------------|----------------|
| Si-C-Si | 1.64 | 108 | 130 to 160 |
| C-O-C | 1.43 | 86 | 110 |
| C-C-C | 1.54 | 85 | 109 |

From these features, it can be understood that a silicone material, formed of a skeleton in which siloxane bonds are connected three-dimensionally with a high degree of crosslinking, can become a protective film that is similar to minerals such as glass and rock and has an excellent heat resistance and light resistance. Particularly, a silicone material having a methyl group as a substituent, is superior in light resistance, because it does not have an absorption range in the ultraviolet region and therefore photolysis is hard to occur.

The silicon content in the silicone material that is preferable for the present invention is usually 20 weight % or more. However, it is particularly preferably 25 weight % or more, and more particularly preferably 30 weight % or more. On the other hand, the upper limit thereof is usually 47 weight %, because the silicon content of a glass, consisting only

of $SiO_2$, is 47 weight %.

The silicon content of a silicone material can be calculated based on the result of inductively coupled plasma spectrometry (hereinafter abbreviated as "ICP" when appropriate) analysis, carried out in accordance with, for example, a method described below.

{Measurement of silicon content}

A silicone material is kept in a platinum crucible in the air at 450 °C for 1 hour and then at 750 °C for 1 hour and at 950 °C for 1.5 hours for firing. After removal of carbon components, the small amount of residue obtained is added with a 10-fold amount or more of sodium carbonate, and then heated by a burner to melt it. Then the melted product is cooled and added with desalted water, being diluted to several ppm in silicon, while adjusting pH value to around neutrality using hydrochloric acid. And then ICP analysis is performed.

<2-2-2. Characteristic [2] (solid Si-NMR spectrum)>

When measuring the solid Si-NMR spectrum of a silicone material preferable for the present invention, at least one, preferably two or more of peaks can be observed in the aforementioned peak regions (a) and/or (b), originating from a silicon atom directly bonded with a carbon atom of an organic group.

Summarizing in terms of chemical shifts, in a silicone material preferable for the present invention, the full width at half maximum of the peak described in (a) is generally smaller than that of the peak of (b) described later, due to smaller constraints of molecular motion. It is in the range of usually 3.0 ppm or less, preferably 2.0 ppm or less, and usually 0.3 ppm or more.

On the other hand, the full width at half maximum of the peak described in (b) is in the range of usually 5.0 ppm or less, preferably 4.0 ppm or less, and usually 0.3 ppm or more, preferably 0.4 ppm or more.

If the full width at half maximum of a peak observed in the above chemical shift areas is too large, a state in which constraints of molecular motion are large and thus the distortion is large is created, leading possibly to forming a member inferior in heat resistance and weather resistance, and of which cracks are more likely to appear. For example when a lot of tetrafunctional silane is used or when large internal stress is generated by a rapid drying in the drying process, the range of the full width at half maximum will be larger than the above range.

If the full width at half maximum of the peak is too small, Si atoms existing in its environment are not involved in the siloxane crosslinking. In such a case, for example when trifunctional silane remains in a non-crosslinked state, the obtained member may be inferior in heat resistance and weather resistance to materials formed mainly of siloxane bonds.

However, even if a peak, of the above-mentioned range of the full width at half maximum, is observed in an area of -80 ppm or more in a silicone material containing a small amount of Si component in a large amount of organic components, the heat resistance, light resistance and coating properties may not be excellent.

The chemical shift value of a silicone material preferable for the present invention can be calculated based on the results of a solid Si-NMR measurement performed by, for example, a method described below. Also, the measured data (the full width at half maximum, silanol amount) is analyzed by a method in which each peak is divided and extracted by the waveform separation analysis or the like utilizing, for example, the Gauss function or Lorentz function.

{Solid Si-NMR spectrum measurement and calculation of the silanol content}

When measuring the solid Si-NMR spectrum of a silicone material, the solid Si-NMR spectrum measurement and the waveform separation analysis are performed under the following conditions. Further, the full width at half maximum of each peak is determined, for the silicone material, based on the obtained waveform data. In addition, the silanol content is determined by comparing the ratio (%) of silicon atoms in silanol to all silicon atoms, decided from the ratio of peak areas originating from silanol to all peak areas, with the silicon content ratio analyzed separately.

{Device conditions}

Device: Infinity CMX-400 nuclear magnetic resonance spectroscope, manufactured by Chemagnetics Inc.
29Si resonance frequency: 79.436 MHz
Probe: 7.5 mm $\phi$ CP/MAS probe
Temperature: Room temperature
Rotational frequency of sample: 4 kHz
Measurement method: Single pulse method
1H decoupling frequency: 50 kHz

29Si flip angle: 90°
29Si 90° pulse width: 5.0 μs
Repetition time: 600 seconds
Total count: 128 times
Observation width: 30 kHz
Broadening factor: 20 Hz
Authentic sample: tetramethoxysilane

For a silicone material, 512 points are taken in as measured data and zero-filled to 8192 points, before Fourier transform is performed.

{Waveform separation analysis method}

For each peak of the spectrum after Fourier transform, an optimization calculation is performed by the nonlinear least square method using the center position, height and full width at half maximum of a peak shape, created by a Lorentz waveform, Gauss waveform or a mixture of both, as variable parameters.
For identification of a peak, refer to AIChE Journal, 44(5), p. 1141, 1998 or the like.

<2-2-3. Characteristic [3] (silanol content)>

The silanol content of a silicone material preferable for the present invention is in the range of usually 0.1 weight % or more, preferably 0.3 weight % or more, and usually 10 weight % or less, preferably 8 weight % or less, more preferably 5 weight % or less. When the silanol content is small, time-dependent change of the silanol (sic) material is little and can be superior in long-term performance stability, as well as in low hygroscopicity and low moisture permeability. However, no silanol content results in poor adhesion, and therefore, there is such appropriate range of the silanol content as described above.

The silanol content of a silicone material can be decided by such method as described before for {Solid Si-NMR spectrum measurement and calculation of the silanol content} in <2-2-2. Characteristic [2] (solid Si-NMR spectrum)>, for example, in which the ratio (%) of silicon atoms in silanol relative to all silicon atoms is determined from the ratio of peak areas originating from silanol relative to all peak areas by means of the solid Si-NMR spectrum measurement, and then, the silanol content can be calculated by comparing the determined silicon ratio with the silicon content analyzed separately.

Since a silicone material preferable for the present invention contains an appropriate amount of silanol, which is usually bound to a polar portion, existing on the device surface, through hydrogen bond, the adhesion develops. The polar portion includes, for example, a hydroxyl group and oxygen in a metalloxane bond.

In addition, a silicone material preferable for the present invention usually forms, due to dehydration condensation, a covalent bond with a hydroxyl group on the device surface when heated in the presence of an appropriate catalyst, leading to a development of still firmer adhesion.

With too much content of silanol, on the other hand, thickening in the system may make the coating difficult, and also, with increased activity, the occurrence of curing before low-boiling point components volatilize by heating may induce a foaming and an increase of internal stress, which may result in crack generations or the like.

[2-3. Content of liquid medium]

There is no special limitation on the content of the liquid medium, insofar as the advantage of the present invention is not significantly impaired. However, it is usually 50 weight % or more, preferably 75 weight % or more, and usually 99 weight % or less, preferably 95 weight % or less, to the whole phosphor-containing composition of the present invention. Even a large amount of liquid medium does not induce any problems particularly, but in order to achieve desired color coordinate, color rendering index, emission efficiency or the like when it is used for a semiconductor light emitting device, it is preferable that the liquid medium is used usually in the above-mentioned proportion. With too small amount of the liquid medium, on the other hand, its handling may be difficult due to no fluidity.

The liquid medium serves mainly as binder, in the phosphor-containing composition of the present invention. The liquid medium can be used either as a single one or as a mixture of two or more kinds in any combination and in any ratio. For example, when a silicon-containing compound is used for the purpose of high heat resistance or light resistance, other thermosetting resin such as epoxy resin can be included to the extent that the durability of the silicon-containing compound will not be impaired. In such a case, it is preferable that the content of the other thermosetting resin is usually 25 weight % or lower, preferably 10 weight % or lower, to the whole amount of the liquid medium, which serves as the binder.

[2-4. Other component]

In the phosphor-containing composition of the present invention, components other than the phosphor and liquid medium can be contained, insofar as the advantage of the present invention is not significantly impaired. The other components may be used either as a single kind thereof or as a mixture of two or more kinds in any combination and in any ratio.

[3. Light emitting device]

The light emitting device of the present invention (hereinafter referred to as "the light emitting device" as appropriate) comprises a first luminous body (excitation light source) and a second luminous body which emits visible light when irradiated with light from the first luminous body, and the second luminous body comprises a first phosphor including at least one kind of the phosphor of the present invention described above in the section of [1. Phosphor].

As the phosphor of the present invention, a. phosphor which is the above-mentioned specific-property phosphor and/or specific-composition phosphor, and which usually emit fluorescences of a green region when irradiated with light from the excitation light source (hereinafter referred to as "the green phosphor of the present invention" as appropriate) is used. Specifically, as the green phosphor of the present invention, a phosphor having its emission peak in the range of from 510 nm to 542 nm is preferably used. The green phosphor of the present invention can be used either as any single kind thereof or as a mixture of two or more kinds in any combination and in any ratio.

The use of the green phosphor of the present invention can make the light emitting device of the present invention be excellent in high emission efficiency, with respect to the light from an excitation light source (first luminous body) of from near-ultraviolet to blue region, as well as in broad color reproduction range, at the time of its use for a white light emitting device such as a light source for a liquid crystal display.

Even when the green phosphor of the present invention corresponds to only the specific-composition phosphor, it is preferable that the CIE color coordinates x and y, in accordance with JIS Z8701, of its luminescent color falls within the following ranges respectively.

Namely, it is preferable that the CIE color coordinate x of the green phosphor of the present invention is usually 0.210 or larger, preferably 0.240 or larger, more preferably 0.263 or larger, and usually 0.330 or smaller, preferably 0.310 or smaller, more preferably 0.300 or smaller.

In addition, it is preferable that the CIE color coordinate y of the green phosphor of the present invention is usually 0.480 or larger, preferably 0.490 or larger, more preferably 0.495 or larger, and usually 0.670 or smaller, preferably 0.660 or smaller, more preferably 0.655 or smaller.

When the CIE color coordinates x and y are within the above ranges, an advantage of wide color reproduction range at the time of white light synthesis can be achieved.

Further, even when the green phosphor of the present invention corresponds to only the specific-property phosphor, it is preferable that the weight-average median diameter thereof is in the range of usually 10 $\mu$m or larger, preferably 15 $\mu$m or larger, and usually 30 $\mu$m or smaller, preferably 20 $\mu$m or smaller. When the weight-average median diameter is too small, the brightness tends to decrease and the phosphor particles tend to aggregate. On the other hand, the weight-average median diameter is too large, unevenness in coating, clogging in a dispenser or the like tend to occur.

Each physical property value of the phosphor, such as emission spectrum, color coordinate and the like, can be measured by the same method as described above in the section of [1. Phosphor].

As preferable examples of the green phosphor of the present invention used for the light emitting device of the present invention, the aforementioned phosphor of the present invention described in the section of [1. Phosphor] and each phosphor used in each Examples of the section [Example] described later can be cited.

There is no particular limitation on the structure of the light emitting device of the present invention and any known device configuration can be adopted, except that it comprises the first luminous body (excitation light source) and utilizes at least the phosphor of the present invention as the second luminous body. Concrete examples of the device configuration will be described later.

The emission peak in the green region, of the emission spectrum of light emitting device of the present invention, preferably exists in the wavelength range of from 515 nm to 535 nm.

The emission spectrum of the light emitting device of the present invention can be measured in a room of which temperature is kept at 25±1 °C with energization of 20 mA, using a software for measuring color and illumination intensity, manufactured by Ocean Optics, Inc., and a spectroscope of USB2000 series (integrating sphere version). From this emission spectrum data in the wavelength region of 380 nm to 780 nm, the chromaticity value (x, y, z) can be calculated as color coordinates of xyz color system, defined in JIS Z8701. In this case, the relational expression of x+y+z=1 holds. In the present Description, the aforementioned color system of XYZ is occasionally referred to as color system of XY and the value thereof is usually represented as (x,y).

The light emitting device of the present invention also has a characteristic of having high NTSC ratio, especially when it is constructed as a white light emitting device. More specifically, the NTSC ratio (%) of the light emitting device of the present invention is usually 70 or higher, preferably 72 or higher, and more preferably 74 or higher. The higher the value of NTSC ratio is, the more preferable, but it is theoretically 150 or lower.

NTSC ratio is decided as follows.

In NTSC system, the standard of Japanese color TV, the reference R, G, B chromaticity points are defined as follows, using an expression of (x,y) of the CIE color coordinate.
R(0.67,0.33), G(0.21,0.71), B(0.14, 0.08)

NTSC ratio (%) is defined, when the area of the triangle formed with three points of this RGB is 100, as 100 times the value of which the area of the triangle formed with R, G and B of the display to be measured, more specifically the area of the triangle, formed with measured chromaticity points (x,y) of monochromatic RGB emitted by the display, which are plotted on the CIE chromaticity diagram, is divided by the area of the reference triangle of NTSC.

Emission efficiency can be determined by calculating the total luminous flux from the results of emission-spectrum measurement using the light emitting device mentioned earlier and then dividing the lumen value (lm) obtained by the power consumption (W). The power consumption can be obtained as the product of the current value and the voltage value, which is measured using True RMS Multimeters Model 187 & 189 manufactured by Fluke Corporation while 20mA electrification.

Particularly the white light emitting device, among the light emitting devices of the present invention, can be obtained with a known device configuration. More specifically, an excitation light source such as described later is used as the first luminous body, and known phosphors, such as a phosphor emitting red fluorescence (hereinafter referred to as "red phosphor" as appropriate), a phosphor emitting blue fluorescence (hereinafter referred to as "blue phosphor" as appropriate), a phosphor emitting yellow fluorescence (hereinafter referred to as "yellow phosphor" as appropriate), which are described later, are used in arbitrary combination, in addition to a green phosphor such as described before.

In this context, the white color of the white light emitting device includes all of (Yellowish) White, (Greenish) White, (Bluish) White, (Purplish) White and White, which are defined in JIS Z8701. Of these, preferable is White.

[3-1. Configuration of light emitting device (luminous body)]

(First luminous body)

The first luminous body of the light emitting device of the present invention emits light for exciting the second luminous body to be described later.

The first luminous body has no particular limitation in its luminous wavelength, insofar as it overlaps the absorption wavelength of the second luminous body to be described later, and therefore, various luminous bodies with wide range of luminous wavelength regions are applicable. Usually a luminous body having luminous wavelength of from ultraviolet region to blue region is used. Among them, particularly preferable are luminous bodies having luminous wavelength of from near-ultraviolet region to blue region.

It is preferable that the luminous wavelength of the first luminous body usually has a concrete value of 200 nm or longer. Among them, it is desirable that, when a near-ultraviolet light is used as the excitation light, a luminous body with a peak luminous wavelength of usually 300 nm or longer, preferably 330 nm or longer, more preferably 360 nm or longer, and usually 420 nm or shorter is used. When a blue light is used as the excitation light, it is desirable that a luminous body with a peak luminous wavelength of usually 420 nm or longer, preferably 430 nm or longer, and usually 500 nm or shorter, preferably 480 nm or shorter is used. Both of these conditions are required from the standpoint of color purity of the light emitting device.

As the first luminous body, a semiconductor luminous element is generally used. Concretely, an emission LED, semiconductor laser diode (hereinafter, abbreviated as "LD" as appropriate) or the like can be used. Other examples of the luminous body that can be used as the first luminous body include an organic electroluminescence luminous element, inorganic electroluminescence luminous element or the like. However, the luminous body that can be used as the first luminous body is not restricted to those exemplified in the present Description.

Among them, a GaN-based LED and LD, using a GaN-based compound semiconductor, are preferable for the first luminous body. This is because a GaN-based LED and LD have light output and external quantum efficiency far greater than those of an SiC-based LED and the like that emit the same range of light and therefore they can give very bright luminescence with very low electric power when used in combination with the above-mentioned phosphor. For example, when applying current load of 20 mA, a GaN-based LED and LD usually have emission intensity 100 times or higher than that of an SiC-based ones. As GaN-based LED or LD, one having an $Al_XGa_YN$ luminous layer, GaN luminous layer or $In_XGa_YN$ luminous layer is preferable. Among them, for GaN-based LED, one having an $In_XGa_YN$ luminous layer is particularly preferable due to its remarkably high emission intensity, and one having a multiple quantum well structure of the $In_XGa_YN$ layer and GaN layer is particularly preferable also due to its remarkably high emission intensity.

In the above description, the value of X + Y usually takes a value in the range of 0.8 to 1.2. For GaN-based LED, one having a such kind of luminous layer that is doped with Zn or Si or without any dopant is preferable for the purpose of adjusting the luminescent characteristics.

A GaN-based LED contains, as its basic components, a such kind of luminous layer, p layer, n layer, electrode and substrate. A GaN-based LED having such a heterostructure as sandwiching the luminous layer with n type and p type of $Al_XGa_YN$ layers, GaN layers, $In_XGa_YN$ layers or the like is preferable, from the standpoint of high emission efficiency. Moreover, the one whose heterostructure is replaced by a quantum well structure is more preferable because it can show higher emission efficiency.

The first luminous body can be used either as a single one or as a mixture of two or more of them in any combination and in any ratio.


(Second luminous body)

The second luminous body of the light emitting device of the present invention is a luminous body which emits visible light when irradiated with light from the above-mentioned first luminous body. It comprises the aforementioned phosphor of the present invention (green phosphor) as the first phosphor, as well as the second phosphor (red phosphor, blue phosphor, orange phosphor and the like) to be described later as appropriate depending on its use or the like. The second luminous body is formed, for example, so that the first and the second phosphors are dispersed in a sealing material.

There is no special limitation on the composition of the phosphor that is used in the second luminous body, exclusive of the phosphor of the present invention. The examples include compounds which is a host crystal, such as a metal oxide typified by $Y_2O_3$, $YVO_4$, $Zn_2SiO_4$, $Y_3Al_5O_{12}$ and $Sr_2SiO_4$, metal nitride typified by $Sr_2Si_5N_8$, phosphate typified by $Ca_5(PO_4)_3Cl$, sulfide typified by ZnS, SrS and CaS and oxysulfide typified by $Y_2O_2S$ and $La_2O_2S$, to which an activation element or coactivation element is added, such as an ion of a rare earth metal of Ce, Pr, Nd, Pm, Sm, Eu, Tb, Dy, Ho, Er, Tm or Yb, or metal ion of Ag, Cu, Au, Al, Mn or Sb.

Preferable examples of the host crystal include sulfides such as (Zn,Cd) S, $SrGa_2S_4$, SrS and ZnS; oxysulfides such as $Y_2O_2S$; aluminates such as $(Y,Gd)_3Al_5O_{12}$, $YAlO_3$, $BaMgAl_{10}O_{17}$, (Ba,Sr) $(Mg,Mn)Al_{10}O_{17}$, (Ba,Sr,Ca) (Mg,Zn, Mn)$Al_{10}O_{17}$, $BaAl_{12}O_{19}$, $CeMgAl_{11}O_{19}$, (Ba,Sr,Mg)·$Al_2O_3$, $BaAl_2Si_2O_8$, $SrAl_2O_4$, $Sr_4Al_{14}O_{25}$ and $Y_3Al_5O_{12}$; silicates such as $Y_2SiO_5$ and $Zn_2SiO_4$; oxides such as $SnO_2$ and $Y_2O_3$; borates such as $GdMgB_5O_{10}$ and $(Y,Gd)BO_3$; halophosphates such as $Ca_{10}(PO_4)_6(F,Cl)_2$ and $(Sr,Ca,Ba,Mg)_{10}(PO_4)_6Cl_2$; and phosphates such as $Sr_2P_2O_7$ and $(La,Ce)PO_4$.

No particular limitation is imposed on the element compositions of the above-mentioned host crystal, and activation element or coactivation element. Partial substitution with an element of the same group is possible. Any phosphor obtained can be used so long as it absorbs light in the near-ultraviolet to visible region and emits visible light.

More concretely, those listed below can be used as phosphor. However, the lists are just examples and phosphors that can be used in the present invention are not limited to those examples. In the following examples, phosphors with different only partial structure are shown abbreviated as mentioned earlier.


(First phosphor)

The second luminous body in the light emitting device of the present invention contains at least the above-mentioned phosphor of the present invention as the first phosphor. The phosphor of the present invention can be used either as a single kind or as a mixture of two or more kinds in any combination and in any ratio. In addition, the first phosphor may contain, other than the phosphor of the present invention, a phosphor (a combined same-color phosphor) emitting a fluorescence of the same color as that of the phosphor of the present invention. As the phosphor of the present invention is usually a green phosphor, another kind of green phosphor can be used as the first phosphor in combination with the phosphor of the present invention.

As such green phosphor, any kind of them can be used, insofar as the advantage of the present invention is not significantly impaired.

Examples of such green phosphor include an europium-activated alkaline earth silicon oxynitride phosphor represented by $(Mg,Ca,Sr,Ba)Si_2O_2N_2$:Eu, which is constituted by fractured particles having a fractured surface and emits light in the green region.

Other examples of such green phosphor include: Eu-activated aluminate phosphor such as $Sr_4Al_{14}O_{25}$:Eu and $(Ba,Sr,Ca)Al_2O_4$:Eu; Eu-activated silicate phosphor such as $(Sr,Ba)Al_2Si_2O_8$:Eu, $(Ba,Mg)_2SiO_4$:Eu, $(Ba,Sr,Ca,Mg)_2SiO_4$: Eu and $(Ba,Sr,Ca)_2(Mg,Zn)Si_2O_7$:Eu; $(Ba,Ca,Sr,Mg)_9(Sc,Y,Lu,Gd)_2(Si,Ge)_6O_{24}$:Eu; Ce,Tb-activated silicate phosphor such as $Y_2SiO_5$:Ce,Tb; Eu-activated borophosphate phosphor such as $Sr_2P_2O_7$-$Sr_2B_2O_5$:Eu; Eu-activated halosilicate phosphor such as $Sr_2Si_3O_8$-$2SrCl_2$:Eu; Mn-activated silicate phosphor such as $Zn_2SiO_4$:Mn; Tb-activated aluminate phosphate such as $CeMgAl_{11}O_{19}$:Tb and $Y_3Al_5O_{12}$:Tb; Tb-activated silicate phosphor such as $Ca_2Y_8(SiO_4)_6O_2$:Tb and

La$_3$Ga$_5$SiO$_{14}$:Tb; Eu,Tb,Sm-activated thiogalate phosphor such as (Sr,Ba,Ca)Ga$_2$S$_4$:Eu,Tb,Sm; Ce-activated aluminate phosphor such as Y$_3$(Al,Ga)$_5$O$_{12}$:Ce and (Y,Ga,Tb,La,Sm,Pr,Lu)$_3$(Al,Ga)$_5$O$_{12}$:Ce; Ce-activated silicate phosphor such as Ca$_3$Sc$_2$Si$_3$O$_{12}$:Ce and Ca$_3$(Sc,Mg,Na,Li)$_2$Si$_3$O$_{12}$:Ce; Ce-activated oxide phosphor such as CaSc$_2$O$_4$:Ce; Eu-activated oxynitride phosphor such as Eu-activated β-sialon; Eu,Mn-activated aluminate phosphor such as BaMgAl$_{10}$O$_{17}$:Eu, Mn; Eu-activated aluminate phosphor such as SrAl$_2$O$_4$:Eu; Tb-activated oxysulfide phosphor such as (La,Gd,Y)$_2$O$_2$S:Tb; Ce,Tb-activated phosphate phosphor such as LaPO$_4$:Ce,Tb; sulfide phosphor such as ZnS:Cu,Al and ZnS:Cu,Au,Al; Ce,Tb-activated borate phosphor such as (Y,Ga,Lu,Sc,La)BO$_3$:Ce,Tb, Na$_2$Gd$_2$B$_2$O$_7$:Ce,Tb and (Ba,Sr)$_2$(Ca,Mg,Zn) B$_2$O$_6$:K,Ce,Tb; Eu,Mn-activated halosilicate phosphor such as Ca$_8$Mg(SiO$_4$)$_4$Cl$_2$:Eu,Mn; Eu-activated thioaluminate phosphor or thiogallate phosphor such as (Sr,Ca,Ba)(Al,Ga,In)$_2$S$_4$:Eu; Eu,Mn-activated halosilicate phosphate such as (Ca, Sr)$_8$(Mg,Zn)(SiO$_4$)$_4$Cl$_2$:Eu,Mn; and Eu-activated oxynitride phosphor such as M$_3$Si$_6$O$_9$N$_4$:Eu and M$_3$Si$_6$O$_{12}$N$_2$:Eu (here, M represents alkaline earth metal element).

Also applicable as the green phosphor are fluorescent dyes such as pyridine-phthalimide condensed derivative, benzoxadinone compound, quinazolinone compound, coumarine compound, quinophthalone compound, naphthalimide compound, and organic phosphors such as terbium complex.

The green phosphor exemplified above can be used either as a single kind or as a mixture of two or more kinds in any combination and in any ratio.

It is preferable that the first phosphor used for the light emitting device of the present invention has an wavelength of emission peak λ$_p$ (nm) in the range of usually longer than 500 nm, particularly 510 nm or longer, further particularly 515 nm or longer, and usually 550 nm or shorter, particularly 542 nm or shorter, further particularly 535 nm or shorter. When the wavelength of emission peak λ$_p$ is too short, the color tends to be bluish. On the other hand, when it is too long, the color tends to be yellowish. In both cases, the characteristics of its green light may deteriorate.

In addition, it is preferable that the first phosphor used for the light emitting device of the present invention has a full width at half maximum (hereinafter abbreviated as "FWHM" as appropriate) of the emission peak, in the above-mentioned emission spectrum, in the range of usually 10 nm or wider, preferably 20 nm or wider, more preferably 25 nm or wider, and usually 85 nm or narrower, particularly 75 nm or narrower, further particularly 70 nm or narrower. When the full width at half maximum, FWHM, is too narrow, the emission intensity may decrease. When it is too wide, the color purity may decrease.

(Second phosphor)

The second luminous body of the light emitting device of the present invention may contain another phosphor (namely, a second phosphor) other than the above-mentioned first phosphor, depending on its use. The second phosphor is a phosphor having a different luminous wavelength from the first phosphor. Such second phosphor is usually used for the purpose of adjusting the color tone of light emission of the second luminous body. Therefore, mostly a phosphor having a different-color fluorescence from the first phosphor is used as the second phosphor. Since a green phosphor is usually used for the first phosphor, as described above, a phosphor other than a green phosphor, such as an orange to red phosphor, blue phosphor or yellow phosphor, is used as the second phosphor.

It is preferable that the weight-average median diameter of the second phosphor used for the light emitting device of the present invention is in the range of usually 10 μm or larger, preferably 12 μm or larger, and usually 30 μm or smaller, preferably 25 μm or smaller. When the weight-average median diameter is too small, the brightness tends to decrease and the phosphor particles tend to aggregate. On the other hand, the weight-average median diameter is too large, unevenness in coating, clogging in a dispenser or the like tend to occur.

(Orange to red phosphor)

When an orange to red phosphor is used as the second phosphor, any kind of orange to red phosphor can be used, insofar as the advantage of the present invention is not significantly impaired. It is preferable that the wavelength of emission peak of the orange or red phosphor is in the range of usually 570 nm or longer, preferably 580 nm or longer, more preferably 585 nm or longer, and usually 780 nm or shorter, preferably 700 nm or shorter, more preferably 680 nm or shorter.

Examples of such orange to red phosphor include an europium-activated alkaline earth silicon nitride phosphor represented by (Mg,Ca,Sr,Ba)$_2$Si$_5$N$_8$:Eu, which is constituted by fractured particles having red fractured surfaces and emits light in red region, and an europium-activated rare-earth oxychalcogenide phosphor represented by (Y,La,Gd, Lu)$_2$O$_2$S:Eu, which is constituted by growing particles having a nearly spherical shapes typical of regular crystal growth and emits light in red region.

Also applicable in the present embodiment is a phosphor containing oxynitride and/or oxysulfide which include at least one element selected from the group consisting of Ti, Zr, Hf, Nb, Ta, W and Mo, described in Japanese Patent Laid-Open Publication No. 2004-300247, and containing an oxynitride having an α-sialon structure in which all or part of Al elements are replaced by Ga elements. These are phosphors which contain oxynitride and/or oxysulfide.

Other examples of the red phosphor include: Eu-activated oxysulfide phosphor such as $(La,Y)_2O_2S$:Eu; Eu-activated oxide phosphor such as $Y(V,P)O_4$:Eu and $Y_2O_3$:Eu; Eu,Mn-activated silicate phosphor such as $(Ba,Mg)_2SiO_4$:Eu,Mn and $(Ba,Sr,Ca,Mg)_2SiO_4$:Eu,Mn; Eu-activated tungstate phosphor such as $LiW_2O_8$:Eu, $LiW_2O_8$:Eu,Sm, $Eu_2W_2O_7$, $Eu_2W_2O_9$:Nb, $Eu_2W_2O_9$:Sm; Eu-activated sulfide phosphor such as $(Ca,Sr)S$:Eu; Eu-activated aluminate phosphor such as $YAlO_3$:Eu; Eu-activated silicate phosphor such as $Ca_2Y_8(SiO_4)_6O_2$:Eu, $LiY_9(SiO_4)_6O_2$:Eu, $(Sr,Ba,Ca)_3SiO_5$:Eu and $Sr_2BaSiO_5$:Eu; Ce-activated aluminate phosphor such as $(Y,Gd)_3Al_5O_{12}$:Ce and $(Tb,Gd)_3Al_5O_{12}$:Ce; Eu-activated oxide, nitride or oxynitride phosphor such as $(Mg,Ca,Sr,Ba)_2Si_5(N,O)_8$:Eu, $(Mg,Ca,Sr,Ba)Si(N,O)_2$:Eu and $(Mg,Ca,Sr,Ba)AlSi(N,O)_3$:Eu; Ce-activated oxide, nitride or oxynitride phosphor such as $(Mg,Ca,Sr,Ba)AlSi(N,O)_3$:Ce; Eu,Mn-activated halophosphate phosphor such as $(Sr,Ca,Ba,Mg)_{10}(PO_4)_6Cl_2$:Eu,Mn; Eu,Mn-activated silicate phosphor such as $Ba_3MgSi_2O_8$:Eu,Mn and $(Ba,Sr,Ca,Mg)_3(Zn,Mg)Si_2O_8$:Eu,Mn; Mn-activated germanate phosphor such as $3.5MgO \cdot 0.5MgF_2 \cdot GeO_2$:Mn; Eu-activated oxynitride phosphor such as Eu-activated $\alpha$-sialon; Eu,Bi-activated oxide phosphor such as $(Gd,Y,Lu,La)_2O_3$:Eu,Bi; Eu,Bi-activated oxysulfide phosphor such as $(Gd,Y,Lu,La)_2O_2S$:Eu,Bi; Eu,Bi-activated vanadate phosphor such as $(Gd,Y,Lu,La)VO_4$:Eu,Bi; Eu,Ce-activated sulfide phosphor such as $SrY_2S_4$:Eu,Ce; Ce-activated sulfide phosphor such as $CaLa_2S_4$:Ce; Eu,Mn-activated phosphate phosphor such as $(Ba,Sr,Ca)MgP_2O_7$:Eu,Mn and $(Sr,Ca,Ba,Mg,Zn)_2P_2O_7$:Eu,Mn; Eu,Mo-activated tungstate phosphor such as $(Y,Lu)_2WO_6$:Eu,Mo; Eu,Ce-activated nitride phosphor such as $(Ba,Sr,Ca)_xSi_yN_z$:Eu,Ce (x,y,z being an integer of 1 or larger); Eu,Mn-activated halophosphate phosphor such as $(Ca,Sr,Ba,Mg)_{10}(PO_4)_6(F,Cl,Br,OH)$:Eu,Mn; and Ce-activated silicate phosphor such as $((Y,Lu,Gd,Tb)_{1-x-y}Sc_xCe_y)_2(Ca,Mg)_{1-r}(Mg,Zn)_{2+r}Si_{z-q}Ge_qO_{12+\delta}$.

Also applicable as the red phosphor are the following examples: red organic phosphor comprising rare-earth ion complex containing anions such as β-diketonate, β-diketone, aromatic carboxylic acid or Bronsted acid as ligands, perylene pigment (for example, dibenzo{[f,f']-4,4',7,7'-tetraphenyl}diindeno[1,2,3-cd:1',2',3'-lm]perylene), anthraquinone pigment, lake pigment, azo pigment, quinacridone pigment, anthracene pigment, isoindoline pigment, isoindolinone pigment, phthalocyanine pigment, triphenylmethane basic dye, indanthrone pigment, indophenol pigment, cyanine pigment and dioxazine pigment.

Among them, it is preferable that the red phosphor contains $(Ca,Sr,Ba)_2Si_5(N,O)_8$:Eu, $(Ca,Sr,Ba)Si(N,O)_2$:Eu, $(Ca,Sr,Ba)AlSi(N,O)_3$:Eu, $(Ca,Sr,Ba)AlSi(N,O)_3$:Ce, $(Sr,Ba)_3SiO_5$:Eu, $(Ca,Sr)S$:Eu, $(La,Y)_2O_2S$:Eu or Eu complex. It is more preferable that it contains $(Ca,Sr,Ba)_2Si_5(N,O)_8$:Eu, $(Ca,Sr,Ba)Si(N,O)_2$:Eu, $(Ca,Sr,Ba)AlSi(N,O)_3$:Eu, $(Ca,Sr,Ba)AlSi(N,O)_3$:Ce, $(Sr,Ba)_3SiO_5$:Eu, $(Ca,Sr)S$:Eu, $(La,Y)_2O_2S$:Eu, β-diketone Eu complex such as Eu(dibenzoylmethane)$_3 \cdot$1,10-phenanthroline complex or carboxylic acid Eu complex. Of these, especially preferable are $(Ca,Sr,Ba)_2Si_5(N,O)_8$:Eu, $(Sr,Ca)AlSiN_3$:Eu or $(La,Y)_2O_2S$:Eu.

Among the above examples, a phosphor that can be preferably used as the orange phosphor is $(Sr,Ba)_3SiO_5$:Eu

(Blue phosphor)

When a blue phosphor is used as the second phosphor, any kind of blue phosphor can be used, insofar as the advantage of the present invention is not significantly impaired. At this point, it is preferable that the wavelength of emission peak of the blue phosphor is in the range of usually 420 nm or longer, preferably 430 nm or longer, more preferably 440 nm or longer, and usually 490 nm or shorter, preferably 480 nm or shorter, more preferably 470 nm or shorter, still more preferably 460 nm or shorter.

Examples of the blue phosphor include europium-activated barium magnesium aluminate phosphors represented by $(Ba, Sr,Ca)MgAl_{10}O_{17}$:Eu, which is constituted by growing particles having a nearly hexagonal shape typical of regular crystal growth and emits light in the blue region, europium-activated calcium halphosphate phosphors represented by $(Mg,Ca,Sr,Ba)_5(PO_4)_3(Cl,F)$:Eu, which is constituted by growing particles having a nearly spherical shape typical of regular crystal growth and emits light in the blue region, europium-activated alkaline earth chloroborate phosphors represented by $(Ca,Sr,Ba)_2B_5O_9Cl$:Eu, which is constituted by growing particles having a nearly cubic shape typical of regular crystal growth and emits light in the blue region, and europium-activated alkaline earth aluminate phosphors represented by $(Sr,Ca,Ba)Al_2O_4$:Eu or $(Sr,Ca,Ba)_4Al_{14}O_{25}$:Eu, which is constituted by fractured particles having fractured surfaces and emits light in the blue green region or the like.

Other examples of the blue phosphor include: Sn-activated phosphate phosphor such as $Sr_2P_2O_7$:Sn; Eu-activated aluminate phosphor such as $(Sr,Ca,Ba)Al_2O_4$:Eu or $(Sr,Ca,Ba)_4AL_{14}O_{25}$:Eu, $BaMgAl_{10}O_{17}$:Eu, $(Ba,Sr,Ca)MgAl_{10}O_{17}$:Eu, $BaMgAl_{10}O_{17}$:Eu,Tb,Sm and $BaAl_8O_{13}$:Eu; Ce-activated thiogalate phosphor such as $SrGa_2S_4$:Ce and $CaGa_2S_4$:Ce; Eu,Mn-activated aluminate phosphor such as $(Ba,Sr,Ca)MgAl_{10}O_{17}$:Eu,Mn; Eu-activated halophosphate phosphor such as $(Sr,Ca,Ba,Mg)_{10}(PO_4)_6Cl_2$:Eu and $(Ba,Sr,Ca)_5(PO_4)_3(Cl,F,Br,OH)$:Eu,Mn,Sb; Eu-activated silicate phosphor such as $BaAl_2Si_2O_8$:Eu, $(Sr,Ba)_3MgSi_2O_8$:Eu; Eu-activated phosphate such as $Sr_2P_2O_7$:Eu; sulfide phosphor such as ZnS:Ag and ZnS:Ag,Al; Ce-activated silicate phosphor such as $Y_2SiO_5$:Ce; tungstate phosphor such as $CaWO_4$; Eu,Mn-activated borophosphate phosphor such as $(Ba,Sr,Ca)BPO_5$:Eu,Mn, $(Sr,Ca)_{10}(PO_4)_6 \cdot nB_2O_3$:Eu and $2SrO \cdot 0.84P_2O_5 \cdot 0.16B_2O_3$:Eu; Eu-activated halosilicate phosphor such as $Sr_2Si_3O_8 \cdot 2SrCl_2$:Eu; and Eu-activated oxyni-

tride phosphor such as $SrSi_9Al_{19}ON_{31}$:Eu and $EuSi_9Al_{19}ON_{31}$.

Also applicable as the blue phosphor are, for example, fluorescent dyes such as naphthalimide compound, benzoxazole compound, styryl compound, coumarine compound, pyrazoline compound and triazole compound, and organic phosphors such as thlium complex.

Among them, it is preferable that the blue phosphor contains $(Ca,Sr,Ba)MgAl_{10}O_{17}$:Eu, $(Sr,Ca,Ba,Mg)_{10}(PO_4)_6$ $(Cl,F)_2$:Eu or $(Ba,Ca,Mg,Sr)_2SiO_4$:Eu. It is more preferable that it contains $(Ca,Sr,Ba)MgAl_{10}O_{17}$:Eu, $(Sr,Ca,Ba,Mg)_{10}$ $(PO_4)_6(Cl,F)_2$:Eu or $(Ba,Ca,Sr)_3MgSi_2O_8$:Eu. It is still more preferable that it contains $BaMgAl_{10}O_{17}$:Eu, $Sr_{10}(PO_4)_6(Cl, F)_2$:Eu or $Ba_3MgSi_2O_8$:Eu. Of these, $(Sr,Ca,Ba,Mg)_{10}(PO_4)_6Cl_2$:Eu or $(Ca,Sr,Ba)MgAl_{10}O_{17}$:Eu is particularly preferable in uses for a lighting system and a display.

(Yellow phosphor)

When a yellow phosphor is used as the second phosphor, any kind of yellow phosphor can be used, insofar as the advantage of the present invention is not significantly impaired. It is preferable that the wavelength of emission peak of the yellow phosphor is in the range of usually 530 nm or longer, preferably 540 nm or longer, more preferably 550 nm or longer, and usually 620 nm or shorter, preferably 600 nm or shorter, more preferably 580 nm or shorter.

Examples of the yellow phosphor include: various phosphors of such as oxide, nitride, oxynitride, sulfide and oxysulfide.

Particularly preferable examples include: garnet phosphors having garnet structures, represented by $RE_3M_5O_{12}$:Ce (here, RE indicates at least one element selected from the group consisting of Y, Tb, Gd, Lu and Sm, and M indicates at least one element selected from the group consisting of Al, Ga and Sc) and $M^a_3M^b_2M^c_3O_{12}$:Ce (here, $M^a$ is a divalent metal, $M^b$ is a trivalent metal and $M^c$ is a tetravalent metal), for example; orthosilicate phosphors represented by $AE_2M^dO_4$: Eu (here, AE indicates at least- one element selected from the group consisting of Ba, Sr, Ca, Mg and Zn, and $M^d$ indicates Si and/or Ge); oxynitride phosphors in which a part of the oxygen, contained in the above types of phosphors as constituent element, are substituted by nitrogen; and Ce-activated phosphors such as nitride phosphors having $CaAlSiN_3$ structures such as $AEAlSiN_3$:Ce (here, AE indicates at least one element selected from the group consisting of Ba, Sr, Ca, Mg and Zn).

Also applicable as another yellow phosphor are Eu-activated phosphors such as sulfide phosphors such as $CaGa_2S_4$:Eu, $(Ca,Sr)Ga_2S_4$:Eu and $(Ca,Sr)(Ga,Al)_2S_4$:Eu and Eu-activated oxynitride phosphors having SiAlON structure such as $Ca_x(Si,Al)_{12}(O,N)_{16}$:Eu.

Other examples of the yellow phosphor include fluorescent dyes such as brilliant sulfoflavine FF (Colour Index Number 56205), basic yellow HG (Colour Index Number 46040), eosine (Colour Index Number 45380) and rhodamine 6G (Colour Index Number 45160).

(Combination of second phosphors)

The above-mentioned second phosphors can be used either as a single kind or as a mixture of two or more kinds in any combination and in any ratio. There is no special limitation on the ratio between the first phosphor and the second phosphor, insofar as the advantage of the present invention is not significantly impaired. Accordingly, the amount of the second phosphors used, as well as the combination and the mixing ratio of the phosphors used as the second phosphor, can be set arbitrarily according to the use or the like of the light emitting device.

Whether the above-described second phosphors (orange or red phosphors, blue phosphors or the like) are used or not and what kind of them are used, in the light emitting device of the present invention, can be decided as appropriate depending on the use of the light emitting device. For example when the light emitting device of the present invention is constructed so that it is used as green light emitting device, only the first phosphor (green phosphor) is enough to be used and no second phosphor is needed.

On the other hand, when the light emitting device of the present invention is constructed so that it is used as white light emitting device, it would be better to combine the first luminous body, the first phosphor (green phosphor) and the second phosphor appropriately, for synthesizing the desired white color. As concrete examples of the preferable combination of the first luminous body, the first phosphor and the second phosphor, when the light emitting device of the present invention is constructed so that it is used as white light emitting device, can be cited as the following ones (i) to (iii).

(i) A blue luminous body (blue LED or the like) as the first luminous body, a green phosphor (the phosphor of the present invention or the like) as the first phosphor, and a red phosphor as the second phosphor are used. In this case, as red phosphor is preferably used one or more than one kind of red phosphor selected from the group consisting of $(Sr,Ca)AlSiN_3$:Eu.

(ii) A near-ultraviolet luminous body (near-ultraviolet LED or the like) as the first luminous body, a green phosphor (the phosphor of the present invention or the like) as the first phosphor, and a combination of a blue phosphor and a red phosphor as the second phosphor, are used. In this case, as blue phosphor is preferably used one or more than one kind of blue phosphor selected from the group consisting of $(Ba,Sr,Ca)MgAl_{10}O_{17}:Eu$ and $(Mg,Ca,Sr,Ba)_5(PO_4)_3$ $(Cl,F):Eu$. As red phosphor is preferably used one or more than one kind of red phosphor selected from the group consisting of $(Sr,Ca)AlSiN_3:Eu$ and $La_2O_2S:Eu$. Among them, it is particularly preferable to use a near-ultraviolet LED, the phosphor of the present invention, $BaMgAl_{10}O_{17}:Eu$ as blue phosphor, and $(Sr,Ca)AlSiN:_3:Eu$ as red phosphor, in combination.

(iii) A blue luminous body (blue LED or the like) as the first luminous body, a green phosphor (the phosphor of the present invention or the like) as the first phosphor, and an orange phosphor as the second phosphor are used. In this case, as orange phosphor is preferably used $(Sr,Ba)_3SiO_5:Eu$.

The phosphor of the present invention can be used as a mixture with another phosphor (in this context, "mixture" does not necessarily mean to blend the phosphors with each other, but it means to use different kinds of phosphors in combination). Among them, the combined use of phosphors described above will provide a preferable phosphor mixture. There is no special limitation on the kind or the ratio of the phosphors mixed.

(Imide / amide method)

When producing various phosphors mentioned above, it is sometimes preferable to use specific production methods which make use of imide and/or amide compounds as materials (this method will be hereinafter referred to as "imide / amide method", as appropriate). This imide / amide method will be explained below.

A phosphor which can be a target of imide / amide method of production is usually a phosphor containing at least one kind of element selected from the group consisting of Si, Al, lanthanoid element, and alkaline-earth metal element. Of these, preferable is a nitride phosphor or oxynitride phosphor containing alkaline-earth metal element. Concrete examples of a phosphor which can be a target of imide / amide method of production include: Eu-activated nitride or oxynitride phosphor such as Eu-activated α-sialon, Eu-activated β-sialon, $(Mg,Ca,Sr,Ba)_2Si_5(N,O)_8:Eu$, $(Mg,Ca,Sr,Ba)Si(N,O)_2:Eu$, $(Mg,Ca,Sr,Ba)AlSi(N,O)_3:Eu$, $SrSi_9Al_{19}ON_{31}:Eu$, $EuSi_9Al_{19}ON_{31}$, $(Mg,Ca,Sr,Ba)_3Si_6O_9N_4:Eu$, and $(Mg,Ca,Sr,Ba)_3Si_6O_{12}N_2:Eu$; Ce-activated nitride or oxynitride phosphor such as $(Mg,Ca,Sr,Ba)Alsi(N,O)_3:Ce$; and Eu,Ce-activated nitride phosphor such as $(Ba,Sr,Ca)_xSi_yN_z:Eu,Ce$ (here, x, y and z indicate an integer of 1 or larger).

Imide / amide method is characterized in that as material, it uses as material an imide compound and/or amide compound containing one or more than one kind of element constituting a phosphor (for example, alkaline-earth metal element). Imide compounds or amide compounds can be purchased or can be synthesized by the method described later, for example.

Examples of alkaline-earth metal element contained in the imide compounds or amide compounds include: calcium (Ca), strontium (Sr) and barium (Ba). Of these, strontium (Sr) and barium (Ba) are preferable. The imide compounds can contain any one kind of the above alkaline-earth metal elements singly or two or more kinds of them together in any combination and in any ratio.

As the imide compounds, imide compounds of various alkaline-earth metal elements can be used, for example. Among them, preferable are imide compounds of Sr (for example, SrNH) and imide compounds of Ba (for example, BaNH).

Examples of the amide compound include $Y(NH_2)_3$, $Ln^2(NH_2)_2$, $Ln^3(NH_2)_3$, $M^1Ln^2_2(NH_2)_5$, $M^1Ln^3_2(NH_2)_7$, $M^1_3Ln^2(NH_2)_5$, $M^1_3Ln^3(NH_2)_6$, $M^1Al(NH_2)_4$, $M^2Al(NH_2)_5$ and $M^2(NH_2)_2$. In the formula, "$Ln^2$" indicates a bivalent lantanoid element, more concretely one or more than one kind of element selected from the group consisting of Sm, Eu and Yb. "$Ln^3$" indicates a trivalent lanthanoid element, more concretely one or more than one kind of element selected from the group consisting of La, Ce, Pr, Nd, Gd, Tb, Dy, Ho, Er and Tm. "$M^1$" indicates an alkali metal element, more concretely one or more than one kind of element selected from the group consisting of Li, Na, K, Rb and Cs. "$M^2$" indicates an alkaline-earth metal element, more concretely one or more than one kind of element selected from the group consisting of Mg, Ca, Sr and Ba. These definitions apply throughout the descriptions of the present section, "imide / amide method".

In this imide / amide method, one kind of imide compound or amide compound can be used singly, or two or more kinds of imide compound and/or amide compound can be used in any combination and in any ratio.

No particular limitation is imposed on the synthesis method of the imide compounds and amide compounds. Explanations will be given thereon in the following with reference to concrete examples.

As production method of the imide compounds containing alkaline-earth metal, a method can be cited in which alkaline-earth metal is fired in an ammoniacal atmosphere. The conditions of this reaction will be explained below.

The firing step is usually done by the following procedur, in which the material alkaline-earth metals are weighed out and filled into a heat-resistant vessel such as a crucible or tray which is made of material of low reactivity and then fired. Material examples of such a heat-resistant vessel used at the time of firing include: ceramics such as alumina, quartz, boron nitride, silicon carbide, silicon nitride and magnesium oxide, metals such as platinum, molybdenum, tungsten, tantalum, niobium, iridium and rhodium, alloys mainly constituted of these metals and carbon (graphite). Of these, a heat-resistant vessel made of quartz can be used for heat treatment at relatively low temperatures such as 1200 °C or lower, and the preferable temperature range of its use is 1000 °C or lower. Among the above-cited materials of the heat-resistant vessel, preferable are alumina and metals.

The firing temperature is in the range of usually 300 °C or higher, preferably 400 °C or higher, and usually 800 °C or lower, preferably 700 °C or lower. When the firing temperature is too low, the production reaction does not proceed satisfactorily and imide compounds may not be obtained sufficiently. When the temperature is too high, imide compounds formed may decompose and nitride of low reactivity may be obtained.

The pressure at the time of firing differs depending on such factors as firing temperature and therefore is not limited specially. However, it is usually 0.01 MPa or higher, preferably 0.1 MPa or higher, and usually 200 MPa or lower, preferably 100 MPa or lower. Industrially, the pressure in the range of around from atmospheric pressure to 1 MPa is convenient and preferable from the standpoint of cost and convenience.

The atmosphere at the time of firing is to be ammoniacal atmosphere. It is sufficient that the atmosphere is ammoniacal when the above-mentioned range of firing temperature is maintained. No particular limitation is imposed on the atmosphere at other times.

The firing time differs depending on the temperature or pressure at the time of firing and therefore is not limited specially. However, it is in the range of usually 10 minutes or longer, preferably 30 minutes or longer, and usually 10 hours or shorter, more preferably 6 hours or shorter. When the firing time is too short, the production reaction may be inadequate. When it is too long, firing energy may be wasted, leading to higher production cost.

An example of production method of imide compounds containing Si can be cited as follows. Starting material of $SiCl_4$ is dispersed in hexane and ammonia gas is bubbled into this solution. Through the reaction of the $SiCl_4$ and ammonia gas, $Si(NH)_2$ and $NH_4Cl$ are formed. This solution is heated in an atmosphere of inert gas to remove $NH_4Cl$. Thereby $Si(NH)_2$ can be obtained.

An example of production method of amide compounds of Al can be cited as follows. Starting material of Al metal and alkali metal, or Al metal and alkaline-earth metal are placed in a stainless reaction tube and the tube is cooled to -30 °C. Ammonia gas is then introduced into the reaction tube and condensed as' liquid ammonia. Subsequently, the upper end of this reaction tube is then sealed and the lower end is heated at a temperature between 80 °C and 100 °C over a period of 24 hours. Through this reaction, the material metal is allowed to dissolve in the liquid ammonia. After the reaction, ammonia gas is removed and amide compound is obtained in the form of $M^1Al(NH_2)_4$ or $M^2Al(NH_2)_5$.

An example of production method of amide compounds of Y and lanthanoid element can be cited as follows. Starting material of lanthanoid element metal or Y metal is placed in a stainless reaction tube and the tube is cooled to -30 °C. Ammonia gas is then introduced into the reaction tube and condensed as liquid ammonia. Subsequently, the upper end of this reaction tube is then sealed and the lower end is heated at a temperature between 80 °C and 100 °C over a period of 24 hours. Through this reaction, the material metal is allowed to dissolve in the liquid ammonia. After the reaction, ammonia gas is removed and amide compound is obtained in the form of $Y(NH_2)_3$, $Ln^2(NH_2)_2$ and $Ln^3(NH_2)_3$.

An example of production method of amide compounds of alkali metal element and alkaline-earth metal element can be cited as follows. Starting material of alkali metal or alkaline-earth metal is placed in a stainless reaction tube and the tube is cooled to -30 °C. Ammonia gas is then introduced into the reaction tube and condensed as liquid ammonia. Subsequently, the upper end of this reaction tube is then sealed and the lower end is heated at a temperature between 80 °C and 100 °C over a period of 24 hours. Through this reaction, the material metal is allowed to dissolve in the liquid ammonia. After the reaction, ammonia gas is removed and amide compound is obtained in the form of $M^1NH_2$ or $M^2(NH_2)_2$.

Then the production method of phosphors based on the above-mentioned imide compounds and/or amide compounds will be explained below.

As phosphor materials, one kind or two or more kinds of imide compound and/or amide compound are used, together with other compounds, as appropriate. The kind or ratio of phosphor materials including the imide compound and/or amide compound and the other compound can be selected suitably according to the composition of the phosphor intended to be produced.

The process of the imide / amide method is the same as that of ordinary process of phosphor production, except that the above-mentioned phosphor materials are used. Namely, the phosphor materials are weighed out and mixed (mixing step), the mixture obtained is fired under the predetermined conditions (firing step) and the fired product is pulverized, washed and surface-treated, if necessary, to prepare a phosphor. Since imide compounds and amide compounds are usually unstable against moisture in air, it is preferable to perform the step of weighing, mixing or the like in a glove box filled with inert gas such as argon or nitrogen.

There is no special limitation on the method of mixing the phosphor materials. Concrete examples include the following (A) dry-type methods and (B) wet-type methods. Imide compounds and/or amide compounds are unstable in polar solvents such as water and, therefore, the dry-type method (A) is usually used.

(A) Dry-type mixing methods in which the above-mentioned materials are pulverized and mixed by combining pulverization, which is done by means of a dry-type pulverizer such as a hammer mill, roll mill, ball mill and jet mill, or pestle / mortar, and mixing, which is done by means of a mixing apparatus such as ribbon blender, V type blender and Henschel mixer, or pestle / mortar.

(B) Wet-type mixing methods in which solvents or dispersion media such as water, methanol or ethanol are added to the above-mentioned materials, and mixing is done by means of a pulverizer, pestle / mortar, evaporation dish / stirring rod or the like, to make a solution or slurry, followed by drying by such method as spray drying, heated drying or air drying.

The firing step is usually done by the following procedure. Namely, the mixture obtained in the above-mentioned mixing step is filled into a heat-resistant vessel such as a crucible or tray which is made of material unlikely to react with each phosphor material and then fired. Material examples of such a heat-resistant vessel used at the time of firing can include ceramics such as alumina, quartz, boron nitride, silicon carbide, silicon nitride and magnesium oxide, metals such as platinum, molybdenum, tungsten, tantalum, niobium, iridium and rhodium, alloys mainly constituted of these metals and carbon (graphite). Of these, a heat-resistant vessel made of quartz can be used for heat treatment at relatively low temperatures such as 1200 °C or lower, and the preferable temperature range of its use is 1000 °C or lower. Among the above-cited materials of the heat-resistant vessel, preferable are alumina and metals.

The firing temperature is in the range of usually 1000 °C or higher, preferably 1200 °C or higher, and usually 1900 °C or lower, preferably 1800 °C or lower. When the firing temperature is too low, the luminescent characteristics may decrease. When the temperature is too high, the phosphor intended may not be produced.

The pressure at the time of firing differs depending on such factors as firing temperature and therefore is not limited specially. However, it is usually 0.01 MPa or higher, preferably 0.1 MPa or higher, and usually 200 MPa or lower, preferably 100 MPa or lower.

The firing time differs depending on the temperature or pressure at the time of firing and therefore is not limited specially. However, it is in the range of usually 10 minutes or longer, preferably 1 hour or longer, more preferably 4 hours or longer, and usually 24 hours or shorter, preferably 8 hours or shorter, preferably 6 hours or shorter. When the firing time is too short, the production reaction may be inadequate. When it is too long, firing energy may be wasted, leading to higher production cost.

No particular limitation is imposed on the kind of atmosphere at the time of firing. Usually, inert gas atmosphere such as nitrogen gas ($N_2$) atmosphere or argon gas atmosphere is preferred.

The use of imide / amide method is preferable, since the phosphors obtained can be improved in their brightnesses. The reason is not clear but is considered as follows.

Imide compounds (for example, SrNH) and amide compounds used as materials in the imide / amide method have a lower oxygen content than acid compounds (sic) used in previous phosphor-producing method (for example, $SrCO_3$), and, therefore, its use as phosphor material is considered to lead to lower oxygen content in the resultant phosphor, bringing about improved brightness of the phosphor.

Nitride (for example, $Sr_2N$) can also be used as a phosphor material. Nitride such as $Sr_2N$ is unstable in air and, since the ratio of N is low relative to alkaline-earth metal element such as Sr, the phosphor obtained is liable to produce crystal defect. In contrast, in imide compounds such as SrNH and amide compounds, the ratio of N relative to alkaline-earth metal element is higher than nitrides, and therefore, crystal defect in the phosphor is less likely to occur. As a result, it is considered that crystallinity of the phosphor improves and effect of improving brightness can be obtained.

Further, hydrogen (H) contained in imide compounds and amide compounds combines with oxygen (O) during firing to form water ($H_2O$) and oxygen concentration in the phosphor obtained is considered to be lowered accordingly.

By using imide / amide method, oxygen content of phosphors decreases, and crystallinity and purity of the phosphors obtained improve, as described above, therefore it is considered that such effects as not only improved brightness of the phosphor obtained but also sharpened peak of the emission spectrum (namely, narrower full width at half maximum of the emission peak) of the phosphor obtained, which may be due to greater homogenization of environment surrounding the activation element such as Eu, are obtained.

(Sealing material)

The above-mentioned first and/or second phosphors are usually used by being dispersed in a liquid medium, which serves as a sealing material, in the light emitting device of the present invention.

Examples of that liquid medium include the same ones as described in the aforementioned section of [2. Phosphor-containing composition].

The liquid medium may contain a metal element that can be a metal oxide having high refractive index, for the purpose of adjusting the refractive index of the sealing member. Examples of a metal element that can be metal oxide having high refractive indexes can be cited Si, Al, Zr, Ti, Y, Nb and B. These metal elements can be used as a single kind or as a mixture of two or more kinds in any combination and in any ratio.

There is no special limitation on the state of existence of such metal elements, insofar as the transparency of the sealing member does not deteriorate. For example, they may exist as a uniform glass layer of metalloxane bonds or as particles in the sealing member. When they exist in a state of particles, the structure inside the particles may be either amorphous or crystal structure. However, for higher refractive index, the crystal structure is preferable.The particle diameter thereof is usually equal to or smaller than the luminous wavelength of a semiconductor luminous element, and preferably 100 nm or smaller, more preferably 50 nm or smaller, particularly preferably 30 nm or smaller, in order not to impair the transparency of the sealing member. The above-mentioned metal elements in a state of particles contained in the sealing member can be obtained by means of adding, for example, to a silicone material, such particles as silicon oxide, aluminium oxide, zirconium oxide, titanium oxide, yttrium oxide, niobium oxide or the like.

Furthermore, the above-mentioned liquid medium may be further added with a known additive such as diffusing agent, filler, viscosity modifier and UV absorbing agent.

[3-2. (Other) configurations of light emitting device]

There is no special limitation on the other configuration of the light emitting device of the present invention, insofar as it comprises the above-mentioned first luminous body and second luminous body. However, it usually comprises a frame on which the above-mentioned first luminous body and second luminous body are located. The location is configured so that the second luminous body is excited (namely, the first and second phosphors are excited) by the light emitted from the first luminous body to emit light and the lights from the first luminous body and/or from the second luminous body are radiated to the outside. At this point, it is not always necessary for the first and second phosphors to be contained in the same layer. Each of different colored phosphors may be contained in the different layer from each other. For example, a layer containing the second phosphor can be laminated on a layer containing the first phosphor.

The light emitting device of the present invention may also utilize a member other than the above-mentioned excitation light source (the first luminous body), the phosphor (the second luminous body) and a frame. As an example the aforementioned sealing material can be cited. The sealing material can be used for, in addition to dispersing the phosphor (the second luminous body), adhering the excitation light source (the first luminous body), the phosphor (the second luminous body) and the frame to each other, in the light emitting device.

[3-3. Embodiment of light emitting device]

The light emitting device of the present invention will be explained in detail below with reference to a concrete embodiment. However, it is to be noted that the present invention is by no means restricted to the following embodiment and any modifications can be added thereto insofar as they do not depart from the scope of the present invention.

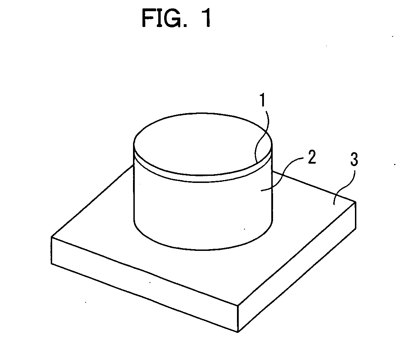

Fig. 1 is a schematic perspective view illustrating the positional relationship between the first luminous body, which functions as the excitation light source, and the second luminous body, constructed as the phosphor-containing part containing a phosphor, in an example of the light emitting device of the present invention. In Fig. 1, the numeral 1 indicates a phosphor-containing part (second luminous body), the numeral 2 indicates a surface emitting type GaN-based LD as an excitation light source (first luminous body), and the numeral 3 indicates a substrate. In order to configure them so that they are in contact with each other, the LD (2) and the phosphor-containing part (second luminous body) (1), prepared separately, may be made in contact with each other in their surfaces by means of adhesive or the like, or otherwise, the phosphor-containing part (second luminous body) may be formed as a layer (molded) on the emission surface of the LD (2). With such configurations, the LD (2) and the phosphor-containing part (second luminous body) (1) can be kept in contact with each other.

With such device configurations, light quantity loss, induced by a leakage of light emitted from the excitation light source (first luminous body) and reflected on the layer surface of the phosphor-containing part (second luminous body) to outside, can be avoided, which enables the enhancement in emission efficiency of the entire device.

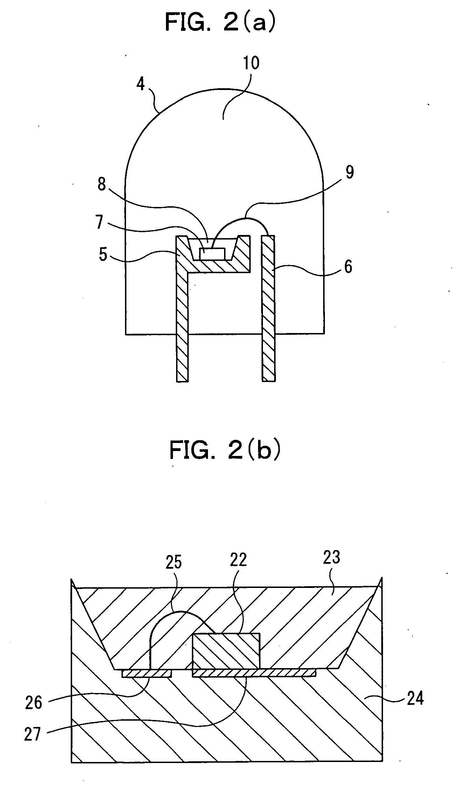

Fig. 2(a) shows a typical example of a light emitting device generally called a shell type. It is a schematic sectional view illustrating an example of the light emitting device comprising an excitation light source (first luminous body) and a phosphor-containing part (second luminous body). In this light emitting device (4), the numeral 5 indicates a mount lead, numeral 6 indicates inner lead, numeral 7 indicates excitation light source (first luminous body), numeral 8 indicates phosphor-containing resinous part, numeral 9 indicates conductive wire and numeral 10 indicates mold member.

Fig. 2(b) shows a typical example of a light emitting device generally called a surface-mount type. It is a schematic sectional view illustrating an example of the light emitting device comprising an excitation light source (first luminous body) and a phosphor-containing part (second luminous body). In the Figure, the numeral 22 indicates an excitation light source (first luminous body), numeral 23 indicates a phosphor-containing resinous part as phosphor-containing part (second luminous body), numeral 24 indicates a frame, numeral 25 indicates a conductive wire and numerals 26 and 27 indicate electrodes.

[3-4. Application of light emitting device]

There is no special limitation on the application of the light emitting device of the present invention, and therefore it can be used in various fields where a usual light emitting device is used. However, owing to its wide color reproduction range and high color rendering, it can be particularly preferably used as a light source of a lighting system or a display.

[3-4-1. Lighting system]

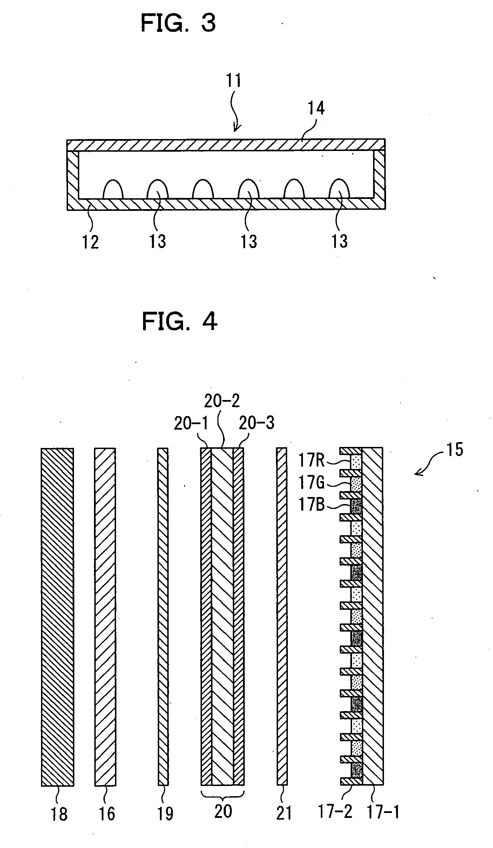

The application of the light emitting device of the present invention to a lighting system can be carried out by incorporating a light emitting device such as described earlier into a known lighting system as appropriate. A surface-emitting lighting system, shown in Fig. 3, in which the aforementioned light emitting device (4) is incorporated, can be cited as the example.

Fig. 3 is a sectional view schematically illustrating an embodiment of the lighting system of the present invention. As shown in this Fig. 3, the surface-emitting lighting system comprises a large number of light emitting devices (13) (corresponding to the aforementioned light emitting device (4)) on the bottom surface of a rectangular holding case (12), of which inner surfaces are made to be opaque ones such as white smooth surfaces, and a power supply, circuit or the like (not shown in the figure) for driving the light emitting devices (13) outside the holding case. In addition, it comprises a milky-white diffusion plate (14), such as an acrylic plate, at the place corresponding to the cover part of the holding case (12), for homogenizing the light emitted.

When the surface-emitting lighting system (11) is driven, and then by means of applying a voltage to the excitation light source (the first luminous body) of the light emitting device (13), light is emitted from the light source and the aforementioned phosphor in the phosphor-containing resinous part, which serves as phosphor-containing part (the second luminous body), absorbs a part of the emitted light and emits visible light. On the other hand, the blue light that is not absorbed in the phosphor is mixed with the visible light to form a light emission with high color rendering, and then the mixed light passes through the diffusion plate (14) to be radiated in the upward direction of the figure. Consequently, an illumination light with a brightness that is uniform within the surface of the diffusion plate (14) of the holding case (12) can be obtained.

[3-4-2. Display]

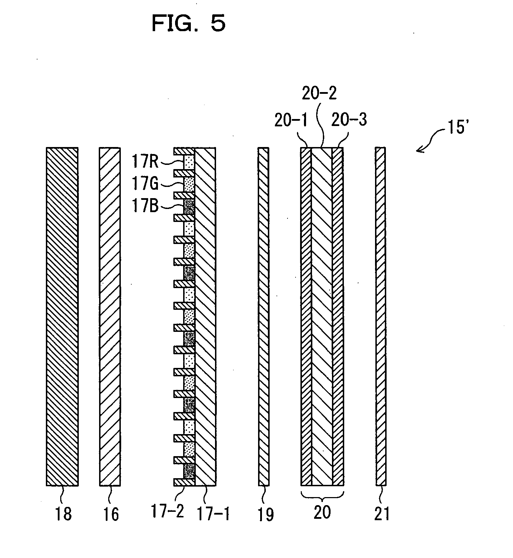

When the light emitting device of the present invention is applied to a display, there is no limitation on the concrete configuration of the display. However, typical examples include those shown in Fig. 4 and Fig. 5.

Fig. 4 is an exploded sectional view schematically illustrating the substantial part of the display of an embodiment of the present invention. In Fig. 4, it is assumed that an observer looks at the image shown on the display from the right side of the figure.

The display (15) of the present embodiment comprises a light source (16) which emits excitation light, and phosphor parts (17R), (17G), and (17B) containing phosphors which absorb the light emitted from the light source (16) and emit visible lights. In addition, the display (15) comprises a frame (18), a polarizer (19), an optical shutter (20) and an analyzer (21).
In the following, an explanation will be given on each of the components.

[Frame]

The frame (18) is a base to hold such the members constituting the display (15) as the light sauce (16), and no special limitation is imposed on its shape.
There is no special limitation on the material of the frame (18), either. The examples thereof include inorganic materials such as metal, alloy, glass or carbon, and organic materials such as synthetic resin. An appropriate one can be selected according to the manner the frame is used.

More concretely, the entire frame (18) or the surface of the frame (18) is made of the material (a resin used for injection molding or the like) which contains such substance having high reflectance as glass fiber, alumina powder or titanium powder.

There is no special limitation on the concrete method to increase the reflectance of the surface of the frame (18). In addition to selecting a suitable material for the frame (18) itself as described above, it is possible to heighten the light reflectance by plating or vapor deposition with metal or alloy having high reflectance, such as silver, platinum or aluminum.

Enhanced reflectance can be provided to the entire frame (18) or to only a part of the frame (18). It is usually desirable that all the surfaces that will be irradiated with light emitted from the light source (16) have enhanced reflectance.

Additionally, the frame (18) is usually fitted with an electrode or a terminal, via which electric power is supplied to the light source (16). At this point, there is no special limitation on the means to connect such electrode or terminal with the light source (16). For example, the light source (16) and an electrode or a terminal can be connected by wire bonding to supply electric power. There is no limitation on the material or the size of the wire. For example, metals such as gold or aluminum can be used as materials for the wire and its thickness can be usually in the range of 20 $\mu$m to 40 $\mu$m. The wires to be used, however, is by no means limited by these examples.

Another example of the method of supplying electric power to the light source (16) is a method based on flip-chip mounting using a bump.

Using solder is another method for supplying electric power to the light source (16). This is because the heat dissipating property of the display (15) can be enhanced, due to excellent heat dissipating property of soldering, especially when high power LED, LD or the like, in which the heat release matters, is used as the excitation light source (first luminous body) of the light source (16). There is no special limitation on the kind of solder. For example, AuSn or AgSn can be used.

The solder can be used for just attaching the light source (16) on the frame (18), in addition to being connected to an electrode or terminal to be used as power-supplying pathway.

When a method'other than solder is used to attach the light source (16) to the frame (18), an adhesive agent such as epoxy resin, imide resin or acrylic resin can be used, for example. In this case, a paste can be used, which is prepared by adding conductive filler such as silver particles or carbon particles to the adhesive agent, so as to make it possible for the power to be supplied to the light source (16) by electrifying the adhesive agent, similarly to when soldering is used. The mixing of such conductive filler is preferable also from the viewpoint of increasing heat dissipating property.

In the present embodiment, a flat-plate shaped frame (18) is used, of which surface is enhanced in reflectance and has a terminal (not shown in the figure) thereon to supply electric power to the light source (16). In addition, to the terminal, electric power can be supplied from a power supply (not shown in the figure).

[Light source]

The light source (16) corresponds to the first luminous body, which emits excitation light, of the light emitting device of the present invention such as described before. The light emitted from the light source (16) serves as excitation light to excite the phosphors contained in the phosphor parts (17R), (17G) and (17B). Furthermore, it is possible that the observer of the display (15) can see the light emitted from the light source (16) itself. In such a case, the light emitted from the light source (16) will also be a light from the pixel itself.

Any wavelength in ultraviolet region or visible region can be adopted for the light emitted from the light source (16), insofar as the light can excite the phosphors within the phosphor parts (17R), (17G) and (17B). A desirable range of the wavelength of the light emitted from the light source is, as its main wavelength of emission peak, usually 350 nm or longer, preferably 380 nm or longer, more preferably 390 nm or longer, and usually 500 nm or shorter, preferably 480 nm or shorter, more preferably 470 nm or shorter. With the wavelength falling below the above-mentioned lower limit, when using a liquid crystal optical shutter as the optical shutter (20), its liquid crystal material may be destructed by the light emitted from the light source (16) itself. On the other hand, when the upper limit of the above-mentioned range is exceeded, decrease in emission efficiency of the phosphor may induce degradation in brightness of the pixels and induce narrower color reproduction range, which is not preferable.

When the excitation light emitted from the light source (16) is in the wavelength range of visible light, the light emitted from the light source (16) can be used for display just as it is. In such a case, adjusting the quantity of light emitted from the light source (16) using an optical shutter (20) can control the brightness of the pixels for which the light emitted from the light source (16) is utilized. For example when the light source (16) emits blue light with wavelength of from 450 nm to 470 nm, the blue light can be utilized just as it is for a light emitted from the pixels of the display (15). In this case, wavelength conversion using a phosphor is unnecessary, and therefore, the phosphor parts corresponding to the blue pixels can be omitted.

Examples of the light source include an LED, fluorescent lamp, edge-emitting type or surface-emitting type of LD, electroluminescence device, and the like. Of these, an LED or fluorescent lamp is usually used preferably. As fluorescent lamp, a conventionally-used cold-cathode tube or hot-cathode tube can be used. However, since the use of a white light will let the blue, green and red light-emitting areas be mixed with other colors, it is desirable that only the near-ultraviolet region is separated to be used from the white light using a filter or the like. Particularly preferable is a fluorescent lamp coated with only a near-ultraviolet phosphor, in view of decreased power consumption.

Examples of the phosphor used for a fluorescent lamp include $SrMgP_2O_7$:Eu (luminous wavelength: 394 nm), $Sr_3(PO_4)_2$:Eu (luminous wavelength: 408 nm), $(Sr,Ba)Al_2Si_2O_8$:Eu (luminous wavelength: 400 nm), $Y_2Si_2O_7$:Ce (luminous wavelength: 385 nm), $ZnGa_2O_4$:Li,Ti (luminous wavelength: 380 nm), $YTaO_4$:Nb (luminous wavelength: 400 nm), $CaWO_4$ (luminous wavelength: 410 nm), BaFX:Eu (where X is a halogen, luminous wavelength: 380 nm), $(Sr,Ca)O\cdot 2B_2O_3$:Eu (luminous wavelength: 380 nm to 450 nm), $SrAl_{12}O_{14}$:Eu (luminous wavelength: 400 nm), $Y_2SiO_5$:Ce (luminous wavelength: 400 nm)and the like. These phosphors can be used either as a single kind or as a mixture of two or more kinds in any combination and in any ratio.

On the other hand, since a near-ultraviolet inorganic semiconductor LED with high brightness as an LED light source can be used, which is commercially-available recently, a back-lighting using the light source can be used. This near-ultraviolet emitting inorganic semiconductor LED can be used particularly preferably, because it can emit light that has a preferable wavelength region for the present invention selectively. For example, a known blue LED of single or multiple quantum well structure, having InGaN luminous layer, and a known near-ultraviolet LED of single or multiple quantum well structure, having AlInGaN, GaN or AlGaN luminous layer are preferable.

In addition, the light emitted from the light source (16) can enter directly to the phosphor parts (17R), (17G) and (17B), as well as after converted into a planar emission using an optical waveguide or light-diffusion plate. Or otherwise, by disposing a reflection plate, it can enter the phosphor parts (17R), (17G) and (17B) after reflected on the reflection plate. With a reflection plate disposed on the backside (the opposite side to the optical shutter (20)) of the light source (16), the utilization efficiency of the light emitted from the light source (16) can be enhanced, similar to when the frame (18) has high reflectance.

There is no limitation on the conversion mechanism for converting the light emitted from the light source (16) into a planar emission. The examples include any one of, or preferably any combination of an optical waveguide such as quartz plate, glass plate or acrylic plate, a reflection mechanism such as Al sheet or various metal-evaporated films, and a light-diffusion mechanism such as a pattern using $TiO_2$ compounds, light-diffusion sheet or light-diffusion prism. Among them, a conversion mechanism that converts the light into a planar light by constituting the light source (16) as a surface-emitting luminous body using an optical waveguide, reflection plate, diffusion plate or the like can be used preferably in the present embodiment. As another example, a conversion mechanism currently used for a liquid crystal display or the like can also be used preferably.

There is no limitation on the means of disposing the light source (16) on the frame (18), and therefore, any known one can be used. Accordingly, the light source (16) can be disposed on the frame (18) by soldering, for example, as described earlier.

In the present embodiment, a surface-emitting luminous body, which emits planar light, is used as the light source (16). In addition, it is assumed that the electric power is supplied to the light source (16) via an interconnection circuit, a wire or the like by means of connecting the terminal on the frame (18) and the electrode of the light source (16) electrically.

[Polarizer]

It is preferable that a polarizer (19) is disposed forward (right side in the figure) of the light source (16), more specifically, between the light source (16) and the optical shutter (20). The polarizer (19) is provided for the purpose of selecting the light in the predetermined direction, from the lights emitted from the light source (16). Also in the present embodiment, the polarizer (19) is assumed to be located between the light source (16) and the optical shutter (20).

[Optical shutter]

The optical shutter (20) of the present embodiment adjusts the light quantity of the light radiated thereon and lets it pass through. More specifically, it adjusts the light quantities of lights, radiated on its backside, separately for each pixel, in accordance with the image to be displayed, and lets them pass through forward. In the case of the present embodiment, the optical shutter (20) adjusts the light quantities of the lights emitted from the light source (16) toward the phosphor parts (17R), (17G) and (17B), separately for each pixel, and lets them pass through forward. Even when the light emitted from the light source (16) is used just as it is as the light from the pixel, it is constituted that the optical shutter (20) adjusts the light quantity of the light emitted from the light source (16) and lets them pass through forward.

More specifically, when the display (15) is constructed as a multicolor or full-color display, two or more kinds of the above-mentioned phosphors are disposed, independently from each other, at the area specified for the light-wavelength conversion mechanism (namely, the phosphor parts (17R), (17G) and (17B)). In the present embodiment, the light quantities of the lights emitted from the phosphor parts (17R), (17G) and (17B) can be adjusted by controlling the respective light quantities of the excitation lights radiated onto the phosphor parts (17R), (17G), and (17B) using the optical shutter (20), and thus a desired image can be displayed with multicolored emission.

Some kind of optical shutters (20) can adjust the light quantity only of the light having a predetermined wavelength region. Accordingly, as the optical shutter (20), the one that can adjust the light quantity should be used with respect to the wavelength region of the light emitted from the light source (16) for switching lights. Meanwhile, the optical shutter (20) may adjust the light quantity of the light emitted from the phosphor parts (17R), (17G), and (17B), not from the light source (16), depending on the configuration of the display (15). In such a case, the one that can adjust the light quantity of the light having a wavelength region of the light emitted from the phosphor parts (17R), (17G), and (17B) for switching lights, should be used. since the center wavelength of the light emitted from the light source (16) or from the phosphor parts (17R), (17G), and (17B) is usually 350 nm or longer and 780 nm or shorter, and preferably 420 nm or shorter, it is desirable to use an optical shutter (20) that can adjust the light quantity of the light in such wavelength region.

The mechanism of the optical shutter (20) usually comprises a collective of plural pixels. However, the number, size and arrangement patterns of the pixels vary, depending on the display size, display format, use of the display or the like, and thus they are not limited to specific constant values. Accordingly, there is no limitation on the size of the pixels of the optical shutter (20), insofar as the advantage of the present invention is not significantly impaired.

For example, when used for a common display, the size of one pixel is preferably 500 $\mu$m square or smaller. Further, concerning a favorable pixel size, it is more preferable that the number of the pixels is around 640x3x480 and the size of one pixel of a monochromatic color is around 100 $\mu$m x 300 $\mu$m, following the values of a liquid crystal display in practical use at present.

In addition, there is no limitation on the number or size of the optical shutter (20) itself either, insofar as the advantage of the present invention is not significantly impaired. For example, it is useful the optical shutter (20) has the thickness of usually 5 cm or smaller. It is preferable that the thickness is 1 cm or smaller for the sake of a thinner and lighter system of the display.

When the display (15) is formed to be a flat type, an optical shutter (20) that can control the light transmittance of the pixels by electrical control to any value can be preferably used, to enable the display of halftones. The higher the absolute value of the light transmittance, the contrast of its change and the velocity response are, the more preferable.

Examples of the optical shutter (20) satisfying such requirements include a transmission type liquid crystal optical shutter such as TFT (Thin Film Transistor) type, STN (Super Twisted Nematic liquid crystal) type, ferroelectric type, antiferroelectric type, guest-host type using dichroism pigment and PDN (Polymer Dispersed Network) type in which polymer is dispersed; and electrochromic or chemicalchromic materials typified by tungsten oxide, iridium oxide, prussian blue, viologen derivatives, TTF-polystyrene, rare-earth diphthalocyanine complex, polythiophene and polyaniline. Among them, a liquid crystal optical shutter is preferably used because of its thin, light and low-power consumption characteristics and possibility of high-density segments due to its practical durability. Particularly preferable is a liquid crystal optical shutter of TFT active matrix type or PDN type. This is because the active matrix type utiliaing a twisted nematic liquid crystal can realize high-speed response that can keep up with a moving image and no cross talk, and the PDN type, which requires no polarizer (21), makes possible less attenuation of the light from a light source (16) or phosphor parts (17R), (17G) and (17B) and thus enables the high-brightness of the light emission.

Further, a control part (not shown in the figure) is usually provided in the display (15) for controlling the optical shutter (20) so that the shutter adjusts the light quantity of each pixel separately in accordance with the image to be displayed on the display (15). The optical shutter (20) functions to adjust the light quantity of the visible light emitted from each pixel in response to the control from the control part, thereby a desired image can be displayed on the display (15).

The adjustment of the brightness of each pixel using an optical shutter (20) can simplify the control circuit of the control part of the display (15). For example when the brightness adjustment of the pixel is carried out by controlling the emission intensity or the like of an LED, used as light source (16), a complicated control circuit for controlling the image to be displayed may be required, since the current-brightness characteristics of the LED will change with time. In contrast to that, when the brightness adjustment of the pixel is carried out by means of adjusting the light quantity of the light emitted from the light source (16) using an optical shutter (20), like in the present embodiment, the control circuit for the brightness adjustment can be simplified, this is because optical shutters such as liquid crystal optical shutter are mostly voltage-controlled.

In the present embodiment, a liquid crystal optical shutter, in which a back electrode (20-1), a liquid crystal layer (20-2) and a front electrode (20-3) are laminated in this order, is used as the optical shutter (20), and the optical shutter (20) is located forward (right side in the figure) of the polarizer (19). The back electrode (20-1) and front electrode (20-3) are assumed to be formed of transparent electrodes which do not absorb the light used for the display (15). In this liquid crystal optical shutter, the voltage applied to the back electrode (20-1) and front electrode (20-3) controls the molecular arrangement of the liquid crystal in the liquid crystal layer (20-2), and this molecular arrangement adjusts the light quantity of each light that is incident to the backside, for each pixel (namely, for each phosphor part (17R), (17G), and (17B)) respectively.

[Analyzer]

Usually, an analyzer (21) to receive light, of which light quantity is adjusted by the optical shutter (20) when the light passed through it, is disposed forward of the optical shutter (20). The analyzer (21) is used for selecting lights having only specified polarization planes from the lights that passed through the optical shutter (20).

Also in the present embodiment, it is assumed that an analyzer (21) is disposed forward of the optical shutter (20), more specifically, between the optical shutter (20) and the phosphor parts (17R), (17G), and (17B).

[Phosphor part]

Phosphor parts (17R), (17G), and (17B) are the parts containing phosphors which absorb the excitation light emitted from the light source (16) and then emit visible lights for forming an image to be displayed on the display (15). Usually, each one of phosphor parts (17R), (17G), and (17B) is disposed for each pixel, and they emit lights which are regarded as lights emitted from the pixels of the display (15). Consequently, in the present embodiment, the observer recognizes the image by seeing fluorescences emitted from these phosphor parts (17R), (17G), and (17B).

Any kind of phosphors can be used for the above-mentioned phosphor parts, insofar as the phosphor of the present invention is included as, at least, green phosphor and the advantage of the present invention is not significantly impaired. Concrete examples of these phosphors include those exemplified for the aforementioned first phosphor and second phosphor.

Furthermore, the phosphors can be prepared as a single kind of or by blending two or more kinds of phosphors. There is no limitation on the luminescent color of the phosphors, because the appropriate color varies depending on the use. For example when a full-color display is produced, blue, green and red luminous bodies (sic) with high color purities are preferably used. There are several methods for expressing the appropriate colors. As an easy method, the center wavelength, CIE color coordinates or the like of the emitted light can be used. Further, when the light-wavelength conversion mechanism is for a monochrome display or multicolor display, it is preferable to contain phosphors showing colors of purple, blue purple, yellow green, yellow and orange. In addition, two or more of these phosphors can be mixed to obtain a light emission with high color purity or light emission of an intermediate-color or white.

Further, a binder is usually used to the phosphor parts (17R), (17G), and (17B) to protect the phosphors from external force, moisture or the like, of external environment.
There is no special limitation on the kind of the binder, insofar as it is a type that is usually used for this purpose. A colorless and transparent material, such as the above-mentioned liquid medium, is used for the binder.

In the phosphor parts (17R), (17G), and (17B), there is no limitation on the content ratio of the binder contained in the phosphor parts (17R), (17G), and (17B), insofar as the advantage of the present invention is not significantly impaired. However, it is usually 5 weight parts or more, preferably 10 weight parts or more, and usually 95 weight parts or less, preferably 90 weight parts or less, with respect to 100 weight parts of the phosphor. When it falls below the lower limit of the range, the phosphor parts (17R), (17G), and (17B) may be fragile. When it exceeds the upper limit thereof, the emission intensity may be low.

In the phosphor parts (17R), (17G), and (17B), an additive other than binder or phosphor can be added. As additive, for example, a diffusing agent can be used for even wider viewing angle. Concrete examples of the diffusing agent include barium titanate, titanium oxide, aluminium oxide and silicon oxide or the like. As another additive, for example, an organic or inorganic coloring dye or coloring pigment can be used, for the purpose of cutting off the wavelengths not desired. These additives can be used either as a single kind or as a mixture of two or more kinds in any combination and in any ratio.

Further, the phosphor parts (17R), (17G), and (17B) can be prepared by any known method. For example, the phosphor parts (17R), (17G), and (17B) can be formed on a transparent substrate (17-1) by the screen printing method using a mixture (coating liquid) comprising a binder, phosphors and solvent, in an arrangement of mosaic, array or stripe, with an interval corresponding to the pixels of the optical shutter (20).

Further, a black matrix layer (17-2) can be formed between each of the phosphor parts (17R), (17G), and (17B) for absorbing the light from outside. The black matrix layer (17-2) can be formed through the process of producing a light-absorption film composed of carbon black on a transparent substrate (17-1) such as glass, utilizing the photosensitivity principle of a photosensitive resin. Or otherwise, it can be formed by laminating a mixture comprising a resin, carbon black and a solvent by screen printing.

Further, there is no limitation on the shape of the phosphor parts (17R), (17G), and (17B). For example when the display (15) is constructed to be of multicolor, phosphors having predetermined emission colors are disposed in the light-emitting regions such as phosphor parts (17R), (17G), and (17B), in accordance with the arrangement of pixels of the optical shutter mechanism. Examples of the shape of the phosphor parts (17R), (17G), and (17B) include: a segment-shape and matrix-shape which are necessary for displaying informtaion. As preferable examples of the matrix-shape include: a stripe constitution and delta constitution. Moreover, for monochrome display, in addition to the above-mentioned shape, one coated with a phosphor uniformly can be used.

Further, there is no limitation on the dimension of the phosphor parts (17R), (17G), and (17B). For example, no particular limitation is imposed on its thickness, insofar as the advantage of the present invention is not significantly impaired. Usually, they can be preferably used with the thickness of 1 cm or smaller. Moreover, the thickness is preferably 2 mm or smaller when they are used for a flat-panel display, in which thickness reduction and weight reduction are demanded. Particularly, in consideration of the balance with the output rate of the light beam, the thicknesses of the phosphor parts (17R), (17G), and (17B) are usually 1 $\mu$m or larger, preferably 5 $\mu$m or thicker, more preferably 10 $\mu$m or thicker, and usually 1000 $\mu$m or thinner, preferably 500 $\mu$m or thinner, more preferably 200 $\mu$m or thinner.

Incidentally, as described earlier, when the light source (16) emits a visible light such as a blue light, the visible light, emitted from the light source (16), can be used as the light emitted from the pixels. In that case, a phosphor part that emits fluorescence of the same color as the light corresponding to that visible light is not essential. For example, when a blue-light emitting LED is used as the light source (16), a phosphor part containing a blue phosphor is not necessary. Accordingly, when a visible light emitted from the light source (16) is radiated outside from the display (15) after the adjustment of its light quantity using an optical shutter, it is not always necessary to use phosphors for all of the pixels. However, also in such a case, it is desirable that the visible light emitted from the light source (16) passes through a light-transmitting portion in which an additive is contained in a binder, for the sake of effective radiation of the visible light emitted from the light source (16) to the outside, scattering it or cutting off the light with undesired wavelengths.

When the above-mentioned display is put to use, the light source (16) is made to emit light with a predetermined intensity. The light emitted from the light source (16) enters the optical shutter (20), after the polarization plane thereof is aligned by the polarizer (19).

The optical shutter (20) adjusts the light quantities of the light incident from the backside following the control of the control part (not shown in the figure) in accordance with the image to be displayed, for each of the pixels separately, and then the lights pass through it to the front side. More specifically, it adjusts the orientation of the liquid crystals each of which position corresponding to each position of the pixels by means of a control of the voltage applied to the transparent electrodes (20-1) and (20-3). Thereby, the light incident from the backside passes through to the front side as their intensions are adjusted for each of the pixels separately.

The lights passed through the optical shutter (20) enter the each corresponding phosphor parts (17R), (17G), and (17B) via the analyzer (21).

In the phosphor part (17R), red phosphors, dispersed within the phosphor part (17R), absorb the incident light and emit red fluorescences. In the phosphor part (17G), green phosphors, dispersed within the phosphor part (17G), absorb the incident light and emit green fluorescences. In the phosphor part (17B), blue phosphors, dispersed within the phosphor part (17B), absorb the incident light and emit blue fluorescences.

At this moment, the light quantities of the incident light are adjusted by the optical shutter (20) in accordance with the image to be displayed, for each of the pixels separately. Therefore, the light quantities of the fluorescences (visible lights), emitted from each of the phosphor parts (17R), (17G), and (17B), are also adjusted, for each of the pixels separately, resulting in formation of the desired image.

The red, green and blue fluorescences emitted here are radiated outside (right side in the figure) of the display (15) via the transparent substrate (17-1). The observer recognizes the image by seeing the lights emitted from the surface of this transparent substrate (17-1).

With the above-mentioned configuration, coloring of the binder, contained in the phosphor parts (17R), (17G), and (17B), induced by light degradation can be prevented in the display (15). Consequently this leads to enable the prevention of degradation with time of color or brightness of the image shown on the display (15).

Moreover, with the above-mentioned display, the water content in the phosphor parts (17R), (17G), and (17B) can be decreased, which enables the inhibition of deterioration of the phosphors in the phosphor parts (17R), (17G), and (17B).

Further, in the above-mentioned display (15), decrease in brightness or change in colors of the pixels depending on the viewing angle can be prevented, unlike a display utilizing a liquid crystal optical shutter.

Fig. 5 is an exploded sectional view schematically illustrating the substantial part of the display of another embodiment of the present invention. In Fig. 5, it is assumed that an observer looks at the image shown on the display from the right side in the figure. In Fig. 5, components designated by the same reference numerals as in Fig. 4 are the same as those of Fig. 4.

The display (15') have the same configurations as the display (15), except that the phosphor parts are disposed between the light source (16) and the polarizer (19). In the present display, the same components as for the aforementioned display (15) can be used.

It is preferable that black matrixes (not shown in the figure) are provided between each of the pixels of the optical shutter (20). Black matrix has a function to blacken gaps between the pixels for better visibility of the display. As material for the black matrix, for example, chromium, carbon, or resin in which carbon or other black material is dispersed can be used, but they are by no means restrictive. In the present embodiment, because the observer sees the lights that passed through the optical shutter (20), the black matrix is provided in the optical shutter.

The display (15') of the present embodiment, of which arrangement order of the components is changed as described above, is constructed so that the optical shutter (20) adjusts light quantities of the lights emitted from the phosphor parts (17R), (17G), and (17B) for each of the pixels separately, and then they pass through the shutter toward the front side. Namely, it has such a configuration that the phosphors within the phosphor parts (17R), (17G), and (17B) emit lights, when irradiated with lights emitted from the light source (16) to the phosphor parts (17R), (17G), and (17B), and the light quantities of the lights emitted from the phosphors within the phosphor parts (17R), (17G), and (17B) are adjusted by the optical shutter (20) for each of the pixels separately, and then they pass through the shutter toward the front side. Then the lights, of which light quantities are adjusted by the optical shutter (20), will form a desired image on the display (15') by multicolored emission.

Accordingly, with respect to the optical shutter (20), the one that can adjust the light quantity with respect to the wavelength region of the light emitted from the light source (16) should be used in the display (15), but in the display (15') of the present embodiment, the one that can adjust the light quantity with respect to the wavelength region of the light emitted from the phosphor parts (17R), (17G), and (17B) should be used. More specifically, in the optical shutter (20) of the present embodiment, the voltage applied to the back electrode (20-1) and front electrode (20-3) controls the molecular arrangement of the liquid crystal in the liquid crystal layer (20-2), and the molecular arrangement adjusts the light quantity of each light incident to the backside, for each of the pixels separately.

The light that passed through the optical shutter (20) is radiated on the analyzer (21). At this moment, because the light quantities of the fluorescences emitted from the phosphor parts (17R), (17G), and (17B) are already adjusted by the optical shutter (20) for each of the pixels separately, the fluorescence incident on the analyzer (21) will form the desired image. The observer recognizes the image by seeing the lights emitted from the surface of the analyzer (21).

With the above-mentioned configuration, coloring of the binder, contained in the phosphor parts (17R), (17G), and (17B), induced by light degradation can be prevented in the display (15'). This leads to enable the prevention of degradation with time of color or brightness of the image shown on the display (15').

Moreover, with the above-mentioned display (15'), the water content in the phosphor parts (17R), (17G), and (17B) can be decreased compared to the previous ones, which enables the inhibition of deterioration of the phosphors in the phosphor parts (17R), (17G), and (17B).

Further, in the display (15'), an influence due to the decay characteristic of the phosphors within the phosphor parts (17R), (17G), and (17B) can be eliminated, unlike the conventional display utilizing a liquid crystal optical shutter. A phosphor occasionally emits fluorescence even after stopping the light irradiation thereon, for a predetermined period of time. This period of time, for which fluorescence is emitted after the light irradiation, is called decay characteristic. As decay characteristic differs depending on the kinds of phosphors, there is a tendency, heretofore to enhance a specific color of an image display on a display, which is one of causes of high cost and complicated control. However, by the configuration of the display (15'), the above-mentioned influence of the decay characteristic can be eliminated and enhancement of the specific color of the image can be prevented.

Furthermore, the control circuit of the control part can be simpler, similar to the case of the display (15).

[Others]

The display of the present invention is by no means limited to the above-mentioned embodiment of the display, but any modifications can be added to each component thereof.

For example, though such a case that an image is displayed using three kinds of red, green and blue lights was explained in the above-mentioned embodiment, a light other than the above-mentioned red, green and blue lights can be used for display. Moreover, two kinds of or four or more kinds of lights can be used for display.

In addition, the light emitted from the light source (16) can be used directly as the light from the pixel at a part of the pixels, for example.

Furthermore, a reflection type configuration can be adopted, in which the lights emitted from the light source (16) do not pass through the phosphor parts (17R), (17G), and (17B) but are reflected at the phosphor parts (17R), (17G), and (17B). Specifically, the light source (16) can be located forwarder of the phosphor parts (17R), (17G), and (17B) in the display (15), for example.

Further, control of the intensity of the lights emitted from the light source (16), for each of the pixels separately, to regulate the brightness for each pixel can be carried out by an optical shutter (20), and also by adjusting the currents supplied to each of the light sources (16), which are provided corresponding to each pixel separately.

In addition, the above-mentioned components such as the light source (16), phosphor parts (17R), (17G), and (17B), frame (18), polarizer (19), optical shutter (20) and analyzer (21) can be used in any combination, insofar as they do not depart from the scope of the present invention.

Moreover, still another component can be incorporated in the display of the present invention. For example, a protective film can be adopted, as described in Japanese Patent Laid-Open Publication (Kokai) No. 2005-884506, in [0039] and the following sections.

Further, in addition to the above components, films having various functions, such as antireflection layer, orientation film, phase difference film, brightness improvement film, reflection film, semitransparent reflection film and light diffusion film, can be added or formed by means of lamination.

Films having these optical functions can be formed, for example, by the following methods.

A layer having a function of phase difference film can be formed, for example by a stretching treatment disclosed in Japanese Patent Publications No. 2841377 and No. 3094113 or a treatment disclosed in Japanese Patent Publication No. 3168850.

**EP 1 995 294 A1**

A layer having a function of brightness improvement film can be formed, for example by forming a micropore following methods disclosed in Japanese Patent Laid-Open Publications (Kokai) No. 2002-169025 and No. 2003-29030 or by overlaying two or more of cholesteric liquid crystal layers having different center wavelengths of selective reflection.

A layer having a function of reflection film or semitransparent reflection film can be formed, for example by using a metallic thin film prepared by vapor deposition, sputtering or the like.

A layer having a function of diffusion film can be formed by coating a resin solution containing microparticles onto the above-mentioned protective film.

A layer having a function of phase difference film or optical compensation film can be formed by coating and orienting a liquid crystal compound such as discotic liquid crystal compound or nematic liquid crystal compound.

Example

The present invention will be explained in further detail below by referring to examples. It is to be understood that the present invention is by no means limited by the following examples insofar as they do not depart from the intent of the invention.

In the following Tables, the symbols which are the same as those used in the above-mentioned formula [1] have the same definition as in the formula [1].

In the column of "Composition" of the Tables, the ratio of each element of the phosphors is represented as number of moles of each element to 1 mole of silicon (Si) of the phosphors (namely, molar ratio of each element relative to silicon), unless otherwise noted.

According to the above definition, the ratio of "Eu" in the following Tables, for example, is equal to the product of $\alpha$ and x (namely, $\alpha$x) in the above formula [1].

The amount of flux used is also expressed as the number of moles of the flux to 1 mole of silicon (Si) in the phosphors (namely, molar ratio of flux relative to silicon), unless otherwise noted.

[Examples 1 to 6 and Comparative Examples 1 to 8]

As material of the phosphor, powders of barium carbonate ($BaCO_3$), strontium carbonate ($SrCO_3$), europium oxide ($Eu_2O_3$) and silicon dioxide ($SiO_2$) were used. Each of these phosphor materials was of a purity of 99.9 % or more and their weight-average median diameter $D_{50}$ was in the range of 10 nm or larger and 5 $\mu$m or smaller. These phosphor materials were weighed out so that the molar ratio of each element was as described in Examples of 1 to 6 and Comparative Examples of 1 to 8 of Table 3 below. The powders of these phosphor materials were mixed well in an automatic mortar until they were sufficiently homogeneous, transferred to an alumina crucible and fired at 1000 °C in air under atmospheric pressure for 12 hours. The content of the crucible was taken out, $SrCl_2$ or $NH_4Cl$ was added as flux in a molar ratio as shown in Examples of 1 to 6 and Comparative Examples of 1 to 8 of the Table 3 below, and the mixture was mixed and powdered in a dry-type ball mill. The powdered mixture obtained was again transferred to an alumina crucible. In Examples of 1, 3 and 5, the material was transferred to the crucible at the time of firing, solid carbon (block-shaped) was placed onto it, and the crucible was covered with a lid. In Examples of 2, 4 and 6, and Comparative Examples of 1 to 5 and 8, bead-shaped carbon was placed in the space around the crucible, and in Comparative Examples of 6 and 7, no carbon was used. In a vacuum furnace, the pressure was reduced to 2 Pa using a vacuum pump and then nitrogen gas containing hydrogen (nitrogen : hydrogen = 96 : 4 (volume ratio)) was introduced until atmospheric pressure was restored. This operation was repeated again and firing was done at 1200 °C for 4 hours in atmospheric pressure under a flow of nitrogen gas containing hydrogen (nitrogen : hydrogen = 96 : 4 volume ratio). The fired product obtained was powdered using a ball mill and, just as it is slurry, passed through a sieve to remove coarse particles, washed with water, elutriated to remove fine particles, dried and sieved to disintegrate aggregated particles, to produce the phosphor. Hereinafter, these phosphors are called the phosphors of Examples 1 to 6 and Comparative Examples 1 to 8.

[Table 3]

**Table 3**

| | Composition | | | | | | | Flux | | Firing atmosphere |
|---|---|---|---|---|---|---|---|---|---|---|
| | $M^I$ | | $M^{II}$ | | | | Molar ratio (%) of Eu, relative to bivalent elements[*1] | $NH_4Cl$ | $SrCl_2$ | |
| | Ba | Sr | Eu | $\alpha$ | $M^0/\alpha$ | Ba/Sr | | | | |
| Example 1 | 1.39 | 0.46 | 0.15 | 2 | 0.075 | 3 | 7.5 | - | 0.1 | $H_2+N_2+C$ |

44

(continued)

| | | Composition | | | | | | Flux | | |
|---|---|---|---|---|---|---|---|---|---|---|
| | M$^{I}$ | | M$^{II}$ | | | | | | | Firing atmosphere |
| | Ba | Sr | Eu | $\alpha$ | M$^0$/$\alpha$ | Ba/Sr | Molar ratio (%) of Eu, relative to bivalent elements[*1] | NH$_4$Cl | SrCl$_2$ | |
| Example 2 | 1.28 | 0.64 | 0.075 | 2 | 0.038 | 2 | 3.75 | - | 0.05 | H$_2$+N$_2$+C |
| Example 3 | 1.29 | 0.65 | 0.060 | 2 | 0.030 | 2 | 3.0 | - | 0.05 | H$_2$+N$_2$+C |
| Example 4 | 1.80 | 0.14 | 0.060 | 2 | 0.030 | 13 | 3.01 | - | 0.05 | H$_2$+N$_2$+C |
| Example 5 | 1.31 | 0.66 | 0.025 | 2 | 0.013 | 2 | 1.25 | - | 0.05 | H$_2$+N$_2$+C |
| Example 6 | 1.85 | 0 | 0.15 | 2 | 0.075 | $\infty$ | 7.5 | - | 0.05 | H$_2$+N$_2$+C |
| Comparative Example 1 | 0.99 | 0.99 | 0.020 | 2 | 0.010 | 1 | 1.0 | - | 0.1 | H$_2$+N$_2$+C |
| Comparative Example 2 | 0.62 | 1.23 | 0.15 | 2 | 0.075 | 0.5 | 7.5 | - | 0.05 | H$_2$+N$_2$+C |
| Comparative Example 3 | 0.66 | 1.31 | 0.025 | 2 | 0.013 | 0.5 | 1.25 | - | 0.05 | H$_2$+N$_2$+C |
| Comparative Example 4 | 0.00 | 1.85 | 0.15 | 2 | 0.075 | 0 | 7.5 | - | 0.05 | H$_2$+N$_2$+C |
| Comparative Example 5 | 0.93 | 0.47 | 0.60 | 2 | 0.30 | 2 | 30.0 | 0.03 | - | H$_2$+N$_2$+C |
| Comparative Example 6 | 1.23 | 0.62 | 0.15 | 2 | 0.075 | 2 | 7.5 | 0.03 | - | H$_2$+N$_2$ |
| Comparative Example 7 | 0.93 | 0.47 | 0.60 | 2 | 0.30 | 2 | 30.0 | 0.03 | - | H$_2$+N$_2$ |
| Comparative Example 8 | 0.93 | 0.93 | 0.15 | 2 | 0.075 | 1 | 7.5 | 0.03 | - | H$_2$+N$_2$+C |

*1: the ratio of number of moles of Eu relative to the total number of moles of bivalent elements (alkaline-earth metal elements and Eu) in the phosphor

The ratios of Eu$^{2+}$ relative to the total Eu, of the phosphors of Examples 1 to 6 and Comparative Examples 1 to 8, was measured by the following procedure.

X-ray absorption near-edge fine structure (hereinafter abbreviated as "XANES") spectrum of Eu-L3 absorption edges was measured using an Si(111) two-crystal spectroscope and a mirror for removing higher-order light in XAFS measurement apparatus placed in the first hatch of Beamline BL19B2 of synchrotron radiation facility (SPring-8) in Japan Synchrotron Radiation Research Institute. Energy calibration of the X-ray was made with the angle of the spectroscope, in a preedge peak that can be seen at 8980.3 eV in the metal copper-foil XANES spectrum of Cu-K absorption edge, specified at 12.7185 degree. Additionally, minute deviation of the spectroscope over time was corrected by performing XANES measurement of Eu-L3 absorption edge of europium oxide before and after the sample measurement. The XANES spectrum measurement was carried out by means of transmission method in the vicinity of Eu-L3 absorption edge (around 6970 eV) at intervals of about 0.4 eV (in terms of spectroscope angle, 0.00094 degree) with 2 sec of accumulation time at each measurement point. Namely, ion chambers filled with nitrogen gas having electrode lengths of 17 cm and 31 cm were used for detectors of X-rays incident and after passed through the sample, respectively. X-ray absorption coefficient was defined as $\mu t = \ln(I_0/I)$ (here, $I_0$ indicates intensity of X-ray incident and I indicates intensity of X-ray after being passed through the sample) in accordance with Lambert-Beer law. Phosphor powder of each Example and Comparative Example, which was sieved after firing, was mixed with boron nitride of about 70 mg using an agate mortar to be homogenous, and the mixture was formed as tablet in 10 mm diameter under the pressure of 150 kg-weight/cm$^2$, and then, the tablet was used as the sample for measurement.

The first order differentiation of the XANES spectra, obtained as above, of the Eu-L3 absorption edges was performed for removing influences of background, resulting in appearances of spectral patterns originating from $Eu^{2+}$ and $Eu^{3+}$, at around 6965 eV to 6976 eV and 6976 eV to 6990 eV, respectively. Each difference between the maximum value and the minimum value of the derivative spectrum in the respective energy range was defined as peak intensities p and q of $Eu^{2+}$ and $Eu^{3+}$, respectively, and the ratio of $Eu^{2+}$ in the entire Eu was defined as r=p/(p+q).

The ratios of $Eu^{2+}$ relative to the total Eu ($Eu^{2+}$/Eu), of the phosphors of Examples 1 to 6 and Comparative Examples 1 to 8, measured by the above procedure, are shown in Table 4 below.

In addition, the emission spectra of the phosphors of Examples 1 to 6 and Comparative Examples 1 to 8 were measured.

The emission spectrum was measured by using a fluorescence measurement apparatus (manufactured by JASCO corporation) equipped with an excitation light source of 150W xenon lamp and a spectrum measurement apparatus of multichannel CCD detector, C7041 (manufactured by Hamamatsu Photonics K.K.). The light from an excitation light source was passed through a grating monochromator with focal length of 10 cm, and only the light having wavelength of 400 nm was radiated onto the phosphors via an optical fiber. The light emitted from the phosphors by the irradiation of the excitation light was separated by a grating monochromator with focal length of 25 cm, and the emission intensity of each wavelength was measured at the wavelength range of from 300 nm to 800 nm using the spectrum measurement apparatus. Through signal processing such as sensitivity correction with a personal computer, the emission spectrum was obtained. The slit width of the receiving spectroscope was specified at 1 nm during the measurement.

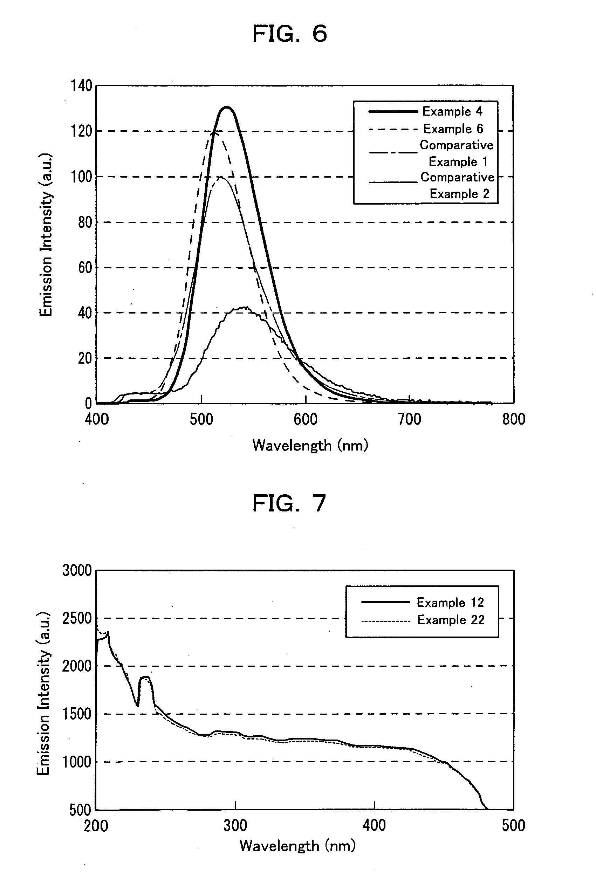

From the emission spectra obtained, the respective wavelengths of emission peak, relative emission-peak intensities and full width at half maximum of the emission peaks were determined. The relative emission-peak intensity was expressed as a relative value, with the emission peak intensity of $BaMgAl_{10}O_{17}$:Eu (manufactured by Kasei Optonics, Ltd., Product Number: LP-B4) at the time of excitation with light of 365 nm taken as 100. The wavelengths of emission peak, relative emission-peak intensities and full width at half maximum of the emission peaks obtained are shown in Table 4 below. Emission spectra of the phosphors of Examples 4 and 6, Comparative Examples 1 and 2 are shown in Fig. 6, as representative emission spectra.

[Table 4]

**Table 4**

| | $EU^{2+}$/Eu | Emission-peak wavelength (nm) | Relative emission-peak intensity | Full width at half maximum of the emission peak (nm) |
|---|---|---|---|---|
| Example 1 | 84% | 525 | 98.5 | 65 |
| Example 2 | 83% | 518 | 75.1 | 64 |
| Example 3 | 88% | 517 | 87.2 | 64 |
| Example 4 | 88% | 512 | 90.2 | 64 |
| Example 5 | 88% | 514 | 109.2 | 65 |
| Example 6 | 88% | 510 | 93.3 | 62 |
| Comparative Example 1 | - | 519 | 75.5 | 70 |
| Comparative Example 2 | 85% | 541 | 32.0 | 89 |
| Comparative Example 3 | - | 535 | 37.0 | 89 |
| Comparative Example 4 | 77% | 559 | 7.2 | 114 |
| Comparative Example 5 | 17% | 526 | 34.4 | 67 |
| Comparative Example 6 | 35% | 519 | 33.1 | 64 |
| Comparative Example 7 | 6% | 518 | 19.9 | 67 |
| Comparative Example 8 | - | 532 | 26.4 | 70 |

Based on the data of each Example and Comparative Example presented in Table 3 and Table 4 above, the relationship between the value of Ba/Sr of the phosphors and wavelength of emission peak, relative emission-peak intensity and full width at half maximum of the emission peak of the phosphors is presented in Table 5 below. In more concrete terms, for Examples and Comparative Examples having the same Eu concentration, the change in wavelength of emission peak, relative emission-peak intensity and full width at half maximum of the emission peak are demonstrated, as the value of Ba/Sr was changed. From the data of Table 5, it is evident that, as the ratio of Ba decreases, wavelength of emission peak is shifted to the longer wavelength region and full width at half maximum of the emission peak increases as well.

[Table 5]

**Table 5**

|  | Example 6 | Example 1 | Comparative Example 6 | Comparative Example 8 | Comparative Example 2 | Comparative Example 4 |
|---|---|---|---|---|---|---|
| Ba/Sr | 2/0 | 3/1 | 2/1 | 1/1 | 1/2 | 0/2 |
| Emission-peak wavelength (nm) | 510 | 525 | 527 | 532 | 541 | 559 |
| Relative emission-peak intensity | 84.9 | 98.8 | 32.4 | 20.4 | 9.1 | 2.6 |
| Full width at half maximum of the emission peak (nm) | 62 | 65 | 64 | 70 | 89 | 114 |

Further, for the phosphors of Examples 1 to 6 and Comparative Examples 1 to 8, the non-luminous object colors based on $L^*$, $a^*$ and $b^*$ color space (sic) were measured using a colorimeter (CR-300, manufactured by MINOLTA), with $D_{65}$ as the standard illuminant. The results are shown in Table 6 below.

[Table 6]

**Table 6**

|  | Non-luminous object color | | | |
|---|---|---|---|---|
|  | $L^*$ | $a^*$ | $L^*$ | $a^*/b^*$ |
| Example 1 | 106.7 | -38.7 | 66.1 | -0.59 |
| Example 2 | 100.1 | -26.0 | 44.8 | -0.58 |
| Example 3 | 100.2 | -24.5 | 43.5 | -0.56 |
| Example 4 | 102.3 | -26.3 | 39.4 | -0.67 |
| Example 5 | 100.9 | -24.1 | 33.2 | -0.73 |
| Example 6 | 97.7 | -33.4 | 57.4 | -0.58 |
| Comparative Example 1 | 101.9 | -25.0 | 57.7 | -0.43 |
| Comparative Example 2 | 97.2 | -18.2 | 59.0 | -0.31 |
| Comparative Example 3 | 96.9 | -16.5 | 52.1 | -0.32 |
| Comparative Example 4 | 96.4 | -12.1 | 47.0 | -0.26 |
| Comparative Example 5 | 92.8 | -12.1 | 43.7 | -0.28 |
| Comparative Example 6 | 98.5 | -9.3 | 37.3 | -0.25 |
| Comparative Example 7 | 97.2 | -9.3 | 33.3 | -0.28 |

(continued)

| | Non-luminous object color | | | |
|---|---|---|---|---|
| | $L^*$ | $a^*$ | $L^*$ | $a^*/b^*$ |
| Comparative Example 8 | 98.3 | -20.2 | 59.2 | -0.34 |

In Comparative Examples 2 and 4, the amounts of Sr in the total amount of $M^I$ are large in comparison with the phosphors of the Examples and it is considered that, because of this, the wavelength of emission peak shifted to the longer wavelength region, the full width at half maximum was broad and the emission-peak intensity decreased. Further, in Comparative Examples 5 and 7, the amount of Eu was too large and thus concentration quenching was considered to have occurred, leading to lowering of the emission-peak intensity.

Further, for the phosphors of Examples 1 to 6 and Comparative Examples 1 to 8, the absorption efficiency $\alpha_q$, internal quantum efficiency $\eta_i$ and external quantum efficiency $\eta_o$ were determined by the following procedure.

First, the phosphor sample to be measured is stuffed up in a cell with its surface smoothed sufficiently enough to keep high measurement accuracy, and then it was set on the bottom hole of an integrating sphere.

Light, from a light emission source (150W Xe lamp) for exciting the phosphor, using an optical fiber, was introduced into the integrating sphere. The light from the aforementioned light emission source was adjusted to be a monochromatic light having emission-peak wavelength of 455 nm, using a monochromator (grating monochromator) or the like.

Then the spectra of the emitted light (fluorescence) and the reflected light of the phosphor sample are measured, by introducing a phosphor, obtained by irradiating phosphor sample to be measured with this monochromatic light as an excitation light from the top hole of the integrating sphere and taken out from the side hole via an optical fiber , into a spectrometer (MCPD7000, manufactured by Otsuka Electronics Co., Ltd.).

Absorption efficiency $\alpha_q$ takes the value calculated by dividing $N_{abs}$ by N, wherein $N_{abs}$ is the number of photons of the excitation light that is absorbed in the phosphor sample and N is the number of all the photons in the excitation light.

First, the latter one, the total number N of all the photons in the excitation light is proportional to the value obtained by the (formula I) below. Therefore, the reflection spectrum $I_{ref}(\lambda)$ was measured using the spectrometer for a reflection plate "Spectralon", manufactured by Labsphere (with 98 % of reflectance R to an excitation light of 450 nm), having reflectance R of approximately 100 % to the excitation light, which was attached to the above integrating sphere in the same disposition as the phosphor sample, irradiated with the excitation light.

[Mathematical Formula 4]

$$\frac{1}{R} \int \lambda \cdot I_{ref}(\lambda) d\lambda \qquad \text{(formula I)}$$

The integration in the above (formula I) was performed at integration interval of 410 nm to 480 nm.

On the other hand, $N_{abs}$, the number of photons of the excitation light that is absorbed in the phosphor sample, is proportional to the amount calculated by the following (formula II).

[Mathematical Formula 5]

$$\frac{1}{R} \int \lambda \cdot I_{ref}(\lambda) d\lambda - \int \lambda \cdot I(\lambda) d\lambda \qquad \text{(formula II)}$$

Therefore, the reflection spectrum $I(\lambda)$, at a time when the phosphor sample of which absorption efficiency $\alpha_q$ is intended to be determined was attached, was determined. The integration interval in (formula II) was set to be the same as in (formula I). Because the actual measurement value of the spectrum is generally obtained as digital data which are divided by a certain finite band width which is related to $\lambda$, the integrations of (formula I) and (formula II) were calculated as finite sum, based on the band width.

From the above results, the absorption efficiency $\alpha_q = N_{abs}/N = $ (formula II) / (formula I) was calculated.

Next, the internal quantum efficiency $\eta_i$ was determined according to the following procedure.

The internal quantum efficiency $\eta_i$ takes the value calculated by dividing $N_{PL}$ by $N_{abs}$, wherein $N_{PL}$ is the number of photons originating from the fluorescence phenomenon and $N_{abs}$ is the number of photons absorbed in the phosphor sample. Here, $N_{PL}$ is proportional to the amount calculated by the following (formula III).

Therefore, the amount calculated by the following (formula III) was determined.

[Mathematical Formula 6]

$$\int \lambda \cdot I(\lambda) d\lambda \qquad \text{(formula III)}$$

The integration in the above (formula III) was performed at integration interval of 481 nm to 800 nm.

From the above results, the internal quantum efficiency $\eta_i = $ (formula III) / (formula II) was calculated.

Incidentally, the integration from spectra expressed by digital data was performed in the same way as when absorption efficiency $\alpha_q$ was determined.

The external quantum efficiency $\eta_o$ was determined as the product of the absorption efficiency $\alpha_q$ and internal quantum efficiency $\eta_i$, which were obtained by the above-mentioned procedure.

The absorption efficiency $\alpha_q$, internal quantum efficiency $\eta_i$, and external quantum efficiency $\eta_o$ of the phosphors of Examples 1 to 6 and Comparative Examples 1 to 8, calculated by the above procedure, are presented in Table 7 below.

[Table 7]

**Table 7**

| | | Composition | | | | Emission efficiency | | |
|---|---|---|---|---|---|---|---|---|
| | | Eu | Ba | Ca | Sr | Absorption efficiency $\alpha_a$ | Internal quantum efficiency $\eta_i$ | External quantum efficiency $\eta_o$ |
| | Example 1 | 0.15 | 1.39 | 0 | 0.46 | 0.82 | 0.78 | 0.64 |
| | Example 2 | 0.075 | 1.28 | 0 | 0.64 | 0.64 | 0.82 | 0.53 |
| | Example 3 | 0.06 | 1.29 | 0 | 0.65 | 0.63 | 0.81 | 0.51 |
| | Example 4 | 0.06 | 1.80 | 0 | 0.14 | 0.60 | 0.80 | 0.48 |
| | Example 5 | 0.025 | 1.31 | 0 | 0.66 | 0.55 | 0.83 | 0.46 |
| | Example 6 | 0.15 | 1.85 | 0 | 0.00 | 0.82 | 0.77 | 0.63 |
| | Comparative Example 1 | 0.02 | 0.99 | 0 | 0.99 | 0.55 | 0.68 | 0.37 |
| | Comparative Example 2 | 0.15 | 0.62 | 0 | 1.23 | 0.58 | 0.50 | 0.29 |
| | Comparative Example 3 | 0.025 | 0.66 | 0 | 1.31 | - | - | - |
| | Comparative Example 4 | 0.15 | 0.00 | 0 | 1.85 | 0.61 | 0.48 | 0.29 |
| | Comparative Example 5 | 0.6 | 0.93 | 0 | 0.47 | - | - | - |
| | Comparative Example 6 | 0.15 | 1.23 | 0 | 0.62 | 0.40 | 0.58 | 0.23 |
| | Comparative Example 7 | 0.6 | 0.93 | 0 | 0.47 | 0.38 | 0.40 | 0.15 |

(continued)

| | Composition | | | | Emission efficiency | | |
|---|---|---|---|---|---|---|---|
| | Eu | Ba | Ca | Sr | Absorption efficiency $\alpha_a$ | Internal quantum efficiency $\eta_i$ | External quantum efficiency $\eta_o$ |
| Comparative Example 8 | 0.15 | 0.93 | 0 | 0.93 | - | - | - |

From the data in Table 7, it is evident that the phosphors of Examples 1 to 6 have high external quantum efficiencies $\eta_o$ and are excellent in emission efficiency in comparison with the phosphors of Comparative Examples 1 to 8. Further, from the data in Table 3, 4, 6 and 7, it is clear that the phosphors of Example 1 to 6 all fall under the category of the specific-property phosphor and specific-composition phosphor as well, of the present invention.

[Example 7]

A light emitting device, of which constitution was the same as what is shown in the above-mentioned Fig. 2(b), was prepared, and its color reproduction range was evaluated by means of NTSC ratio. The preparation of the light emitting device was carried out by the following procedure.
Among components of the light emitting devices prepared in the Examples and Comparative Examples below, those having corresponding components in Fig. 2(b) will have their reference numerals in parentheses as appropriate.
As the first luminous body (22), a blue light-emitting diode (hereinafter abbreviated to as "blue LED" as appropriate) having emission wavelength of 450 nm to 470 nm, ES-CEBL912, manufactured by EPISTAR Corporation, was used. The blue LED (22) was bonded by means of die bonding using silver paste as adhesive to the terminal disposed at the bottom of the recess in frame (24). The adhesive of silver paste was applied thinly and uniformly, in consideration of efficient dissipation of heat generated at the blue LED (22). After curing the silver paste by heating at 150 °C for 2 hours, the blue LED (22) and the electrode (26) of the frame (24) were bonded through wire bonding. For wire (25), a gold wire with diameter of 25 $\mu$m was used.
For luminescent material of the phosphor-containing resinous part (23), a green phosphor of the above-mentioned Example 1 (hereinafter referred to as "phosphor (A)" as appropriate) and a phosphor of $Sr_{0.8}Ca_{0.192}Eu_{0.008}AlSiN_3$ (hereinafter referred to as "phosphor (B)" as appropriate) emitting light having wavelength of approximately 520 nm to 760 nm were used. The weight ratio of the phosphor (A) and the phosphor (B) was made to be 90:10. A mixture of two-pack epoxy resin and aerosil were added to the phosphors in the weight ratio of 15:100, relative to the total weight of these phosphors (A) and (B). Further, by adding a curing agent in the ratio of 100:70 relative to the total weight of the resin-containing mixture, which includes the phosphors, and mixing them with a kneading machine, a phosphor slurry (phosphor-containing composition) was prepared. The obtained phosphor slurry was poured into the recess of the above-mentioned frame (24), and heated at 100 °C for 3 hours and then at 140 °C for another 3 hours so as to be cured, resulting in forming a phosphor-containing resinous part (23).
The obtained light emitting device was driven to emit light by energizing the blue LED (22) with a current of 20 mA. As its white color coordinate was measured, it was x/y = 0.31/0.33. Further, NTSC ratio was measured in the same manner as described above in the section of [3. Light emitting device], as an index of color reproduction range. The NTSC ratio obtained is presented in Table 8 described later.

[Example 8]

A light emitting device was prepared by the same method as described for Example 7, except that a phosphor of $Ca_{0.998}E_{0.08}AlSiN_3$ (hereinafter referred to as "phosphor (C)" as appropriate), emitting light having wavelength of approximately 560 nm to 750 nm, was used in place of phosphor (B) of Example 7 and the weight ratio of the phosphor (A) and the phosphor (C) was 88:12.
As the white color coordinate was measured, of the light emitting device obtained, when emitting light under the same conditions as in Example 7, it was x/y = 0.31/0.33. Further, NTSC ratio was measured in the same manner as described above in the section of [3. Light emitting device], as an index of color reproduction range. The NTSC ratio obtained is presented in Table 8 described later.

[Comparative Example 9]

A light emitting device was prepared by the same method as described for Example 7, except that, as the blue LED (22) in Example 7, 460MB290, manufactured by Cree, Inc., was used and, as the luminescent material in the phosphor-containing resinous part (23), a phosphor of $Y_3Al_5O_{12}$:Ce (P46-Y3, manufactured by Kasei Optonics, Ltd.), emitting light having wavelength of approximately. 480 nm to 720 nm, was used.

As the white color coordinate was measured, of the light emitting device obtained, when emitting light under the same conditions as in Example 7,it was x/y = 0.31/0.33. Further, NTSC ratio was measured in the same manner as described above in the section of [2-4. Embodiment of Light emitting device] (sic), as an index of color reproduction range. The NTSC ratio obtained is presented in Table 8.

[Table 8]

**Table 8**

|  | Phosphor | NTSC ratio (%) |
|---|---|---|
| Example 7 | phosphor (A) + phosphor (B) | 85 |
| Example 8 | phosphor (A) + phosphor (C) | 78 |
| Comparative Example 9 | $Y_3Al_5O_{12}$:Ce | 66 |

[Examples 9 to 33 and Comparative Example 10]

As material of the phosphor, each powder of barium carbonate ($BaCO_3$), strontium carbonate ($SrCO_3$), europium oxide ($Eu_2O_3$) and silicon dioxide ($SiO_2$) were used. Each of these phosphor materials was of a purity of 99.9 % or more and their weight-average median diameter $D_{50}$ was in the range of 10 nm or larger and 5 $\mu$m or smaller. These phosphor materials were weighed out so that the composition of each phosphor obtained was as described in Examples of 9 to 33 and Comparative Example of 10 of Table 9 below. In all of Examples 9 to 33 and Comparative Example 10, the ratio of Eu in the total amount of bivalent elements contained in the phosphor is 7.5 mole percent. The powders of these phosphor materials were mixed in an automatic mortar until they were sufficiently homogeneous, transferred to an alumina crucible and fired at 1000 °C in a nitrogen atmosphere under atmospheric pressure for 12 hours. The content of the crucible was taken out, the compound shown in Table 8 below was added as flux, and the mixture was mixed and powdered in a dry-type ball mill. The powdered mixture obtained was again transferred to an alumina crucible. Then solid carbon (block-shaped) was placed onto it, and the crucible was covered with a lid. In a vacuum furnace, the pressure was reduced to 2 Pa using a vacuum pump and then nitrogen gas containing hydrogen (nitrogen : hydrogen = 96 : 4 (volume ratio)) was introduced until atmospheric pressure was restored. This operation was repeated again and firing was done at 1200 °C for 4 hours in atmospheric pressure under a flow of nitrogen gas containing hydrogen (nitrogen : hydrogen = 96 : 4 (volume ratio)). The fired product obtained was powdered using a ball mill and, as just as it is slurry, passed through a sieve to remove coarse particles, washed with water, elutriated to remove fine particles, dried and sieved again to disintegrate aggregated particles, to produce the phosphor. Hereinafter, these phosphors are called the phosphors of Examples 9 to 33 and Comparative Example 10.

[Table 9]

**Table 9**

|  |  | Composition | Flux | | | |
|---|---|---|---|---|---|---|
|  |  |  | Compound containing bivalent element | | Compound containing monovalent or trivalent element | |
|  |  |  | Compound | Amount used (mol) | Compound | Amount used (mol) |
|  | Example 9 | $(Ba_{1.36}Sr_{0.49}Eu_{0.15})SiO_4$ | $SrCl_2$ | 0.015 | - | - |
|  | Example 10 | $(Ba_{1.36}Sr_{0.49}EU_{0.15})SiO_4$ | $SrCl_2$ | 0.03 | - | - |
|  | Example 11 | $(Ba_{1.36}Sr_{0.49}Eu_{0.15})SiO_4$ | $SrCl_2$ | 0.05 | - | - |
|  | Example 12 | $(Ba_{1.36}Sr_{0.49}EU_{0.15})SiO_4$ | $SrCl_2$ | 0.05 | - | - |
|  | Example 13 | $(Ba_{1.36}Sr_{0.49}Eu_{0.15})SiO_4$ | $SrCl_2$ | 0.1 | - | - |

(continued)

| | Composition | Flux | | | |
|---|---|---|---|---|---|
| | | Compound containing bivalent element | | Compound containing monovalent or trivalent element | |
| | | Compound | Amount used (mol) | Compound | Amount used (mol) |
| Example 14 | $(Ba_{1.36}Sr_{0.49}Eu_{0.15})SiO_4$ | $BaCl_2$ | 0.1 | - | - |
| Example 15 | $(Ba_{1.36}Sr_{0.49}Eu_{0.15})SiO_4$ | $SrF_2$ | 0.1 | - | - |
| Example 16 | $(Ba_{1.36}Sr_{0.49}Eu_{0.15})SiO_4$ | - | - | NaCl | 0.1 |
| Example 17 | $(Ba_{1.36}Sr_{0.49}Eu_{0.15})SiO_4$ | $MgF_2$ | 0.1 | - | - |
| Example 18 | $(Ba_{1.36}Sr_{0.49}Eu_{0.15})SiO_4$ | - | - | $NH_4Cl$ | 0.1 |
| Example 19 | $(Ba_{1.36}Sr_{0.49}Eu_{0.15})SiO_4$ | - | - | CsCl | 0.1 |
| Example 20 | $(Ba_{1.36}Sr_{0.49}Eu_{0.15})SiO_4$ | $SrCl_2$ | 0.05 | CsCl | 0.025 |
| Example 21 | $(Ba_{1.36}Sr_{0.49}Eu_{0.15})SiO_4$ | $SrCl_2$ | 0.05 | CsCl | 0.03 |
| Example 22 | $(Ba_{1.36}Sr_{0.49}Eu_{0.15})SiO_4$ | $SrCl_2$ | 0.1 | CsCl | 0.1 |
| Example 23 | $(Ba_{1.36}Sr_{0.49}Eu_{0.15})SiO_4$ | $SrCl_2$ | 0.1 | CsCl | 0.2 |
| Example 24 | $(Ba_{1.36}Sr_{0.49}Eu_{0.15})SiO_4$ | $SrCl_2$ | 0.05 | LiCl | 0.1 |
| Example 25 | $(Ba_{1.36}Sr_{0.49}Eu_{0.15})SiO_4$ | $SrCl_2$ | 0.05 | $YCl_3.6H_2O$ | 0.05 |
| Example 26 | $(Ba_{1.36}Sr_{0.49}Eu_{0.15})SiO_4$ | $SrCl_2$ | 0.05 | $YF_3$ | 0.025 |
| Example 27 | $(Ba_{1.36}Sr_{0.49}Eu_{0.15})SiO_4$ | $SrCl_2$ | 0.1 | CsCl | 0.05 |
| | | | | KCl | 0.05 |
| Example 28 | $(Ba_{1.36}Sr_{0.49}Eu_{0.15})SiO_4$ | $SrCl_2$ | 0.1 | RbCl | 0.05 |
| Example 29 | $(Ba_{1.36}Sr_{0.49}Eu_{0.15})SiO_4$ | $SrCl_2$ | 0.1 | $KPO_4$ | 0.05 |
| Example 30 | $(Ba_{1.36}Sr_{0.4}Eu_{0.15})SiO_4$ | $BaCl_2$ | 0.1 | CsCl | 0.1 |
| Example 31 | $(Ba_{1.36}Sr_{0.49}Eu_{0.15})SiO_4$ | $BaCl_2$ | 0.05 | CsCl | 0.025 |
| | | | | KCl | 0.025 |
| Example 32 | $(Ba_{1.36}Sr_{0.49}Eu_{0.15})SiO_4$ | $ZnCl_2$ | 0.1 | CsCl | 0.05 |

(continued)

| | Composition | Flux | | | |
|---|---|---|---|---|---|
| | | Compound containing bivalent element | | Compound containing monovalent or trivalent element | |
| | | Compound | Amount used (mol) | Compound | Amount used (mol) |
| Example 33 | $(Ba_{1.36}Sr_{0.49}Eu_{0.15})SiO_4$ | $SrCl_2$ | 0.025 | - | - |
| | | $BaCl_2$ | 0.025 | - | - |
| Comparative Example 10 | $(Ba_{1.36}Sr_{0.49}Eu_{0.15})SiO_4$ | - | - | - | - |

The emission spectra of the phosphors of Examples 9 to 33 and Comparative Example 10 were measured by the same method as that described for Examples 1 to 8 and Comparative Examples 1 to 9, except that light having wavelength of 455 nm was used as the excitation light. From the emission spectra obtained, the wavelength of emission peak, full width at half maximum of the emission peak and relative emission-peak intensity were determined. The results are shown in Table 10.

The relative emission-peak intensity was expressed, in the same way as for Examples 1 to 8 and Comparative Examples 1 to 9, as a relative value, with the emission peak intensity of $BaMgAl_{10}O_{17}$:Eu (manufactured by Kasei Optonics, Ltd., Product Number: LP-B4) at the time of excitation with light of 365 nm, was taken as 100.

Further, the relative luminances and color coordinates of the phosphors of Examples 9 to 33 and Comparative Example 10 were calculated by the method shown below. The results are shown in Table 10.

(Relative brightness)

Since stimulus value Y defined in JIS Z8701 is proportional to brightness, the relative amount of stimulus value Y was taken as relative brightness. The brightness of $Y_3Al_5O_{12}$:Ce (P46-Y3, manufactured by Kasei Optonics, Ltd.), excited with light of 455 nm, was taken as 100.

(Color coordinate)

Color coordinates x and y of color system of X, Y and Z, defined in JIS Z8701, was calculated from the data in the wavelength region of 480 nm or longer and 800 nm or shorter of the emission spectrum.

Further, for the phosphors of Examples 9 to 33 and Comparative Example 10, the absorption efficiency $\alpha_q$, internal quantum efficiency $\eta_i$ and external quantum efficiency $\eta_o$ were determined by the same procedure as that for Examples 1 to 6 and Comparative Examples 1 to 8. The results are shown in Table 10.

[Table 10]

Table 10

| | Luminance characteristics | | | | | | Emission efficiency | | |
|---|---|---|---|---|---|---|---|---|---|
| | Emission-peak wavelength (nm) | Relative emission-peak intensity | Full width at half maximum of the emission peak (nm) | Relative brightness | Color coordinate | | Absorption efficiency $\alpha_q$ | Internal quantum efficiency $\eta_i$ | External quantum efficiency $\eta_o$ |
| | | | | | x value | y value | | | |
| Example 9 | 525 | 48.1 | 67 | 85 | 0.273 | 0.639 | 0.66 | 0.69 | 0.46 |
| Example 10 | 528 | 58.1 | 68 | 104 | 0.292 | 0.615 | 0.71 | 0.70 | 0.50 |
| Example 11 | 529 | 79.4 | 68 | 127 | 0.299 | 0.619 | 0.79 | 0.82 | 0.65 |
| Example 12 | 527 | 89.5 | 68 | 138 | 0.280 | 0.636 | - | - | - |
| Example 13 | 530 | 98.4 | 69 | 159 | 0.293 | 0.627 | 0.77 | 0.76 | 0.59 |
| Example 14 | 524 | 93.4 | 68 | 149 | 0.269 | 0.640 | 0.76 | 0.69 | 0.53 |
| Example 15 | 528 | - | 67 | 109 | 0.291 | 0.641 | 0.76 | 0.66 | 0.50 |
| Example 16 | 526 | - | 68 | - | 0.276 | 0.566 | 0.71 | 0.70 | 0.50 |
| Example 17 | 525 | - | 67 | - | 0.278 | 0.605 | 0.69 | 0.66 | 0.45 |
| Example 18 | 525 | - | 68 | - | 0.277 | 0.582 | 0.72 | 0.62 | 0.45 |
| Example 19 | 525 | - | 67 | - | 0.270 | 0.500 | 0.72 | 0.70 | 0.51 |
| Example 20 | 527 | 91.6 | 67 | 161 | 0.279 | 0.636 | 0.78 | 0.68 | 0.53 |
| Example 21 | 527 | 93.2 | 67 | 163 | 0.279 | 0.637 | 0.79 | 0.70 | 0.55 |
| Example 22 | 528 | 89.8 | 67 | 161 | 0.287 | 0.634 | 0.81 | 0.79 | 0.64 |
| Example 23 | 527 | 90.5 | 67 | 162 | 0.287 | 0.635 | 0.78 | 0.75 | 0.59 |
| Example 24 | 525 | 92.7 | 67 | 150 | 0.273 | 0.638 | 0.75 | 0.65 | 0.49 |
| Example 25 | 528 | 86.2 | 68 | 145 | 0.287 | 0.635 | 0.78 | 0.57 | 0.45 |
| Example 26 | 529 | 80.5 | 60 | 139 | 0.297 | 0.629 | 0.72 | 0.64 | 0.46 |
| Example 27 | 528 | 87.0 | 69 | 144 | 0.280 | 0.635 | 0.72 | 0.73 | 0.52 |
| Example 28 | 525 | 72.8 | 68 | 136 | 0.269 | 0.642 | 0.72 | 0.66 | 0.47 |
| Example 29 | 528 | 78.6 | 68 | 130 | 0.276 | 0.632 | 0.71 | 0.72 | 0.51 |
| Example 30 | 524 | 88.0 | 67 | 142 | 0.271 | 0.640 | 0.73 | 0.71 | 0.52 |

(continued)

| | Luminance characteristics | | | | | | Emission efficiency | | |
|---|---|---|---|---|---|---|---|---|---|
| | Emission-peak wavelength (nm) | Relative emission-peak intensity | Full width at half maximum of the emission peak (nm) | Relative brightness | Color coordinate | | Absorption efficiency $\alpha_q$ | Internal quantum efficiency $\eta_i$ | External quantum efficiency $\eta_o$ |
| | | | | | x value | y value | | | |
| Example 31 | 528 | 87.0 | 68 | 144 | 0.280 | 0.635 | 0.78 | 0.66 | 0.51 |
| Example 32 | 525 | 70.8 | 67 | 128 | 0.285 | 0.631 | 0.65 | 0.76 | 0.49 |
| Example 33 | 525 | 88.5 | 68 | 129 | 0.266 | 0.639 | 0.66 | 0.77 | 0.51 |
| Comparative Example 10 | 524 | 34.3 | 69 | 56.5 | 0.256 | 0.618 | 0.51 | 0.76 | 0.38 |

From the results shown in Table 9 and Table 10, it is evident that all the phosphors of Examples 9 to 33 fall under the category of the specific-property phosphor of the present invention.

The weight-average median diameters and non-luminous object colors based on $L^*$, $a^*$ and $b^*$ color space (sic) were measured for the phosphors of Examples 9 to 33 and Comparative Example 10 by the same procedure as that for the above-mentioned Examples 1 to 6 and Comparative Examples 1 to 8. The results are shown in Table 11 below.

[Table 11]

Table 11

| | Weight-average median diameter ($\mu$m) | Non-luminous object color | | | |
|---|---|---|---|---|---|
| | | $L^*$ | $a^*$ | $b^*$ | $a^*/b^*$ |
| Example 9 | 13.6 | 99.5 | -33.4 | 56.1 | -0.60 |
| Example 10 | 16.0 | 102.7 | -36.2 | 62.1 | -0.58 |
| Example 11 | 22.6 | 103.9 | -34.7 | 62.8 | -0.55 |
| Example 12 | 24.6 | 102.0 | -33.8 | 61.9 | -0.55 |
| Example 13 | 28.1 | 104.6 | -38.6 | 69.9 | -0.55 |
| Example 14 | 27.4 | 101.8 | -32.5 | 57.9 | -0.56 |
| Example 15 | 21.0 | 100.0 | -26.5 | 44.7 | -0.59 |
| Example 16 | 19.0 | 100.8 | -24.5 | 33.0 | -0.74 |
| Example 17 | 22.7 | 98.2 | -21.5 | 34.5 | -0.62 |
| Example 18 | 13.0 | 98.0 | -20.4 | 37.4 | -0.54 |
| Example 19 | 15.0 | 99.4 | -27.7 | 30.5 | -0.91 |
| Example 20 | 19.2 | 104.6 | -38.6 | 69.9 | -0.55 |
| Example 21 | 17.4 | 102.6 | -36.4 | 63.3 | -0.57 |
| Example 22 | 18.8 | 103.8 | -31.3 | 50.0 | -0.63 |
| Example 23 | 20.6 | 105.1 | -36.7 | 62.8 | -0.59 |
| Example 24 | 20.6 | 102.6 | -36.4 | 63.3 | -0.57 |
| Example 25 | 21.3 | 97.9 | -31.9 | 69.9 | -0.46 |
| Example 26 | 19.0 | 103.0 | -33.9 | 66.5 | -0.51 |
| Example 27 | 15.6 | 105.1 | -36.6 | 62.6 | -0.58 |
| Example 28 | 20.1 | 101.7 | -29.3 | 52.7 | -0.56 |
| Example 29 | 11.2 | 103.8 | -31.3 | 50.8 | -0.62 |
| Example 30 | 20.8 | 104.6 | -38.6 | 69.9 | -0.55 |
| Example 31 | 15.7 | 99.6 | -26.2 | 43.9 | -0.60 |
| Example 32 | 18.3 | 103.1 | -32.7 | 60.7 | -0.54 |
| Example 33 | 18.0 | 103.1 | -32.7 | 60.7 | -0.54 |
| Comparative Example 10 | 12.4 | 95.6 | -24.6 | 49.8 | -0.49 |

From the results shown in Table 9 and Table 11, it is evident that all the phosphors of Examples 9 to 33 fall under the category of specific-composition phosphor of the present invention.

The excitation spectra of the phosphors of Examples 12 and 22 were measured at room temperatures using a fluorescence spectrophotometer, type F-4500 (manufactured by Hitachi, Ltd.). The result is shown in Fig. 7.

In Examples 9 to 13, $SrCl_2$ alone was used as flux. From the results, it is evident that, as the amount of $SrCl_2$ used is increased, the crystal growth is promoted, the weight-average median diameter is increased, and the relative emission-peak intensity and relative brightness enhance accordingly. Thus, it is evident that $SrCl_2$ has a crystal growth promoting effect.

In Examples 14 to 19, each of various compounds were used alone as flux in the production of phosphors.

In Examples 20 to 23, $SrCl_2$ and CsCl were used as flux in combination, in the production of phosphors. It is clear that, when CsCl was combined with $SrCl_2$ which has a crystal growth promoting effect, crystal growth is inhibited. In this way, when compounds having bivalent element like $SrCl_2$ is combined with compounds having monovalent or trivalent element like CsCl, compounds having monovalent or trivalent element exerts a crystal growth inhibiting effect and it is possible to obtain easy-to-use phosphors with high brightness maintained with small weight-average median diameter.

For the phosphor of Example 20, chemical composition was analyzed by glow discharge mass spectrometry (GDMS), and chlorine (Cl) were detected at a concentration of 10 ppm and cesium (Cs) were detected at a concentration of 10 ppm.

In Examples 24 to 33, two or three kinds of various compounds were used in combination as flux in the production of phosphors. When two or more fluxes are used in combination, a phosphor with high brightness can be realized even if its weight-average median diameter is small.

Further, combination of compounds each having bivalent element is also possible, as shown in Example 33.

For the phosphor of Comparative Example 10, which was produced without using a flux, the weight-average median diameter was small, and the relative emission-peak intensity and relative brightness were also low.

[Examples 34 to 36]

As material of the phosphor, each powder of barium carbonate ($BaCO_3$), strontium carbonate ($SrCO_3$), europium oxide ($Eu_2O_3$) and silicon dioxide ($SiO_2$) were used. Each of these phosphor materials was of a purity of 99.9 % or more and their weight-average median diameter $D_{50}$ was in the range of 10 nm or larger and 5 $\mu$m or smaller. These phosphor materials were weighed out so that the ratios were as described in Examples of 34 to 36 of Table 12 below. The powders of these phosphor materials were well in an automatic mortar until they were sufficiently homogeneous, transferred to an alumina crucible and fired at 1100 °C in a nitrogen atmosphere under atmospheric pressure for 12 hours. The content of the crucible was taken out, $SrCl_2$ was added as flux to give a molar ratio of 0.1 relative to silicon (Si) in the phosphor, and the mixture was mixed and powdered in a dry-type ball mill. The powdered mixture obtained was again transferred to an alumina crucible. Then solid carbon (block-shaped) was placed onto it, and the crucible was covered with a lid. In a vacuum furnace, the pressure was reduced to 2 Pa using a vacuum pump and then nitrogen gas containing hydrogen (nitrogen : hydrogen = 96 : 4 (volume ratio)) was introduced until atmospheric pressure was restored. This operation was repeated again and firing was done at 1200 °C for 6 hours in atmospheric pressure under a flow of nitrogen gas containing hydrogen (nitrogen : hydrogen = 96 : 4 (volume ratio)). The fired product obtained was powdered using a ball mill and, just as it is slurry, passed through a sieve to remove coarse particles, washed with water, elutriated to remove fine particles, dried and sieved again to disintegrate aggregated particles, to produce the phosphor. Hereinafter, these phosphors are called the phosphors of Examples 34 to 36.

[Table 12]

Table 12

| | Composition | | | | |
|---|---|---|---|---|---|
| | M$^{I}$ | | M$^{II}$ | $\alpha$ | Molar ratio (%) of Eu, relative to bivalent elements [*2] |
| | Ba | Sr | Eu | | |
| Example 34 | 1.35 | 0.50 | 0.15 | 2 | 7.5 |
| Example 35 | 1.50 | 0.35 | 0.15 | 2 | 7.5 |
| Example 36 | 1.65 | 0.20 | 0.15 | 2 | 7.5 |
| *2: the ratio of number of moles of Eu, relative to the total number of moles of bivalent elements (alkaline-earth metal elements and Eu) in the phosphor | | | | | |

The emission spectra of the phosphors of Examples 34 to 36 were measured by the same method as that described for Examples 9 to 33 and Comparative Example 10. From the emission spectra obtained, the respective wavelength of emission peak, relative emission-peak intensity, full width at half maximum of the emission peak, relative brightness and color coordinate x and y were determined. The results are shown in Table 13 below.

Further, for the phosphors of Examples 34 to 36, the absorption efficiency $\alpha_q$, internal quantum efficiency $\eta_i$ and external quantum efficiency $\eta_o$ were determined by the same procedure as that for the above-mentioned Examples 1 to 6 and Comparative Examples 1 to 8. The results are shown in Table 13 below.

[Table 13]

Table 13

| | Luminance characteristics | | | | | | Emission efficiency | | |
|---|---|---|---|---|---|---|---|---|---|
| | Emission-peak wavelength (nm) | Relative emission-peak intensity | Full width at half maximum of the emission peak (nm) | Relative brightness | Color coordinate | | Absorption efficiency $\alpha_q$ | Internal quantum efficiency $\eta_i$ | External quantum efficiency $\eta_o$ |
| | | | | | x value | y value | | | |
| Example 34 | 528 | 259 | 67 | 172 | 0.283 | 0.636 | 0.82 | 0.79 | 0.64 |
| Example 35 | 525 | 279 | 62 | 178 | 0.264 | 0.641 | 0.77 | 0.69 | 0.53 |
| Example 36 | 520 | 266 | 58 | 160 | 0.242 | 0.639 | 0.79 | 0.79 | 0.62 |

The non-luminous object colors based on L*, a* and b* color space (sic) were also measured for the phosphors of Examples 34 to 36 by the same procedure as that for the above-mentioned Examples 1 to 6 and Comparative Examples 1 to 8. The results are shown in Table 14 below.

[Table 14]

Table 14

|  | L* | a* | b* | a*/b* |
|---|---|---|---|---|
| Example 34 | 105.4 | -38.84 | +69.84 | -0.56 |
| Example 35 | 104.4 | -38.46 | +64.23 | -0.60 |
| Example 36 | 100.9 | -36.41 | +53.48 | -0.68 |

[Comparative Examples 11 to 14]

$Sr_{0.5}Ba_{1.5}SiO_4$:Eu, described in "FIG. 5" of the above-mentioned Patent Document 1 (Specification of U.S. Patent No. 6982045) was produced following the method of Example 1 above.

Namely, as material of phosphor, each powder of barium carbonate ($BaCO_3$), strontium carbonate ($SrCO_3$), europium oxide ($Eu_2O_3$) and silicon dioxide ($SiO_2$) were used, and were weighed out to give a molar ratio of 1.5 : 0.48 : 0.01 : 1.05, deionized water was added to prepare slurry and the mixture was powdered and mixed using a ball mill. After drying the mixture obtained, $NH_4Cl$ was added as flux to give a molar ratio of 0.01, relative to silicon (Si) in the phosphor, and the mixture was powdered with a ball mill so that the mean particle diameter thereof was around 1 μm to 5 μm, thereby to obtain a mixture of material. The mixture obtained was transferred to a quartz crucible and fired at 1000 °C for 1 hour in air under an atmospheric pressure (primary firing). The fired product was taken out of the crucible, $NH_4Cl$ was added as flux in the same amount as previously, namely when mixing the materials, and the product was mixed and powdered using a dry-type ball mill to give a mean particle diameter of around 1 μm to 5 μm. The product was again transferred to a quartz crucible, a lid was placed thereon, and fired for 3 hours according to the secondary firing conditions of Comparative Examples 11 to 14 shown in Table 15 below, under a reducing atmosphere in an atmospheric pressure (secondary firing). The fired product obtained was powdered using a ball mill and, just as it is slurry, passed through a sieve to remove coarse particles, washed with water and elutriated to remove fine particles. After drying, it was sieved to disintegrate aggregated particles, to produce the phosphor. Hereinafter, these phosphors are called the phosphors of Comparative Examples 11 to 14.

Conditions at the time of secondary firing of each of Comparative Examples are shown in Table 15. The details are as follows:

In Comparative Example 11, firing was done at 1000 °C for 3 hours in an atmosphere of hydrogen-containing nitrogen (nitrogen : hydrogen = 96 : 4 (volume ratio)).

In Comparative Example 12, the aforementioned quartz crucible containing the materials, with a lid on, was placed in a larger crucible, bead-shaped carbon was placed in the space around the aforementioned quartz crucible and a lid was placed on the larger crucible. Firing was done at 1000 °C for 3 hours. Namely, firing was done in an atmosphere close to that of carbon monoxide (CO-like atmosphere).

In Comparative Example 13, firing was done under the same conditions as those of Comparative Example 11, except that the firing temperature was 1200 °C.

In Comparative Example 14, firing was done under the same conditions as those of Comparative Example 12, except that the firing temperature was 1200 °C.

[Table 15]

Table 15

| | Composition | | | | | Conditions of secondary firing | | |
|---|---|---|---|---|---|---|---|---|
| | M$^I$ | | M$^{II}$ | α | Molar ratio (%) of Eu, relative to bivalent elements *3 | Atmosphere | Firing temperature | Firing time |
| | Ba | Sr | Eu | | | | | |
| Comparative Example 11 | 1.50 | 0.48 | 0.02 | 1.9 | 1.0 | hydrogen-containing nitrogen | 1000 °C | 3 hours |

(continued)

| | Composition | | | | | Conditions of secondary firing | | |
| --- | --- | --- | --- | --- | --- | --- | --- | --- |
| | $M^I$ | | $M^{II}$ | $\alpha$ | Molar ratio (%) of Eu, relative to bivalent elements [*3] | Atmosphere | Firing temperature | Firing time |
| | Ba | Sr | Eu | | | | | |
| Comparative Example 12 | 1.50 | 0.48 | 0.02 | 1.9 | 1.0 | CO-like atmosphere [*4] | 1000 °C | 3 hours |
| Comparative Example 13 | 1.50 | 0.48 | 0.02 | 1.9 | 1.0 | hydrogen-containing nitrogen | 1200 °C | 3 hours |
| Comparative Example 14 | 1.50 | 0.48 | 0.02 | 1.9 | 1.0 | CO-like atmosphere [*4] | 1200 °C | 3 hours |

*3: the ratio of number of moles of Eu, relative to the total number of moles of bivalent elements (alkaline-earth metal elements and Eu) in the phosphor
*4: atomosphere obtained by the method in which a quartz crucible containing the materials, with a lid on, was placed in a larger crucible, bead-shaped carbon was placed in the space around the quartz crucible and a lid was placed on the larger crucible

The emission spectra of the phosphors of Comparative Examples 11 to 14 were measured by the same method as that described for Examples 9 to 33 and Comparative Example 10. From the emission spectra obtained, the respective wavelength of emission peak, relative emission-peak intensity, full width at half maximum of the emission peak, relative brightness and color coordinate x and y were determined. The results are shown in Table 16 below.

Further, for the phosphors of Comparative Examples 11 to 14, the respective absorption efficiency $\alpha_q$, internal quantum efficiency $\eta_i$ and external quantum efficiency $\eta_o$ were determined by the same procedure as that for the above-mentioned Examples 1 to 6 and Comparative Examples 1 to 8. The results are shown in Table 16 below.

[Table 16]

Table 16

| | Luminance characteristics | | | | | | Emission efficiency | | |
|---|---|---|---|---|---|---|---|---|---|
| | Emission-peak wavelength (nm) | Relative emission-peak intensity | Full width at half maximum of the emission peak (nm) | Relative brightness | Color coordinate | | Absorption efficiency $\alpha_q$ | Internal quantum efficiency. $\eta_i$ | External quantum efficiency $\eta_o$ |
| | | | | | x value | y value | | | |
| Comparative Example 11 | 516 | 63 | 74 | 36 | 0.223 | 0.634 | 0.27 | 0.78 | 0.21 |
| Comparative Example 12 | 509 | 23 | 70 | 13 | 0.214 | 0.605 | 0.20 | 0.43 | 0.09 |
| Comparative Example 13 | 516 | 87 | 70 | 50 | 0.227 | 0.639 | 0.37 | 0.71 | 0.26 |
| Comparative Example 14 | 512 | 27 | 72 | 15 | 0.218 | 0.614 | 0.29 | 0.36 | 0.10 |

The non-luminous object colors based on $L^*$, $a^*$ and $b^*$ color space (sic) were also measured for the phosphors of Comparative Examples 11 to 14 by the same procedure as that for the above-mentioned Examples 1 to 6 and Comparative Examples 1 to 8. The results are shown in Table 17 below.

[Table 17]

Table 17

| | Non-luminous object color | | | |
|---|---|---|---|---|
| | $L^*$ | $a^*$ | $b^*$ | $a^*/b^*$ |
| Comparative Example 11 | 101.62 | -12.32 | 16.35 | -0.75 |
| Comparative Example 12 | 100.67 | -6.32 | 10.78 | -0.59 |
| Comparative Example 13 | 101.71 | -16.51 | 24.02 | -0.69 |
| Comparative Example 14 | 99.59 | -8.57 | 15.56 | -0.55 |

In the phosphors of Comparative Examples 11 to 14, the relative emission-peak intensity, relative brightness and external quantum efficiency were all low, as shown in Table 16. As shown in Table 17, the object color was also outside the specified range of the present invention. This is considered to be because, in the phosphors of Comparative Examples 11 to 14, the concentration of Eu was low in comparison with the phosphors of the present invention, the firing time was short in the primary and also secondary firing, and the combination of firing temperature and firing atmosphere was not appropriate.

[Compositions (1) to (6)]

In Examples 37 to 39 and Comparative Examples 15 to 47 which will be explained below, at the time of phosphor production, each powder of barium carbonate ($BaCO_3$), strontium carbonate ($SrCO_3$), europium oxide ($Eu_2O_3$) and silicon dioxide ($SiO_2$) was weighed out as phosphor materials so as to give a respective compositions of (1) to (6) in Table 18 below. In the following explanation, these compositions are represented simply as composition (1) to composition (6).

[Table 18]

Table 18

| | Composition | | | | | |
|---|---|---|---|---|---|---|
| | $M^I$ | | | $M^{II}$ | $\alpha$ | Molar ratio (%) of Eu, relative to bivalent elements [*5] |
| | Ba | Ca | Sr | Eu | | |
| Composition (1) | 1 | 0 | 0.98 | 0.02 | 1.9 | 1.0 |
| Composition (2) | 1.98 | 0 | 0 | 0.02 | 1.9 | 1.0 |
| Composition (3) | 1.5 | 0 | 0.48 | 0.02 | 1.9 | 1.0 |
| Composition (4) | 0.5 | 0 | 1.48 | 0.02 | 1.9 | 1.0 |
| Composition (5) | 0 | 1 | 0.98 | 0.02 | 1.9 | 1.0 |
| Composition (6) | 1.36 | 0 | 0.46 | 0.15 | 1.9 | 1.0 |
| *5: the ratio of number of moles of Eu, relative to the total number of moles of bivalent elements (alkaline-earth metal elements and Eu) in the phosphor | | | | | | |

As shown in Table 18 above, the amount of Eu is small in compositions (1) to (5). Only in composition (6), the amount of Eu is large and the requirement (v), mentioned earlier, of the specific-property phosphor of the present invention is satisfied.

[Example 37 and Comparative Examples 15 to 19]

The powders of phosphor materials were weighed out so that the composition was as described in Table 19 below. They were mixed in an automatic mortar until they were sufficiently homogeneous, transferred to an alumina crucible and fired at 1100 °C for 12 hours in nitrogen atmosphere under an atmospheric pressure (primary firing). The content of the crucible was taken out, $SrCl_2$ was added as flux to give a molar ratio of 0.1 relative to silicon (Si) in the phosphor, and the mixture was mixed and powdered with a dry-type ball mill. The powdered mixture obtained was again transferred to an alumina crucible. Then solid carbon was placed onto it, and the crucible was covered with a lid. In a vacuum furnace, the pressure was reduced to 2 Pa using a vacuum pump and then a nitrogen gas containing hydrogen (nitrogen : hydrogen = 96 : 4 (volume ratio)) was introduced until atmospheric pressure was restored. This operation was repeated again and firing was done at 1200 °C for 6 hours in atmospheric pressure under a flow of nitrogen gas containing hydrogen (nitrogen : hydrogen = 96 : 4 (volume ratio)) (secondary firing). The fired product obtained was powdered using a ball mill and, just as it is slurry, passed through a sieve to remove coarse particles, washed with water, elutriated to remove fine particles, dried and sieved to disintegrate aggregated particles, to produce the phosphor. Hereinafter, these phosphors are called the phosphors of Example 37 and Comparative Examples 15 to 19. The conditions of production of the phosphors of Example 37 and Comparative Examples 15 to 19 are presented in Table 19 below.

[Table 19]

Table 19

| | Composition | Conditions of primary firing | | | | Conditions of secondary firing | | | | |
|---|---|---|---|---|---|---|---|---|---|---|
| | | Atmosphere | Firing temperature | Firing time | Flux | Atmosphere | Solid carbon | Firing temperature | Firing time | Flux |
| Comparative Example 15 | Composition (1) | nitrogen | 1100 °C | 12 hours | absent | nitrogen gas containing hydrogen | present | 1200 °C | 6 hours | $SrCl_2$ |
| Comparative Example 16 | Composition (2) | nitrogen | 1100 °C | 12 hours | absent | nitrogen gas containing hydrogen | present | 1200 °C | 6 hours | $SrCl_2$ |
| Comparative Example 17 | Composition (3) | nitrogen | 1100 °C | 12 hours | absent | nitrogen gas containing hydrogen | present | 1200 °C | 6 hours | $SrCl_2$ |
| Comparative Example 18 | Composition (4) | nitrogen | 1100 °C | 12 hours | absent | nitrogen gas containing hydrogen | present | 1200 °C | 6 hours | $SrCl_2$ |
| Comparative Example 19 | Composition (5) | nitrogen | 1100 °C | 12 hours | absent | nitrogen gas containing hydrogen | present | 1200 °C | 6 hours | $SrCl_2$ |
| Example 37 | Composition (6) | nitrogen | 1100 °C | 12 hours | absent | nitrogen gas containing hydrogen | present | 1200 °C | 6 hours | $SrCl_2$ |

For the phosphors obtained in Example 37 and Comparative Examples 15 to 19, the wavelength of emission peak, relative emission-peak intensity, full width at half maximum of the emission peak, relative brightness, color coordinate, absorption efficiency, internal quantum efficiency, external quantum efficiency and non-luminous object color based on $L^*$, $a^*$ and $b^*$ color space (sic) were measured, by the same method as described for Examples 34 to 36. The results are shown in Table 20 and Table 21.

[Table 20]

Table 20

| | Emission-peak wavelength (nm) | Relative emission-peak intensity (%) | Full width at half maximum of the emission peak (nm) | Relative brightness (%) | Color coordinate | |
| --- | --- | --- | --- | --- | --- | --- |
| | | | | | x value | y value |
| Comparative Example 15 | 518 | 110 | 65 | 64 | 0.233 | 0.615 |
| Comparative Example 16 | 505 | 103 | 62 | 46 | 0.171 | 0.568 |
| Comparative Example 17 | 517 | 111 | 69 | 66 | 0.227 | 0.612 |
| Comparative Example 18 | 544 | 109 | 87 | 93 | 0.377 | 0.571 |
| Comparative Example 19 | 602 | 51 | 128 | 44 | 0.491 | 0.458 |
| Example 37 | 527 | 187 | 69 | 125 | 0.276 | 0.630 |

[Table 21]

Table 21

| | Emission efficiency | | | Non-luminous object color | | | |
| --- | --- | --- | --- | --- | --- | --- | --- |
| | Absorption efficiency $\alpha_q$ | Internal quantum efficiency $\eta_i$ | External quantum efficiency $\eta_o$ | $L^*$ | $a^*$ | $b^*$ | $a^*/b^*$ |
| Comparative Example 15 | 0.38 | 0.84 | 0.32 | 103.3 | -19.1 | +26.12 | -0.73 |
| Comparative Example 16 | 0.39 | 0.64 | 0.25 | 98.1 | -17.8 | +17.76 | -1.00 |
| Comparative Example 17 | 0.41 | 0.80 | 0.32 | 101.5 | -20.9 | +25.81 | -0.81 |
| Comparative Example 18 | 0.55 | 0.79 | 0.43 | 104.3 | -19.5 | +42.64 | -0.46 |
| Comparative Example 19 | 0.52 | 0.60 | 0.31 | 99.4 | -5.7 | +35.73 | -0.16 |
| Example 37 | 0.72 | 0.73 | 0.53 | 103.1 | -33.8 | +53.28 | -0.63 |

From the results shown in Table 20 and Table 21, it is clear that, when the amount of Eu is small as in phosphors of Comparative Examples 15 to 19, it tends to be difficult to obtain a phosphor of excellent luminescent characteristics even when firing was done in the presence of solid carbon. Further, it is clear that, like a phosphor in Comparative Example 18, full width at half maximum of the emission peak tends to be broad as the amount of Sr becomes large.

[Example 38 and Comparative Examples 20 to 24]

The phosphors were produced by the same method as that used for the above-mentioned Example 37 and Comparative Examples 15 to 19, except that the primary firing was done in air, no flux was used in the secondary firing and instead, $SrCl_2$ was used as flux in the primary firing in a molar ratio of 0.1 relative to the amount of silicon (Si) in the phosphor. Hereinafter, these phosphors are called the phosphors of Example 38 and Comparative Examples 20 to 24. The conditions of production of the phosphors of Example 38 and Comparative Examples 20 to 24 are presented in Table 22 below.

[Table 22]

Table 22

| | Composition | Conditions of primary firing | | | | Conditions of secondary firing | | | | |
|---|---|---|---|---|---|---|---|---|---|---|
| | | Atmosphere | temperature | Firing time | Flux | Atmosphere | Solid carbon | Fring temperature | Firing time | Flux |
| Comparative Example 20 | Composition (1) | air | 1100 °C | 12 hours | SrCl$_2$ | nitrogen gas containing hydrogen | present | 1200 °C | 6 hours | absent |
| Comparative Example 21 | Composition (2) | air | 1100 °C | 12 hours | SrCl$_2$ | nitrogen gas containing hydrogen | present | 1200 °C | 6 hours | absent |
| Comparative Example 22 | Composition (3) | air | 1100 °C | 12 hours | SrCl$_2$ | nitrogen gas containing hydrogen | present | 1200 °C | 6 hours | absent |
| Comparative Example 23 | Composition (4) | air | 1100 °C | 12 hours | SrCl$_2$ | nitrogen gas containing hydrogen | present | 1200 °C | 6 hours | absent |
| Comparative Example 24 | Composition (5) | air | 1100 °C | 12 hours | SrCl$_2$ | nitrogen gas containing hydrogen | present | 1200 °C | 6 hours | absent |
| Example 38 | Composition (6) | air | 1100 °C | 12 hours | SrCl$_2$ | nitrogen gas containing hydrogen | present | 1200 °C | 6 hours | absent |

For the phosphors obtained in Example 38 and Comparative Examples 20 to 24, the wavelength of emission peak, relative emission-peak intensity, full width at half maximum of the emission peak, relative brightness, color coordinate, absorption efficiency, internal quantum efficiency, external quantum efficiency and non-luminous object color based on $L^*$, $a^*$ and $b^*$ color space (sic) were measured, by the same method as described for Examples 34 to 36. The results are shown in Table 23 and Table 24.

[Table 23]

Table 23

|  | Emission-peak wavelength (nm) | Relative emission-peak intensity (%) | Full width at half maximum of the emission peak (nm) | Relative brightness (%) | Color coordinate | |
|---|---|---|---|---|---|---|
|  |  |  |  |  | x value | y value |
| Comparative Example 20 | 521 | 183 | 66 | 115 | 0.262 | 0.629 |
| Comparative Example 21 | 508 | 113 | 67 | 57 | 0.191 | 0.588 |
| Comparative Example 22 | 520 | 146 | 68 | 87 | 0.234 | 0.621 |
| Comparative Example 23 | 549 | 128 | 89 | 111 | 0.393 | 0.566 |
| Comparative Example 24 | 598 | 63 | 124 | 52 | 0.503 | 0.457 |
| Example 38 | 528 | 191 | 69 | 128 | 0.280 | 0.632 |

[Table 24]

Table 24

|  | Emission efficiency | | | Non-luminous object color | | | |
|---|---|---|---|---|---|---|---|
|  | Absorption efficiency $\alpha_q$ | Internal quantum efficiency $\eta_i$ | External quantum efficiency $\eta_o$ | $L^*$ | $a^*$ | $b^*$ | $a^*/b^*$ |
| Comparative Example 20 | 0.66 | 0.63 | 0.42 | 103.9 | -28.9 | +38.61 | -0.75 |
| Comparative Example 21 | 0.44 | 0.66 | 0.29 | 99.4 | -20.1 | +22.55 | -0.89 |
| Comparative Example 22 | 0.54 | 0.73 | 0.39 | 102.3 | -25.6 | +33.69 | -0.76 |
| Comparative Example 23 | 0.65 | 0.75 | 0.49 | 104.6 | -21.8 | +53.65 | -0.41 |
| Comparative Example 24 | 0.57 | 0.63 | 0.36 | 99.6 | -5.3 | +43.15 | -0.12 |
| Example 38 | 0.75 | 0.70 | 0.53 | 103.7 | -34.5 | +57.80 | -0.60 |

From the results shown in Table 23 and Table 24, it is evident that, in Comparative Example 23, the relative brightness and external quantum efficiency $\eta_o$ reached a certain level, but the full width at half maximum of the emission peak was broad and thus the requirement (ii) for the specific-property phosphor of the present invention mentioned earlier was not satisfied.

[Comparative Examples 25 to 30]

The phosphors were produced by the same method as that used for the above-mentioned Example 37 and Comparative Examples 15 to 19, except that the primary firing was done in air, $NH_4Cl$ was used as flux in the primary firing in place of $SrCl_2$ in a molar ratio of 0.1, relative to the amount of silicon (Si) in the phosphor, no flux was used in the secondary firing and no solid carbon was used. Hereinafter, these phosphors are called the phosphors of Comparative Examples 25 to 30. The conditions of production of the phosphors of Comparative Examples 25 to 30 are presented in Table 25 below.

[Table 25]

Table 25

| | Composition | Conditions of primary firing | | | | Conditions of secondary firing | | | | |
|---|---|---|---|---|---|---|---|---|---|---|
| | | Atmosphere | Firing temperature | Firing time | Flux | Atmosphere | Solid carbon | Firing temperature | Firing time | Flux |
| Comparative Example 25 | Composition (1) | air | 1100 °C | 12 hours | $NH_4Cl$ | nitrogen gas containing hydrogen | absent | 1200 °C | 6 hours | absent |
| Comparative Example 26 | Composition (2) | air | 1100 °C | 12 hours | $NH_4Cl$ | nitrogen gas containing hydrogen | absent | 1200 °C | 6 hours | absent |
| Comparative Example 27 | Composition (3) | air | 1100 °C | 12 hours | $NH_4Cl$ | nitrogen gas containing hydrogen | absent | 1200 °C | 6 hours | absent |
| Comparative Example 28 | Composition (4) | air | 1100 °C | 12 hours | $NH_4Cl$ | nitrogen gas containing hydrogen | absent | 1200 °C | 6 hours | absent |
| Comparative Example 29 | Composition (5) | air | 1100 °C | 12 hours | $NH_4Cl$ | nitrogen gas containing hydrogen | absent | 1200 °C | 6 hours | absent |
| Comparative Example 30 | Composition (6) | air | 1100 °C | 12 hours | $NH_4Cl$ | nitrogen gas containing hydrogen | absent | 1200 °C | 6 hours | absent |

For the phosphors obtained in Example 38 and Comparative Examples 20 to 24 (sic), the wavelength of emission peak, relative emission-peak intensity, full width at half maximum of the emission peak, relative brightness, color coordinate, absorption efficiency $\alpha_q$, internal quantum efficiency $\eta_i$, external quantum efficiency $\eta_o$ and non-luminous object color based on $L^*$, $a^*$ and $b^*$ color space (sic) were measured, by the same method as described for Examples 34 to 36. The results are shown in Table 26 and Table 27.

[Table 26]

Table 26

| | Emission-peak wavelength (nm) | Relative emission-peak intensity (%) | Full width at half maximum of the emission peak (nm) | Relative brightness (%) | Color coordinate | |
|---|---|---|---|---|---|---|
| | | | | | x value | y value |
| Comparative Example 25 | 517 | 143 | 62 | 79 | 0.224 | 0.629 |
| Comparative Example 26 | 504 | 103 | 58 | 44 | 0.160 | 0.556 |
| Comparative Example 27 | 518 | 110 | 67 | 64 | 0.224 | 0.613 |
| Comparative Example 28 | 544 | 74 | 86 | 62 | 0.362 | 0.573 |
| Comparative Example 29 | 587 | 8 | 73 | 10 | 0.359 | 0.433 |
| Comparative Example 30 | 524 | 89 | 68 | 57 | 0.260 | 0.630 |

[Table 27]

Table 27

| | Emission efficiency | | | Non-luminous object color | | | |
|---|---|---|---|---|---|---|---|
| | Absorption efficiency $\alpha_q$ | Internal quantum efficiency $\eta_i$ | External quantum efficiency $\eta_o$ | $L^*$ | $a^*$ | $b^*$ | $a^*/b^*$ |
| Comparative Example 25 | 0.62 | 0.57 | 0.35 | 102.2 | -26.0 | +41.04 | -0.63 |
| Comparative Example 26 | 0.37 | 0.63 | 0.23 | 100.3 | -16.9 | +19.29 | -0.87 |
| Comparative Example 27 | 0.47 | 0.67 | 0.32 | 102.5 | -21.6 | +30.01 | -0.72 |
| Comparative Example 28 | 0.55 | 0.50 | 0.28 | 102.1 | -17.4 | +39.53 | -0.44 |
| Comparative Example 29 | 0.38 | 0.17 | 0.06 | 97.8 | -5.9 | +19.68 | -0.30 |
| Comparative Example 30 | 0.38 | 0.17 | 0.06 | 99.1 | -25.0 | +51.30 | -0.49 |

From the results presented in Table 26 and Table 27, it is evident that the luminescent characteristics tend to deteriorate when firing was done in a weak reducing atmosphere like the nitrogen gas containing hydrogen (nitrogen : hydrogen = 96 : 4 (volume ratio)) in such cases as phosphors of Comparative Examples 25 to 30.

[Example 39 and Comparative Examples 31 to 35]

The phosphors were produced by the same method as that used for the above-mentioned Comparative Examples 25 to 30, except that $SrCl_2$ was used as flux in the primary firing in place of $NH_4Cl$ in a molar ratio of 0.1, relative to the amount of silicon (Si) in the phosphor. Hereinafter, these phosphors are called the phosphors of Example 39 and Comparative Examples 31 to 35. The conditions of production of the phosphors of Example 39 and Comparative Examples 31 to 35 are presented in Table 28 below.

[Table 28]

Table 28

| | Composition | Conditions of primary firing | | | | Conditions of secondary firing | | | | |
|---|---|---|---|---|---|---|---|---|---|---|
| | | Atmosphere | Firing temperature | Firing time | Flux | Atmosphere | Solid carbon | Firing temperature | Firing time | Flux |
| Comparative Example 31 | Composition (1) | air | 1100 °C | 12 hours | $SrCl_2$ | nitrogen gas containing hydrogen | absent | 1200 °C | 6 hours | absent |
| Comparative Example 32 | Composition (2) | air | 1100 °C | 12 hours | $SrCl_2$ | nitrogen gas containing hydrogen | absent | 1200 °C | 6 hours | absent |
| Comparative Example 33 | Composition (3) | air | 1100 °C | 12 hours | $SrCl_2$ | nitrogen gas containing hydrogen | absent | 1200 °C | 6 hours | absent |
| Comparative Example 34 | Composition (4) | air | 1100 °C | 12 hours | $SrCl_2$ | nitrogen gas containing hydrogen | absent | 1200 °C | 6 hours | absent |
| Comparative Example 35 | Composition (5) | air | 1100 °C | 12 hours | $SrCl_2$ | nitrogen gas containing hydrogen | absent | 1200 °C | 6 hours | absent |
| Example 39 | Composition (6) | air | 1100 °C | 12 hours | $SrCl_2$ | nitrogen gas containing hydrogen | absent | 1200 °C | 6 hours | absent |

For the phosphors obtained in Example 39 and Comparative Examples 31 to 35, the wavelength of emission peak, relative emission-peak intensity, full width at half maximum of the emission peak, relative brightness, color coordinate, absorption efficiency, internal quantum efficiency, external quantum efficiency and non-luminous object color based on $L^*$, $a^*$ and $b^*$ color space (sic) were measured, by the same method as described for Examples 34 to 36. The results are presented in Table 29 and Table 30.

[Table 29]

Table 29

| | Emission-peak wavelength (nm) | Relative emission-peak intensity (%) | Full width at half maximum of the emission peak (nm) | Relative brightness (%) | Color coordinate | |
| --- | --- | --- | --- | --- | --- | --- |
| | | | | | x value | y value |
| Comparative Example 31 | 521 | 155 | 65 | 93 | 0.247 | 0.631 |
| Comparative Example 32 | 508 | 98 | 64 | 47 | 0.180 | 0.578 |
| Comparative Example 33 | 518 | 127 | 68 | 75 | 0.231 | 0.620 |
| Comparative Example 34 | 545 | 85 | 86 | 73 | 0.380 | 0.568 |
| Comparative Example 35 | 590 | 21 | 159 | 21 | 0.443 | 0.463 |
| Example 39 | 525 | 197 | 68 | 130 | 0.275 | 0.634 |

[Table 30]

Table 30

| | Emission efficiency | | | Non-luminous object color | | | |
| --- | --- | --- | --- | --- | --- | --- | --- |
| | Absorption efficiency $\alpha_q$ | Internal quantum efficiency $\eta_i$ | External quantum efficiency $\eta_o$ | $L^*$ | $a^*$ | b | $a^*/b^*$ |
| Comparative Example 31 | 0.65 | 0.63 | 0.41 | 103.4 | -28.3 | +46.35 | -0.61 |
| Comparative Example 32 | 0.41 | 0.62 | 0.25 | 99.2 | -18.0 | +20.08 | -0.89 |
| Comparative Example 33 | 0.53 | 0.65 | 0.35 | 101.8 | -23.9 | +33.25 | -0.72 |
| Comparative Example 34 | 0.62 | 0.52 | 0.32 | 102.7 | -19.2 | +48.76 | -0.39 |
| Comparative Example 35 | 0.53 | 0.26 | 0.14 | 97.4 | -7.9 | +33.25 | -0.24 |
| Example 39 | 0.73 | 0.73 | 0.53 | 103.5 | -34.6 | +57.18 | -0.61 |

From the comparison of the results in Table 29 and Table 30 with the results in Table 26 and Table 27, it is evident that the phosphors of Comparative Examples 31 to 35 and Example 39 have better luminescent characteristics in whole than the phosphors of Comparative Examples 25 to 30. Thus, it is more preferable to use $SrCl_2$ than to use $NH_4Cl$ as flux. The effect of $SrCl_2$ is particularly remarkable from the comparison of the phosphor of Comparative Example 30 with that of Example 39.

As mentioned above, firing in a highly reducing atmosphere tends to give a phosphor of better luminescent characteristics and is, therefore, preferable. However, from the results obtained with the phosphor of Example 39, it is evident that, even in a weakly reducing atmosphere, it is possible to obtain a phosphor of high luminescent characteristics by adjusting the amount of Eu properly and using an appropriate flux such as $SrCl_2$.

[Comparative Examples 36 to 41]

The phosphors were produced by the same method as that used for the above-mentioned Example 37 and Comparative Examples 15 to 19, except that the primary firing was done in air using $NH_4Cl$ as flux in a molar ratio of 0.1 relative to the amount of silicon (Si) in the phosphor, and the secondary firing was done in air in the presence of a solid carbon (namely, in an atmosphere close to carbon monoxide) without any flux. Hereinafter, these phosphors are called the phosphors of Comparative Examples 36 to 41. The production conditions of the phosphors of Comparative Examples 36 to 41 are presented in Table 31 below.

[Table 31]

Table 31

| | Composition | Conditions of primary firing | | | | Conditions of secondary firing | | | | |
|---|---|---|---|---|---|---|---|---|---|---|
| | | Atmosphere | Firing temperature | Firing time | Flux | Atmosphere | Solid carbon | Firing temperature | Firing time | Flux |
| Comparative Example 36 | Composition (1) | air | 1100 °C | 12 hours | $NH_4Cl$ | air | present | 1200 °C | 6 hours | absent |
| Comparative Example 37 | Composition (2) | air | 1100 °C | 12 hours | $NH_4Cl$ | air | present | 1200 °C | 6 hours | absent |
| Comparative Example 38 | Composition (3) | air | 1100 °C | 12 hours | $NH_4Cl$ | air | present | 1200 °C | 6 hours | absent |
| Comparative Example 39 | Composition (4) | air | 1100 °C | 12 hours | $NH_4Cl$ | air | present | 1200 °C | 6 hours | absent |
| Comparative Example 40 | Composition (5) | air | 1100 °C | 12 hours | $NH_4Cl$ | air | present | 1200 °C | 6 hours | absent |
| Comparative Example 41 | Composition (6) | air | 1100 °C | 12 hours | $NH_4Cl$ | air | present | 1200 °C | 6 hours | absent |

For the phosphors obtained in Comparative Examples 36 to 41, the wavelength of emission peak, relative emission-peak intensity, full width at half maximum of the emission peak, relative brightness, color coordinate, absorption efficiency, internal quantum efficiency, external quantum efficiency and non-luminous object color based on $L^*$, $a^*$ and $b^*$ color space (sic) were measured, by the same method as described for Examples 34 to 36. The results are presented in Table 32 and Table 33.

[Table 32]

Table 32

| | Emission-peak wavelength (nm) | Relative emission-peak intensity (%) | Full width at half maximum of the emission peak (nm) | Relative brightness (%) | Color coordinate | |
|---|---|---|---|---|---|---|
| | | | | | x value | y value |
| Comparative Example 36 | 515 | 52 | 66 | 28 | 0.209 | 0.596 |
| Comparative Example 37 | 500 | 45 | 57 | 19 | 0.159 | 0.517 |
| Comparative Example 38 | 517 | 41 | 74 | 24 | 0.212 | 0.575 |
| Comparative Example 39 | 534 | 15 | 105 | 13 | 0.301 | 0.519 |
| Comparative Example 40 | 584 | 3 | 18 | 5 | 0.259 | 0.385 |
| Comparative Example 41 | 517 | 12 | 78 | 8 | 0.221 | 0.541 |

[Table 33]

Table 33

| | Emission efficiency | | | Non-luminous object color | | | |
|---|---|---|---|---|---|---|---|
| | Absorption efficiency $\alpha_q$ | Internal quantum efficiency $\eta_i$ | External quantum efficiency $\eta_o$ | $L^*$ | $a^*$ | $b^*$ | $a^*/b^*$ |
| Comparative Example 36 | 0.51 | 0.25 | 0.13 | 99.4 | -15.6 | +29.07 | -0.54 |
| Comparative Example 37 | 0.51 | 0.25 | 0.13 | 97.5 | -10.8 | +13.32 | -0.81 |
| Comparative Example 38 | 0.34 | 0.33 | 0.11 | 99.3 | -13.7 | +22.60 | -0.60 |
| Comparative Example 39 | 0.43 | 0.28 | 0.12 | 96.5 | -9.3 | +22.99 | -0.40 |
| Comparative Example 40 | 0.47 | 0.13 | 0.06 | 96.6 | -4.4 | +13.39 | -0.33 |
| Comparative Example 41 | 0.33 | 0.11 | 0.04 | 94.9 | -14.6 | +40.59 | -0.36 |

The luminescent characteristics of the phosphors of Comparative Examples 36 to 41 were low. The reason was considered to be due to too weak reductive conditions of the atmosphere of firing.

[Comparative Examples 42 to 47]

The phosphors were produced by the same method as that used for the above-mentioned Comparative Examples 36 to 41, except that $SrCl_2$ was used as flux in the primary firing in place of $NH_4Cl$ in a molar ratio of 0.1, relative to the amount of silicon (Si) in the phosphor. Hereinafter, these phosphors are called the phosphors of Comparative Examples 42 to 47. The conditions of production of the phosphors of Comparative Examples 42 to 47 are presented in Table 34 below.

[Table 34]

Table 34

| | Composition | Conditions of primary firing | | | | Conditions of secondary firing | | | | |
|---|---|---|---|---|---|---|---|---|---|---|
| | | Atmosphere | Firing temperature | Firing time | Flux | Atmosphere | Solid carbon | Firing temperature | Firing time | Flux |
| Comparative Example 42 | Composition (1) | air | 1100 °C | 12 hours | $SrCl_2$ | air | present | 1200 °C | 6 hours | absent |
| Comparative Example 43 | Composition (2) | air | 1100 °C | 12 hours | $SrCl_2$ | air | present | 1200 °C | 6 hours | absent |
| Comparative Example 44 | Composition (3) | air | 1100 °C | 12 hours | $SrCl_2$ | air | present | 1200 °C | 6 hours | absent |
| Comparative Example 45 | Composition (4) | air | 1100 °C | 12 hours | $SrCl_2$ | air | present | 1200 °C | 6 hours | absent |
| Comparative Example 46 | Composition (5) | air | 1100 °C | 12 hours | $SrCl_2$ | air | present | 1200 °C | 6 hours | absent |
| Comparative Example 47 | Composition (6) | air | 1100 °C | 12 hours | $SrCl_2$ | air | present | 1200 °C | 6 hours | absent |

For the phosphors obtained in Comparative Examples 42 to 47, the wavelength of emission peak, relative emission-peak intensity, full width at half maximum of the emission peak, relative brightness, color coordinate, absorption efficiency, internal quantum efficiency, external quantum efficiency and non-luminous object color based on $L^*$, $a^*$ and $b^*$ color space (sic) were measured, by the same method as described for Examples 34 to 36. The results are presented in Table 35 and Table 36.

[Table 35]

Table 35

| | Emission-peak wavelength (nm) | Relative emission-peak intensity (%) | Full width at half maximum of the emission peak (nm) | Relative brightness (%) | Color coordinate | |
|---|---|---|---|---|---|---|
| | | | | | x value | y value |
| Comparative Example 42 | 519 | 73 | 64 | 48 | 0.233 | 0.617 |
| Comparative Example 43 | 506 | 63 | 63 | 30 | 0.175 | 0.558 |
| Comparative Example 44 | 519 | 67 | 71 | 40 | 0.223 | 0.601 |
| Comparative Example 45 | 544 | 25 | 93 | 22 | 0.345 | 0.543 |
| Comparative Example 46 | 563 | 4 | 22 | 6 | 0.333 | 0.417 |
| Comparative Example 47 | 514 | 11 | 79 | 7 | 0.224 | 0.539 |

[Table 36]

Table 36

| | Emission efficiency | | | Non-luminous object color | | | |
|---|---|---|---|---|---|---|---|
| | Absorption efficiency $\alpha_q$ | Internal quantum efficiency $\eta_i$ | External quantum efficiency $\eta_o$ | $L^*$ | $a^*$ | $b^*$ | $a^*/b^*$ |
| Comparative Example 42 | 0.59 | 0.36 | 0.21 | 100.0 | -20.1 | +36.29 | -0.55 |
| Comparative Example 43 | 0.39 | 0.42 | 0.16 | 97.3 | -13.8 | +15.97 | -0.87 |
| Comparative Example 44 | 0.47 | 0.40 | 0.19 | 99.4 | -16.9 | +25.65 | -0.66 |
| Comparative Example 45 | 0.52 | 0.19 | 0.10 | 96.6 | -11.6 | +27.87 | -0.42 |
| Comparative Example 46 | 0.53 | 0.08 | 0.04 | 85.0 | -4.7 | +13.69 | -0.34 |
| Comparative Example 47 | 0.72 | 0.05 | 0.04 | 92.8 | -14.1 | +39.29 | -0.36 |

The luminescent characteristics of the phosphors of Comparative Examples 42 to 47 were low. The reason was considered to be due to too weak reductive conditions of the atmosphere of firing.

[Example 40]

A light emitting device, of which constitution was the same as what is shown in Fig. 2(b), was prepared by the following procedure.

As the first luminous body (22), a blue light-emitting diode (hereinafter abbreviated as "blue LED" as appropriate) having emission wavelength of 450 nm to 470 nm, C460EZ290, manufactured by Cree, Inc., was used. The blue LED (22) was bonded by means of die bonding using silver paste as adhesive to the terminal disposed at the bottom of the recess in the frame (24). The adhesive of silver paste was applied thinly and uniformly, in consideration of efficient dissipation of heat generated at the blue LED (22). After curing the silver paste by heating at 150 °C for 2 hours, the blue LED (22) and the electrode (26) of the frame (24) were bonded through wire bonding. For wire (25), a gold wire with diameter of 25 μm was used.

For luminescent material of the phosphor-containing resinous part (23), the phosphor (C) used in Example 8 and the green phosphor used in the above-mentioned Example 34 (hereinafter referred to as "phosphor (D)" as appropriate) were used. The weight ratio of the phosphor (C) and phosphor (D) was 16:84. An epoxy resin (YL7301, manufactured by Japan Epoxy Resins Co., Ltd.) was added in the weight ratio of 13:100, relative to the total weight of these phosphors (C) and (D). Further, by adding a curing agent (YLH1230, manufactured by Japan Epoxy Resins Co., Ltd.) and aerosil (RY-200S, Nippon Aerojil), a phosphor slurry (phosphor-containing composition) was prepared. The obtained phosphor slurry was poured into the recess of the above-mentioned frame (24), and heated at 100 °C for 3 hours and then at 140 °C for another 3 hours, so as to be cured. Thereby, a phosphor-containing resinous part (23) was prepared.

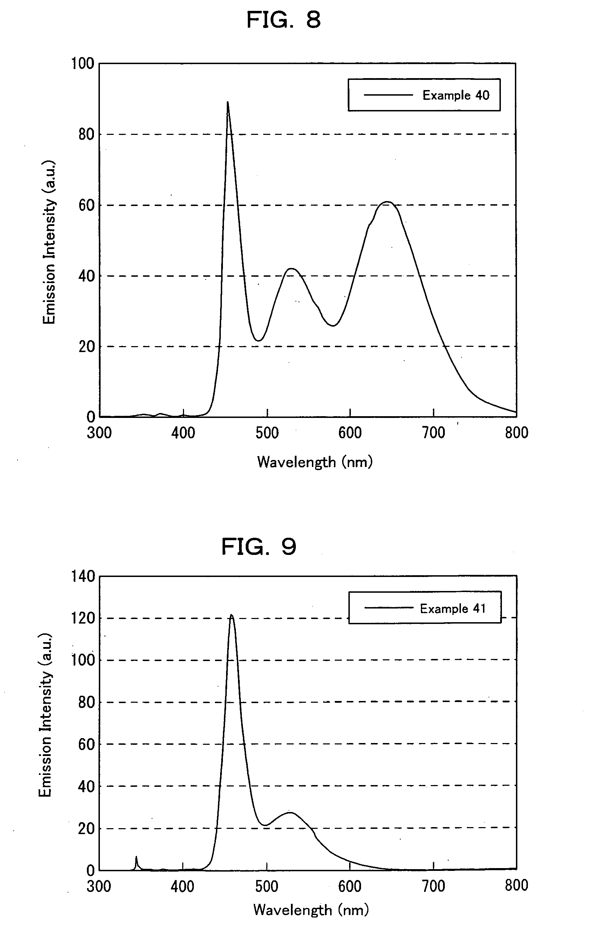

When the obtained light emitting device was driven to emit light by energizing the blue LED (22) with a current of 20 mA, a white light could be obtained. The light emitted from the light emitting device was measured with a fiber multi-channel spectroscope (USB2000, manufactured by Ocean Optics, Inc.). As its white color coordinate was measured, it was x/y = 0.34/0.33. In addition, the entire luminous flux of the emitted light was 2.6 lm, and the emission efficiency was 43 lm/W. The emission spectrum of the white light, measured then, of the light emitting device in Example 40 is shown in Fig. 8.

[Example 41]

A light emitting device was prepared by the same method as described for Example 40, except that, as the luminescent material in the phosphor-containing resinous part (23), the phosphor (D) alone was used and, as the blue LED (22), C460MB290 (manufactured by Cree, Inc., having luminous wavelength of 450 nm to 470 nm) was used.

When the obtained light emitting device was driven to emit light by the same condition as in Example 40, a blue green light could be obtained. The light emitted from the light emitting device was measured with a fiber multi-channel spectroscope (USB2000, manufactured by Ocean Optics, Inc.). As its white color coordinate was measured, it was x/y = 0.18/0.22, the entire luminous flux of the emitted light was 1.4 lm, and the emission efficiency was 23 lm/W. The emission spectrum, measured then, of the light emitting device in Example 41 is shown in Fig. 9.

[Example 42]

A light emitting device was prepared by the same method as described for Example 40, except that the following points. As the first luminous body(22), a near-ultraviolet light-emitting diode (hereinafter referred to as "near-ultraviolet LED" as appropriate) of C395MB290 BR0428-03A (manufactured by Cree, Inc., having luminous wavelength of 390 nm to 400 nm) was used in place of the blue LED, and as the luminescent material in the phosphor-containing resinous part (22) (sic), the phosphor (C) (red phosphor), the phosphor (D) (green phosphor) and a blue phosphor, emitting a light having the wavelength of around 420 nm to 460nm, of $BaMgAl_{10}O_{17}$:Eu (hereinafter referred to as "phosphor (E)" as appropriate) were used. The weight ratio of the phosphor (C) : phosphor (D) : phosphor (E) was equal to 2:2:17. A silicone resin (JCR6101UP, manufactured by Dow Corning Toray Company, Limited), in place of the epoxy resin, was added to the phosphors in the weight ratio of 21:100, relative to the total weight of these phosphors (C), (D) and (E). Further, an aerosil (RY-200S, manufactured by Nippon Aerojil) was added thereto. In the results, a phosphor slurry (phosphor-containing composition) was prepared. The phosphor slurry was heated to be cured under the conditions of at 70 °C for 1 hr, and subsequently at 150 °C for 2 hours.

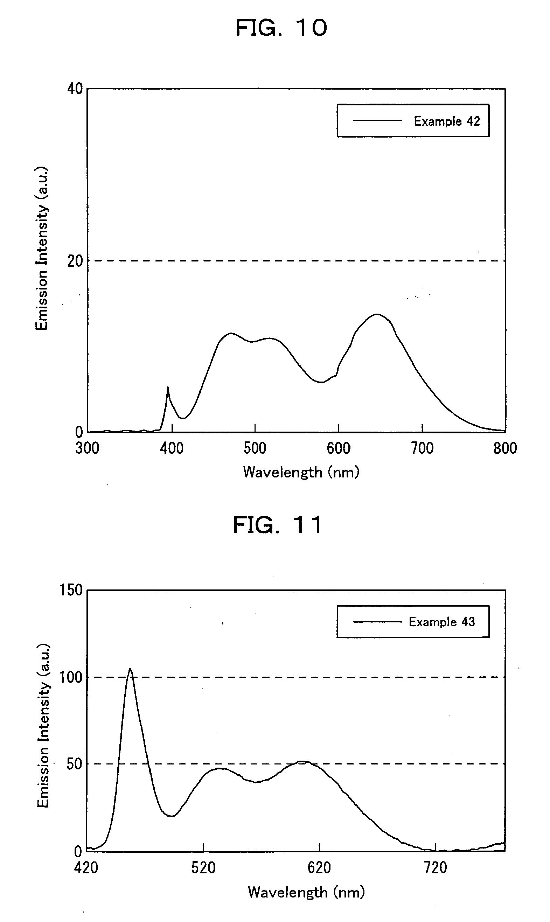

The obtained light emitting device was driven to emit light in the same condition as in Example 7, by energizing the near-ultraviolet LED with a current of 20 mA, and then a white light could be obtained. The light emitted from the light emitting device was measured with a fiber multi-channel spectroscope (USB2000, manufactured by Ocean Optics, Inc.). As its white color coordinate was measured, it was x/y = 0.34/0.34, the entire luminous flux of the emitted light was 0.6 lm, and the emission efficiency was 8.2 lm/W. The emission spectrum of the white light, measured then, of the light emitting device in Example 42 is shown in Fig. 10.

[Example 43]

A light emitting device, of which constitution was the same as what is shown in Fig. 2(b), was prepared by the following procedure.

As the first luminous body (22), a blue light-emitting diode (hereinafter abbreviated as "blue LED" as appropriate) of C460EZ290, manufactured by Cree, Inc., having emission wavelength of 450 nm to 470 nm was used. The blue LED (22) was bonded by means of die bonding using silver paste as adhesive to the terminal disposed at the bottom of the recess in the frame (24). The adhesive, silver paste, was applied thinly and uniformly, in consideration of efficient dissipation of heat generated at the blue LED (22). After curing the silver paste by heating at 150 °C for 2 hours, the blue LED (22) and the electrode (26) of the frame (24) were bonded through wire bonding. For wire (25), a gold wire with diameter of 25 $\mu$m was used.

For luminescent material of the phosphor-containing resinous part (23), a red phosphor of $(Sr_{0.992}Eu_{0.008})_2Si_5N_8$ (hereinafter referred to as "phosphor (X)" as appropriate) and the green phosphor used in the above-mentioned Example 34 (hereinafter referred to as "phosphor (D)" as appropriate) were used. The weight ratio of the phosphor (X) and phosphor (D) was 4:11. An inorganic material (of which preparing method will be described later) was added to these phosphor (X) and phosphor (D) so that the weight ratio of (total weight of the phosphor (X) and phosphor (D)) : (total weight of the inorganic material) was equal to 15:100. To this, an aerosil (hydrophilic COK84, manufactured by Degussa Japan Co., Ltd.) was added, resulting in preparation of a phosphor slurry (phosphor-containing composition). The obtained phosphor slurry was poured into the recess of the above-mentioned frame (24), and heated at 90 °C for 2 hours, at 110 °C for 1 hour and then at 150 °C for 3 hours so as to be cured, thereby forming a phosphor-containing resinous part (23).

When the obtained light emitting device was driven to emit light by energizing the blue LED (22) with a current of 20 mA, a white light could be obtained. The light emitted from the light emitting device was measured with a fiber multi-channel spectroscope (USB2000, manufactured by Ocean Optics, Inc.). As its white color coordinate was measured, it was x/y = 0.34/0.33, the entire luminous flux of the emitted light was 1.3 lm, and the emission efficiency was 20.6 lm/W. The emission spectrum of the white light, measured then, of the light emitting device in Example 43 is shown in Fig. 11.

The inorganic material described above was synthesized as follows.

140 g of Double-ended silanol dimethyl silicone oil (XC96-723, manufactured by GE Toshiba Silicones Co., Ltd.), 14 g of phenyltrimethoxysilane, and 0.308 g of zirconium tetraacetylacetonate powder as a catalyst, were weighed into a three-necked flask fitted with an agitating blade and condenser, and the mixture was agitated for 15 minutes at room temperature until the catalyst dissolved sufficiently. Thereafter, the reaction solution was heated until the temperature reached 120 °C and kept at this temperature under total reflux for 30 minutes, while stirring, for initial hydrolysis.

Then, nitrogen gas ($N_2$) was blown in with SV of 20, and methanol formed, water and silicone components with low boiling point, produced as byproducts, were distilled off, while stirring was continued at 120 °C, to proceed polymerization reaction for further 6 hours. In this context, "SV" is an abbreviation of "Space Velocity" and indicates a blowing-in volume per unit time. Therefore, SV of 20 means that 20 times the reaction solution volume of nitrogen was bubbled in per 1 hour.

Bubbling of nitrogen gas was stopped and the reaction solution was cooled to room temperature and transferred to a round-bottomed flask. Then the methanol, water and silicone components with low boiling point, which were just a little amount of residues, were distilled off at 120 °C, 1 kPa and for 20 minutes in an oil bath using a rotary evaporator. Inorganic material containing no solvent was thus obtained.


[Examples 44 to 50]

As materials of the phosphor, powders of barium carbonate ($BaCO_3$), strontium carbonate ($SrCO_3$), europium oxide ($Eu_2O_3$), silicon dioxide ($SiO_2$) and terbium oxide ($Tb_4O_7$) were used. Each of these phosphor materials was of a purity of 99.9 % or more and their weight-average median diameter $D_{50}$ was in the range of 10 nm or larger and 5 $\mu$m or smaller. These phosphor materials were weighed out so that the molar ratio of each element was as described in Examples of 44 to 50 of Table 37 below. In Examples 45, 47 to 50, terbium oxide was weighed out to be used as a phosphor material so that the molar ratio of each Tb in 1 mole of the phosphor (namely, in 1 mole of silicon (Si) contained in the phosphor) was as described in column "Tb" of Table 37 below (for example, in Example 45, the terbium oxide was weighed out so that 0.001 mole of Tb was contained in 1 mole of the phosphor, namely, the molar ratio of Tb relative to the phosphor was 0.1 mole percent). In this context, the number of moles of the phosphor were determined based on the molecular weight, which was calculated considering the composition represented by the above-mentioned formula [1] as one molecule. The powders of these phosphor materials were added with $SrCl_2$ as flux, and mixed in an automatic mortar together with ethanol until they were sufficiently homogeneous. After the mixture was dried, it was transferred to an alumina crucible and fired at 1100 °C for 12 hours in nitrogen atmosphere under an atmospheric pressure. The content of the crucible was taken out, and it was mixed and powdered in a dry-type ball mill. The powdered mixture obtained was again transferred to an alumina crucible. Then solid carbon was placed onto it, and the crucible was covered with a lid. In a vacuum furnace, the pressure was reduced to 2 Pa using a vacuum pump and then a nitrogen gas containing hydrogen (nitrogen : hydrogen = 96 : 4 (volume ratio)) was introduced until atmospheric pressure was restored. This operation was repeated again and firing was done at 1200 °C for 6 hours in atmospheric pressure under a flow of nitrogen gas containing hydrogen (nitrogen : hydrogen = 96 : 4 (volume ratio)). The fired product obtained was powdered using a ball mill and, just as it is slurry, passed through a sieve to remove coarse particles, washed with water, elutriated to remove fine particles, dried and sieved to disintegrate aggregated particles, thereby to produce the phosphor. Hereinafter, these phosphors are called the phosphors of Examples 44 to 50.

[Table 37]

Table 37

| | Composition | | | | | |
|---|---|---|---|---|---|---|
| | M$^I$ | | M$^{II}$ | $\alpha$ | Molar ratio (%) of Eu, relative to bivalent elements*6 | Tb *7 |
| | Ba | Sr | Eu | | | |
| Example 44 | 1.39 | 0.46 | 0.15 | 2 | 7.5 | 0 |
| Example 45 | 1.39 | 0.46 | 0.15 | 2 | 7.5 | 0.1 |
| Example 46 | 1.59 | 0.26 | 0.15 | 2 | 7.5 | 0 |
| Example 47 | 1.59 | 0.26 | 0.15 | 2 | 7.5 | 0.05 |
| Example 48 | 1.59 | 0.26 | 0.15 | 2 | 7.5 | 0.1 |
| Example 49 | 1.59 | 0.26 | 0.15 | 2 | 7.5 | 0.2 |
| Example 50 | 1.59 | 0.26 | 0.15 | 2 | 7.5 | 0.5 |
| *6 : the ratio of number of moles of Eu, relative to the total number of moles of bivalent elements (alkaline-earth metal elements and Eu) in the phosphor<br>*7 : represented by the ratio of number of moles (mole persent) of Tb, relative to number of moles of silicon (Si) in the phosphor | | | | | | |

For the phosphors obtained in Examples 44 to 50, the wavelength of emission peak, relative emission-peak intensity, full width at half maximum of the emission peak, relative brightness, color coordinate, absorption efficiency, internal quantum efficiency, external quantum efficiency and non-luminous object color based on L$^*$, a$^*$ and b$^*$ color space (sic) were measured, by the same method as described for Examples 34 to 36. The results are presented in Table 38 and Table 39. For Examples 44 and 45, their weight-average median diameters are also presented in Table 39.

[Table 38]

Table 38

| Production Example | Luminance characteristics | | | | | |
|---|---|---|---|---|---|---|
| | Emission-peak wavelength (nm) | Relative emission-peak intensity (%) | Full width at half maximum of the emission peak (nm) | Relative brightness (%) | Color coordinate | |
| | | | | | x value | y value |
| Example 44 | 527 | 249 | 67 | 162 | 0.275 | 0.638 |
| Example 45 | 528 | 244 | 67 | 164 | 0.285 | 0.635 |
| Example 46 | 524 | 249 | 68 | 154 | 0.261 | 0.648 |
| Example 47 | 523 | 245 | 67 | 152 | 0.259 | 0.650 |
| Example 48 | 522 | 248 | 66 | 155 | 0.257 | 0.647 |
| Example 49 | 524 | 245 | 66 | 153 | 0.261 | 0.648 |
| Example 50 | 523 | 256 | 67 | 162 | 0.267 | 0.648 |

[Table 39]

Table 39

| | Emission efficiency | | | Non-luminous object color | | | | Weight-average median diameter (μm) |
|---|---|---|---|---|---|---|---|---|
| | Absorption efficiency $\alpha_q$ | Internal quantum efficiency $\eta_i$ | External quantum efficiency $\eta_o$ | $L^*$ | $a^*$ | $b^*$ | $a^*/b^*$ | |
| Example 44 | 0.78 | 0.71 | 0.55 | 103.1 | -38.03 | 64.52 | -0.59 | 18 |
| Example 45 | 0.77 | 0.73 | 0.56 | 103.8 | -38.69 | 67.71 | -0.57 | 21 |
| Example 46 | 0.79 | 0.73 | 0.58 | 103.1 | -32.87 | 56.06 | -0.59 | - |
| Example 47 | 0.68 | 0.75 | 0.51 | 104.3 | -37.92 | 64.35 | -0.59 | - |
| Example 48 | 0.71 | 0.75 | 0.53 | 102.5 | -32.48 | 51.48 | -0.63 | - |
| Example 49 | 0.79 | 0.73 | 0.57 | 102.9 | -36.41 | 59.93 | -0.61 | - |
| Example 50 | 0.80 | 0.72 | 0.58 | 103.7 | -37.29 | 64.90 | -0.57 | - |

From the results shown in Table 38 and Table 39, it is evident that the phosphors of Examples 45, 47 to 50, which contain Tb, possess luminescent characteristics equal to or better than those of Examples 44 and 46, which do not contain Tb.

Subsequently, for the phosphors of Examples 46 to 50, the brightness retention rate was evaluated by the following method.

The measurement was performed using an emission spectrum measurement device of multi-channel spectrum analyzer, MCPD7000, manufactured by Otsuka Electronics Co., Ltd., a stage equipped with a cooling mechanism using a peltiert device and a heating mechanism using a heater, and a light source device equipped with a 150W xenon lamp and a spectroscope.

A cell holding the phosphor sample was put on the stage, and the temperature was changed within the range of from 20 °C to 180 °C. It was verified that the surface temperature of the phosphor sample was held constant at the predetermined temperature. Then the emission spectrum of the phosphor sample was measured, when it was excited with a light from the light source having wavelength of 455 nm, which was separated with a diffraction grating. The brightness was decided from the measured emission spectrum. As the measurement value of the surface temperature of the phosphor sample, a value corrected by utilizing temperature values measured with a radiation thermometer and a thermocouple was used.

The brightness retention rate was calculated as the relative amount of the brightness at 100 °C relative to that at 25 °C, which was obtained by the above procedure.

Specifically, the brightness retention rate was calculated as $\{I_{455}(100)/I_{455}(25)\}$, wherein $I_{455}(25)$ indicates the brightness obtained by excitation with a light of 455nm peak wavelength at 25 °C and $I_{455}(100)$ indicates the brightness obtained by excitation with a light of 455nm peak wavelength at 100 °C.

The brightness retention rates obtained for the phosphors of Examples 46 to 50 are shown in Table 40 below.
[Table 40]

Table 40

| | Tb content (%) [8] | Brightness retention rate $\{I_{455}(100)/I_{455}(25)\}$ |
|---|---|---|
| Example 46 | 0 | 0.67 |
| Example 47 | 0.05 | 0.71 |
| Example 48 | 0.1 | 0.74 |
| Example 49 | 0.2 | 0.60 |
| Example 50 | 0.5 | 0.50 |
| [8] : represented by the ratio of number of moles (%) of Tb, relative to number of moles of silicon (Si) in the phosphor | | |

As is evident from the results shown in Table 40, apparent improvements of brightness retention rate were observed in the phosphor of Example 47, which contains 0.05 mole percent of Tb, and in the phosphor of Example 48, which contains 0.1 mole percent of Tb, in comparison with the phosphor of Example 46, which contains no Tb. On the contrary, in the phosphors of Examples 49 and 50, which contain Tb with further more concentration, the brightness retention rates tend to decrease.

The above results are considered to be derived from the effect of improving temperature characteristics could be achieved due to the fact that coexistence of Eu ion and another ion (in this case, Tb ion) induced the decrease in non-radiative relaxation amount of Eu emission.

It is inferred that the same effect can be also achieved with ions of other rare-earth or ions of metals belonging to IB group in periodic table, according to the investigation by the present inventors.

[Example 51]

A light emitting device was prepared by the same method as described for Example 40, except that the following points. As the blue LED, C460MB290 (manufactured by Cree, Inc., having luminous wavelength of 460 nm) was used. As the luminescent material in phosphor-containing resinous part (22), the phosphor of Example 44 alone was used. The inorganic material used in the above-mentioned Example 43 was added, in place of epoxy resin, with weight ratio of 6:100, relative to the phosphor weight, and aerosil (COK84, manufactured by Nippon Aerojil) was also added, thereby to prepare the phosphor slurry (phosphor-containing composition). When the obtained light emitting device was driven to emit light in the same condition as in Example 40, namely, by energizing the blue LED with a current of 20 mA, a blue green light could be obtained.

[Example 52]

A light emitting device was prepared by the same method as described for Example 51, except that the phosphor of Example 45 was used in place of the phosphor of Example 44. When the obtained light emitting device was driven to emit light by the same condition as in Example 51, a blue green light could be obtained.

A durability tests were performed for the light emitting devices obtained in Examples 51 and 52, by the following procedure.

At the time just after turning on (this point of time will be hereinafter referred to as "0 hour") of the light emitting device, the emission spectrum and color coordinate were measured using a fiber multi-channel spectroscope (USB2000, manufactured by Ocean Optics, Inc.). After the light emitting device is lit on continuously for 1000 hours (this point of time will be hereinafter referred to as "1000 hours") with driving current of 20 mA at a temperature of 85 °C and relative humidity of 85 %, using an aging system, LED AGING SYSTEM 100ch LED environment tester (YEL-51005, manufactured by Yamakatsu Electronics Industry Co., Ltd.), the emission spectrum and color coordinates x and y were measured again using a fiber multi-channel spectroscope (USB2000, manufactured by Ocean Optics, Inc.).

By calculating the ratio of the emission intensity of the green peak (originating from the phosphor) relative to the emission intensity of the blue peak (originating from the LED), namely "emission intensity of green peak / emission intensity of blue peak", of each measured emission spectrum, the value of the "emission intensity of green peak / emission intensity of blue peak" at the time of 1000 hours, when the value of the "emission intensity of green peak / emission intensity of blue peak" at 0 hour was 100 % was determined. This value (%) was taken as the result of the durability test.

The results of the durability test (%) obtained for the light emitting devices in Example 51 and 52 and the color coordinates x and y at 0 hour and 1000 hours are shown in Table 41 below.

[Table 41]

Table 41

| Light emitting device | Phosphor | Tb content (%) *9 | Result of durability test (%) | Change in color coordinate | | | |
|---|---|---|---|---|---|---|---|
| | | | | 0 hour | | 100 hours | |
| | | | | x value | y value | x value | y value |
| Example 51 | Example 44 | 0 | 90.6 | 0.179 | 0.214 | 0.175 | 0.197 |
| Example 52 | Example 45 | 0.1 | 97.0 | 0.182 | 0.233 | 0.180 | 0.226 |
| *9 : represented by the ratio of number of moles (%) of Tb, relative to number of moles of silicon (Si) in the phosphor | | | | | | | |

From the results shown in the above Table 41, it is evident that the light emitting device in Example 52, which used the phosphor of Example 45 containing Tb, exhibited superior durability to the light emitting device in Example 51, which used the phosphor of Example 44 containing no Tb. In addition, from the results of the color coordinates, which show that the changes in y values after turning on the device for 1000 hours were 0.007 in Example 52 and 0.017 in Example 51, it is evident that the color shift of Example 52 was smaller.

Considering the results of the Examples 51 and 52, comprehensively with the above-mentioned Examples 44 and 45, it is clear that, even if Tb is added to the phosphor having compositions represented by the above-mentioned formula [1], the phosphors having the same luminescent characteristics as the phosphors without Tb, can be obtained, and a light emitting device that utilizes this phosphor, as described in Example 52, excels in durability.

[Production of phosphor (Reference Example)]

Finally, of the phosphors used for the production of the light emitting device in each Example and Comparative Example mentioned above, the phosphors whose method of production has not yet been described will be explained below as Reference Example.

(Reference Example 1: Production of $CaAlSiN_3$:Eu)

Each material powder was weighed out to give molar ratios of 0.3306 mole of $Ca_3N_2$, 1 mole of AlN, 0.363 mole of $Si_3N_4$ and 0.004 mole of $Eu_2O_3$, relative to 1 mole of the phosphor, so that the chemical composition ratio of the phosphor produced was $Ca_{0.992}AlEu_{0.008}SiN_3$. These were mixed using a desktop mixer and fired in a boron nitride crucible at a maximum temperature of 1800 °C for 2 hours in a nitrogen atmosphere of 0.5 MPa. The fired powder obtained was pulverized in an alumina mortar and sieved through a nylon mesh of 450 $\mu$m and 224 $\mu$m. The powder was then stirred in purified water for 1 hour and pulverized with a ball mill. Subsequently, by classification treatment to adjust particle size and drying, a phosphor of $Ca_{0.992}AlEu_{0.008}SiN_3$ was produced.

(Reference Example 2: Production of $Sr_2Si_5N_8$:Eu)

A phosphor of $Sr_2Si_5N_8$:Eu was produced by two methods explained below. In the following description, the method used in Reference Example 2A is called "imide / amide method", and the method used in Reference Example 2B is called "conventional method", as appropriate. In the above Example 43, the phosphor of $(Sr_{0.992}Eu_{0.008})_2Si_5N_8$, obtained by the method (imide / amide method) of Reference Example 2A, was used.

<Reference Example 2A (imide / amide method)>

SrNH was prepared first by the following method.
In a glove box filled with high purity argon gas, 3.1566 g of Sr metal was weighed out with an electronic balance and put on an $Al_2O_3$ boat. This was placed in a quartz glass tube and a valve was fitted to both ends of the tube, followed by sealing. This quartz glass tube was taken out of the glove box and placed in a tubular furnace. Then the tip of both valves was connected to an ammonia gas line. After the vacuum was induced in the quartz tube until the pressure was around $5 \times 10^{-3}$ Pa, the rotary pump was stopped and high purity ammonia gas was allowed to flow for 1 hour. After that, the temperature was raised to 250 °C over a period of 1 hour and that temperature was maintained for 1 hour. Further, the temperature was raised to 650 °C over a period of 2 hours, that temperature was maintained for 4 hours, and then the tube was allowed to cool to room temperature. After firing, the quartz glass tube was transferred to the glove box and retained there with the valves at both ends remaining closed. The SrNH thus obtained was used as starting material of the phosphor described later.

Subsequently, a phosphor of $Sr_2Si_5N_8$:Eu was prepared by the following method.
As phosphor materials, 0.4638 g of SrNH mentioned above, 0.5283 g of $Si_3N_4$ (manufactured by Ube Industries, Ltd.) and 0.0080 g of $Eu_2O_3$ (manufactured by Shin-Etsu Chemical Co., Ltd.) were used so as to give a composition ratio of $(Sr_{0.992}Eu_{0.008})_2Si_5N_3$. These phosphor materials were weighed out with an electronic balance in a glove box filled with high purity argon gas. All these phosphor materials were mixed and powdered in an alumina mortar placed in the glove box until they were homogeneous, the mixed powder was placed in a boron nitride crucible, and compression-molded by applying a slight weight. This boron nitride crucible was placed in a resistance-heating type vacuum pressurized-atmosphere heat-treating furnace, manufactured by Fujidenpa Kogyo Co., Ltd. and the pressure in the furnace was reduced to lower than $5 \times 10^{-3}$ Pa, which was mostly vacuum. Then, the temperature was raised from room temperature to at a rate of 20 °C/minute, and then nitrogen gas of high purity (99.9995 %) was started to be introduced at the point of the temperature reaching 800 °C. Nitrogen gas was passed for 30 minutes until the pressure in the furnace was 0.92 MPa, while the temperature in the furnace was maintained at 800 °C. The temperature was further raised to 1200 °C at a rate of 20 °C/minutes, while the high purity nitrogen gas pressure was maintained at 0.92 MPa. That temperature was maintained for 5 minutes, and a radiation thermometer was changed from a thermocouple to a radiation thermometer. While measuring the temperature with the radiation thermometer, the temperature was raised again to 1600 °C at a rate of 20 °C/minute, which temperature was maintained for further 2 hours. The temperature was further raised to 1800 °C at a rate of 20 °C/minute, which temperature was maintained for 2 hours. After that, the temperature was lowered to 1200 °C at a rate of 20 °C/minute, and the product was then allowed to cool spontaneously. The fired product obtained was powdered for 30 minutes using an alumina mortar in air to obtain a powder of the phosphor of $(Sr_{0.992}Eu_{0.008})_2Si_5N_8$. The phosphor of $(Sr_{0.992}Eu_{0.008})_2Si_5N_8$ obtained by the above method (imide / amide method) will be called hereinafter the phosphor of Reference Example 2A.

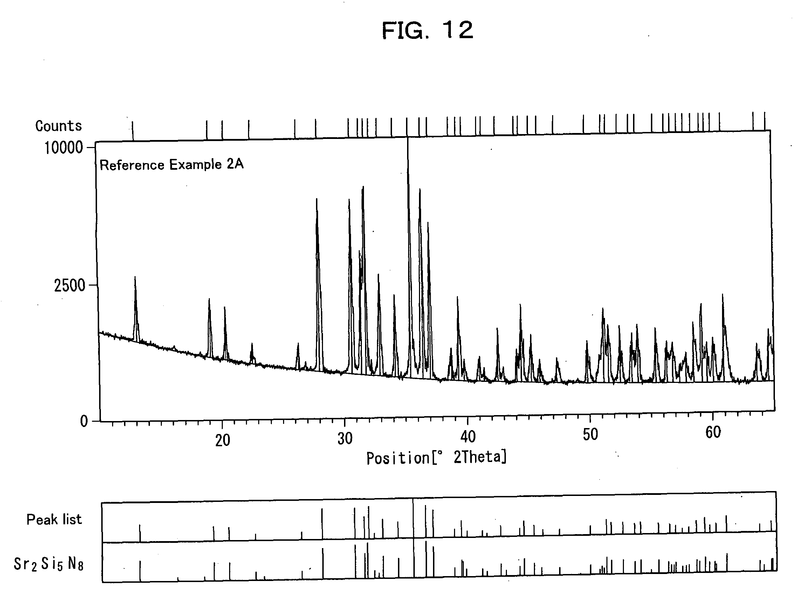

X-ray powder diffraction pattern was measured for the obtained phosphor of Reference Example 2A. The X-ray powder diffraction spectrum obtained is shown in Fig. 12. From Fig. 12, it is evident that, in the phosphor of Reference Example 2A, an almost single phase comprising $Sr_2Si_5N_8$ is formed.

<Reference Example 2B (conventional method)>

Each material was weighed out to give molar ratios of 1.96 mole of $SrCO_3$, 1.66 mole of $Si_3N_4$ and 0.02 mole of $Eu_2O_3$, so that the composition ratio was $(Sr_{0.98}Eu_{0.02})_2Si_5N_8$. These were mixed well. The mixture of material obtained was transferred to a carbon (graphite) crucible and fired in a resistance-heating type vacuum pressurized-atmosphere heat-treating furnace, manufactured by Fujidenpa Kogyo Co., at 1800 °C for 2 hours under a pressure of 0.92 MPa (primary firing). After firing, the fired mixture was pulverized in an alumina mortar and the mixture was again fired in a boron nitride crucible in a resistance-heating type vacuum pressurized-atmosphere heat-treating furnace, manufactured by Fujidenpa Kogyo Co., at 1800 °C for 2 hours under a pressure of 0.92 MPa (secondary firing). The fired product was pulverized in an alumina mortar to obtain a phosphor powder of $(Sr_{0.98}Eu_{0.02})_2Si_5N_8$. The phosphor of $(Sr_{0.98}Eu_{0.02})_2Si_5N_8$, obtained by the above method (conventional method), will be called the phosphor of Reference Example 2B.

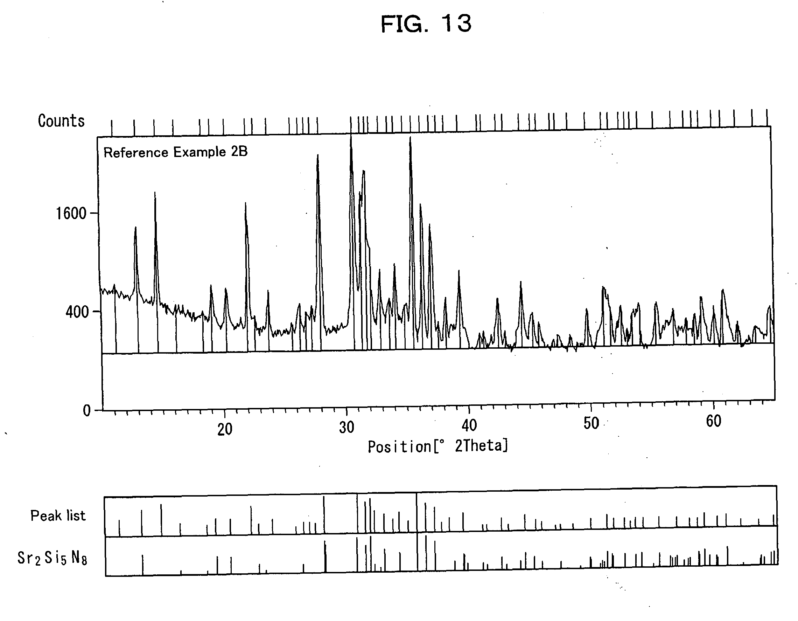

X-ray powder diffraction pattern was measured for the obtained phosphor of Reference Example 2B. The X-ray powder diffraction spectrum obtained is shown in Fig. 13. From Fig. 13, it is evident that, in the phosphor of Reference Example 2B also, an almost single phase comprising $Sr_2Si_5N_8$ is formed.

<Comparison of Reference Example 2A (imide / amide method) and Reference Example 2B (conventional method)>

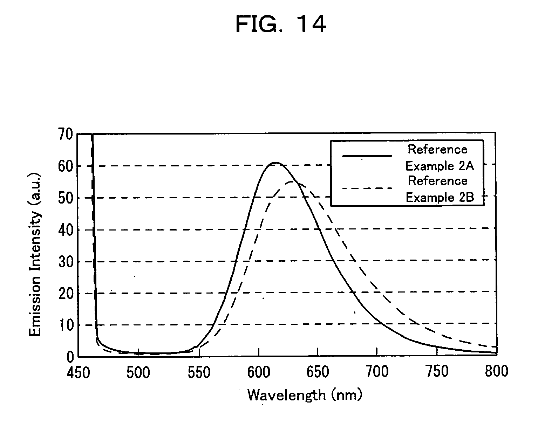

For the phosphors of Reference Example 2A and Reference Example 2B, the emission spectrum was measured at an excitation wavelength of 455 nm. The result is shown in Fig. 14.

From the emission spectra in Fig. 14, each full width at half maximum of the emission peak was calculated for the phosphors of Reference Example 2A and Reference Example 2B. The full width at half maximum of the emission peak of the phosphor of Reference Example 2B was 83 nm (sic), whereas the full width at half maximum of the emission peak of the phosphor of Reference Example 2A was 96 nm (sic). From the data, it is evident that the production method of the phosphor of Reference Example 2A (namely, imide / amide method) could make the full width at half maximum of the emission peak narrower by 13 nm and, in addition, shift the emission peak to shorter wavelength region.

From the emission spectra in Fig. 14, brightnesses of the phosphors of Reference Example 2A and Reference Example B were calculated. The brightness of the phosphor of Reference Example 2A improved about 1.3 times higher than that of the phosphor of Reference Example 2B. The content of Eu is different between the phosphor of Reference Example 2A and phosphor of Reference Example 2B but this difference in Eu content is considered not to affect full width at half maximum or brightness significantly, and the improvement is considered to be due to the difference in method of production.

From the above findings, it is evident that, by producing a phosphor using the production method of Reference Example 2A (namely, imide / amide method), the phosphor obtained can have narrower full width at half maximum of the emission peak, shorter wavelength of emission peak and higher brightness.

The production method of Reference Example 2A (imide / amide method) is characterized in that imide compound or amide compound (SrNH for the present Reference Example) containing a constituent element of the phosphor is used as material.

SrNH has a lower oxygen content than $SrCO_3$, used for Reference Example 2B, and, therefore, its use as a phosphor material is considered to lead to lower oxygen content in the phosphor, bringing about higher brightness of the phosphor.

$Sr_2N$ can also be used as a source for Sr in a phosphor. However, $Sr_2N$ is unstable in air and, since the ratio of N is low relative to Sr, the phosphor obtained is liable to produce crystal defect.

In contrast, in SrNH, the ratio of N relative to Sr is higher than that of $Sr_2N$, and therefore, crystal defect in the phosphor is less likely to occur. As a result, it is considered that crystallinity of the phosphor improves and effect of improving brightness can be obtained.

Further, hydrogen (H) contained in SrNH reacts with oxygen (O) during firing to form water ($H_2O$) and therefore oxygen concentration in the phosphor obtained is considered to be lowered further accordingly.

By using SrNH as phosphor material, oxygen concentration of phosphors decreases, and crystallinity and purity of the phosphors obtained improve, as described above, leading possibly to such advantageous effects as not only improved brightness of the phosphor obtained but also sharpened peak of the emission spectrum (namely, narrower full width at half maximum of the emission peak) of the phosphor, which is due to greater homogenization of environment surrounding the activation element such as Eu.

(Reference Example 3: Production of $Sr_{0.8}Ca_{0.2}AlSiN_3$:Eu)

<Production of mother alloy>

Each metal was weighed out so as to give a metal element composition ratio of Al:Si = 1:1 (molar ratio). The material metal was fused in a graphite crucible using a high frequency induction fusion furnace in an atmosphere of argon. The fused metal was then poured into a mold from the crucible and allowed to solidify to obtain an alloy having a metal element composition of Al:Si = 1:1. This alloy will be called "mother alloy" hereinafter.

<Production of alloy for phosphor precursor>

The above mother alloy and other material metals were weighed out so as to give a metal element ratio of Eu: Sr:Ca:Al:Si = 0.008:0.792:0.2:1:1 (molar ratio). Air was evacuated from the furnace until the pressure was $5 \times 10^{-2}$ Pa and then argon was introduced into the furnace to a predetermined pressure. In this furnace, the mother alloy, and then Sr, were fused in a calcia crucible and the fused metal was poured into a mold and allowed to solidify. This alloy will be called "alloy for phosphor precursor" hereinafter.

<Production of phosphor>

After the alloy for phosphor precursor obtained was subjected to coarse milling in an alumina mortar under nitrogen atmosphere, it was pulverized in nitrogen atmosphere using a supersonic jet pulverizer under a pulverizing pressure of 0.15 MPa at a material-feeding speed of 0.8 kg/hour. The alloy powder obtained was washed with water, subjected to classification treatment and dried, thereby to give a phosphor of $Sr_{0.792}Ca_{0.200}AlEu_{0.008}SiN_3$.

(Reference Example 4: Production of $BaMgAl_{10}O_{17}$:Eu)

Each material powder was weighed out to give molar ratios of 0.7 mole of $BaCO_3$, 1 mole of $MgCO_3$, 0.15 mole of $Eu_2O_3$ and 5 mole of $\gamma$-$Al_2O_3$, relative to 1 mole of the phosphor, so that the chemical composition ratio of the phosphor produced was $Ba_{0.7}Eu_{0.3}MgAl_{10}O_{17}$. These were mixed in a bag and passed through a nylon mesh of 224 $\mu$m. The mixture obtained was fired in an alumina crucible at a maximum temperature of 1550 °C for 5 hours in an atmosphere containing carbon monoxide gas in the presence of solid carbon. After being cooled, the fired powder was pulverized with a pestle in an alumina mortar, washed with water, subjected to classification treatment and dried, thereby to produce $Ba_{0.7}Eu_{0.3}MgAl_{10}O_{17}$.

Industrial Applicability

There is no special limitation on the use of the phosphor of the present invention, and it can be used for any fields in which an usual phosphor is used. However, it is suitable for realizing a luminous body for a general illumination that is excited by a light source such as near-ultraviolet LED or blue LED, particularly a white luminous body for a back-lighting with high brightness and wide color reproduction range, making the most of its characteristics such as superior conversion efficiency of blue light or near-ultraviolet light and excellent color purity.

The light emitting device of the present invention, which utilizes the phosphor of the present invention having the above-mentioned characteristics, can be used for various fields in which an usual light emitting device is used. Among them, it can be preferably used particularly as a light source of a display or a lighting system.

The present invention has been explained in detail above with reference to specific embodiments. However, it is evident to those skilled in the art that various modifications can be added thereto without departing from the intention and the scope of the present invention.

The present application is based on the description of Japanese Patent Application No. 2006-034393, filed on February 10, 2006, Japanese Patent Application No. 2006-243165, filed on September 7, 2006, and Japanese Patent Application No. 2007-30442, filed on February 9, 2007 and their entireties are incorporated herewith by reference.

**Claims**

1. A phosphor satisfying the following conditions (i) to (v):

> (i) the wavelength of emission peak thereof is 510 nm or longer and 542 nm or shorter, when excited with a light of which peak wavelength is 400 nm or 455 nm,
> (ii) the full width at half maximum of the emission peak thereof is 75 nm or narrower, when excited with a light of which peak wavelength is 400 nm or 455 nm,
> (iii) the external quantum efficiency, which is defined by the formula below, is 0.42 or larger, when excited with a light of which peak wavelength is 400 nm or 455 nm,

$$(external \ quantum \ efficiency) = (internal \ quantum \ efficiency) \times (absorption \ efficiency)$$

> (iv) at least a part of the surface of said phosphor comprises substance containing oxygen, and
> (v) said phosphor contains a metal element (hereinafter referred to as "$M^{II}$ element") of which valence can be 2 or 3 and the molar ratio of said $M^{II}$ element, to the total number of moles of bivalent elements contained in said phosphor, is larger than 1 % and smaller than 15 %.

2. A phosphor according to Claim 1, wherein
the CIE color coordinate x and y of its luminescent color falls within the following ranges respectively, when excited with a light of which peak wavelength is 400 nm or 455 nm.
$0.210 \leq x \leq 0.330$, and
$0.480 \gamma y \leq 0.670$

3. A phosphor according to Claim 1 or Claim 2, wherein
said phosphor contains at least Ba as the bivalent element (hereinafter referred to as "$M^{I}$ element"), and
the molar ratios of Ba and Sr, represented by [Ba] and [Sr] respectively, to the whole $M^{I}$ elements satisfy the condition of

$$0.5 < \{[Ba]/([Ba]+[Sr])\} \leq 1.$$

4. A phosphor having a chemical composition represented by the formula [1] below, wherein
$L^{*}$, $a^{*}$ and $b^{*}$, when the non-luminous object color is represented by $L^{*}$, $a^{*}$ and $b^{*}$ color space (sic), satisfy the conditions of
$L^{*} \geq 90$,
$a^{*} \leq -20$,
$b^{*} \geq 30$, and

$$\{a^{*}/b^{*}\} \leq -0.45.$$

[Chemical Formula 1]

$$(M^{I}_{(1-x)} M^{II}_{x})_{\alpha} Si O_{\beta} \qquad [1]$$

(In the above formula [1],
$M^{I}$ represents at least one or more element(s) selected from the group consisting of Ba, Ca, Sr, Zn and Mg,
$M^{II}$ represents at least one or more metal element(s) of which valence can be 2 or 3, and
x, $\alpha$ and $\beta$ are the numbers falling within the following ranges, respectively:

0.01<x<0.3,
1.5≤α≤2.5, and
3.5≤β≤4.5.)

**5.** A phosphor according to Claim 4, wherein
said phosphor is produced by firing a phosphor precursor in the presence of a flux.

**6.** A phosphor according to Claim 4 or Claim 5, wherein
said phosphor is produced by firing a phosphor precursor in a highly reducing atmosphere.

**7.** A phosphor according to any one of Claims 4 to 6, wherein,
in the above formula [1], $M^I$ contains at least Ba, and
the molar ratio of said Ba to the entire $M^I$ is larger than 0.5 or larger and smaller than 1.

**8.** A phosphor according to any one of Claims 4 to 7, wherein,
in the above formula [1], $M^I$ contains at least Ba and Sr, and
the molar ratios of Ba and Sr, represented by [Ba] and [Sr] respectively, to the whole $M^I$ elements satisfy the condition of

$$0.5 < \{[Ba]/([Ba]+[Sr])\} \leq 1.$$

**9.** A phosphor according to any one of Claims 4 to 8, wherein,
the weight-average median diameter of said phosphor is 10 μm or larger and 30 μm or smaller.

**10.** A phosphor according to any one of Claims 4 to 9, wherein,
other than the elements included in the above formula [1], at least one element selected from the group consisting of elements having valence of 1, 2, 3, -1 and -3 is further contained, and the total content of such element is 1 ppm or more.

**11.** A phosphor according to Claim 10, wherein,
other than the elements included in the above formula [1], at least one element selected from the group consisting of alkali metal element, alkaline-earth metal element, zinc (Zn), yttrium (Y), aluminium (Al), scandium (Sc), phosphorus (P), nitrogen (N), rare-earth element and halogen element is further contained, and the total content of such element is 1 ppm or more.

**12.** A method for producing a phosphor according to any one of Claims 1 to 11, comprising a step of:

firing a phosphor precursor in an atmosphere of which oxygen concentration is 100 ppm or lower.

**13.** A method for producing a phosphor according to any one of Claims 1 to 11, comprising a step of:

firing a phosphor precursor in the presence of a solid carbon.

**14.** A method for producing a phosphor, according to Claim 12 or Claim 13, wherein
other than sources for the $M^I$, $M^{II}$ and Si, two or more kinds of compounds are used, which are selected from the group consisting of a compound including monovalent element or atomic group and minus monovalent element, compound including monovalent element or atomic group and minus trivalent element or atomic group, compound including bivalent element and minus monovalent element, compound including bivalent element and minus trivalent element or atomic group, compound including trivalent element and minus monovalent element, and compound including trivalent element and minus trivalent element or atomic group.

**15.** A method for producing a phosphor, according to any one of Claims 12 to 14, wherein
other than sources for the $M^I$, $M^{II}$ and Si, two or more kinds of compounds are used, which are selected from the group consisting of an alkali metal halide, alkaline-earth metal halide, zinc halide, halide of trivalent element selected from the group consisting of Y, Al, Sc and rare-earth element, alkali metal phosphate, alkaline-earth metal phosphate, zinc phosphate, and phosphate of trivalent element selected from the group consisting of Y, Al, La and Sc.

**16.** A method for producing a phosphor, according to any one of Claims 12 to 15, wherein
a flux having crystal growth promoting effect and a flux having crystal growth inhibiting effect are used in combination.

**17.** A phosphor-containing composition comprising said phosphor according to any one of Claims 1 to 11 and a liquid medium.

**18.** A light emitting device comprising a first luminous body and a second luminous body which emits visible light when irradiated with light from said first luminous body, wherein
said second luminous body comprises, as a first phosphor, at least one kind of said phosphor according to any one of Claims 1 to 11.

**19.** A light emitting device according to Claim 18, wherein
said second luminous body comprises, as a second phosphor, at least one kind of a phosphor of which wavelength of emission peak is different from that of said first phosphor.

**20.** A light emitting device according to Claim 19, wherein
said first luminous body has an emission peak in the range of 420 nm or longer and 500 nm or shorter, and
said second luminous body comprises, as the second phosphor, at least one kind of a phosphor having an emission peak in the range of 570 nm or longer and 780 nm or shorter.

**21.** A light emitting device according to Claim 19, wherein
said first luminous body has an emission peak in the range of 300 nm or longer and 420 nm or shorter, and
said second luminous body comprises, as the second phosphor, at least one kind of a phosphor having an emission peak in the range of 420 nm or longer and 470 nm or shorter and at least one kind of a phosphor having an emission peak in the range of 570 nm or longer and 780 nm or shorter.

**22.** A light emitting device according to Claim 19, wherein
said first luminous body has an emission peak in the range of 420 nm or longer and 500 nm or shorter, and
said second luminous body comprises, as the second phosphor, at least one kind of a phosphor having an emission peak in the range of 580 nm or longer and 620 nm or shorter.

**23.** A display comprising a light emitting device according to any one of Claims 18 to 22 as a light source.

**24.** A lighting system comprising a light emitting device according to any one of Claims 18 to 22 as a light source.

FIG. 1

FIG. 2(a)

FIG. 2(b)

# FIG. 3

# FIG. 4

# FIG. 5

## FIG. 6

## FIG. 7

## FIG. 8

## FIG. 9

# FIG. 10

# FIG. 11

# FIG. 12

Reference Example 2A

Counts — Position[° 2Theta]

Peak list

Sr₂Si₅N₈

## FIG. 13

Reference Example 2B

Peak list

Sr$_2$Si$_5$N$_8$

FIG. 14

## INTERNATIONAL SEARCH REPORT

International application No.

PCT/JP2007/052405

A. CLASSIFICATION OF SUBJECT MATTER
*C09K11/59*(2006.01)i, *C09K11/08*(2006.01)i, *H01L33/00*(2006.01)i, *H01J61/44*
(2006.01)n

According to International Patent Classification (IPC) or to both national classification and IPC

B. FIELDS SEARCHED

Minimum documentation searched (classification system followed by classification symbols)
C09K11/08-11/89, H01L33/00, H01J61/44

Documentation searched other than minimum documentation to the extent that such documents are included in the fields searched
Jitsuyo Shinan Koho        1922-1996   Jitsuyo Shinan Toroku Koho   1996-2007
Kokai Jitsuyo Shinan Koho   1971-2007   Toroku Jitsuyo Shinan Koho   1994-2007

Electronic data base consulted during the international search (name of data base and, where practicable, search terms used)
CA(STN), JST7580(JDream2), JSTPlus(JDream2)

C. DOCUMENTS CONSIDERED TO BE RELEVANT

| Category* | Citation of document, with indication, where appropriate, of the relevant passages | Relevant to claim No. |
|---|---|---|
| A | WO 2004/111156 A1 (PHOSPHORTECH CORP.), 23 December, 2004 (23.12.04), Full text & US 6982045 B2        & JP 2007-500776 A | 1-3 |
| A | WO 2003/021691 A1 (Matsushita Electric Industrial Co., Ltd.), 13 March, 2003 (13.03.03), Claims 10 to 11; examples & EP 1367655 A1        & US 2005/227569 A1 | 1-3 |
| A | JP 2005-520916 A (Koninklijke Philips Electronics N.V.), 14 July, 2005 (14.07.05), Claims; Par. Nos. [0041] to [0048] & EP 1490453 A1        & WO 2003/080763 A1 | 1-3 |

☒ Further documents are listed in the continuation of Box C.          ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

Date of the actual completion of the international search
08 May, 2007 (08.05.07)

Date of mailing of the international search report
22 May, 2007 (22.05.07)

Name and mailing address of the ISA/
Japanese Patent Office

Authorized officer

Facsimile No.

Telephone No.

Form PCT/ISA/210 (second sheet) (April 2005)

**INTERNATIONAL SEARCH REPORT**

| International application No. |
| --- |
| PCT/JP2007/052405 |

C (Continuation). DOCUMENTS CONSIDERED TO BE RELEVANT

| Category* | Citation of document, with indication, where appropriate, of the relevant passages | Relevant to claim No. |
| --- | --- | --- |
| A | JP 2005-63837 A (Mitsubishi Chemical Corp.), 10 March, 2005 (10.03.05), Claims; Par. No. [0010]; table 1 (Family: none) | 1-3 |
| A | JP 2004-115633 A (Matsushita Electric Industrial Co., Ltd.), 15 April, 2004 (15.04.04), Claims; examples (Family: none) | 1-3 |

Form PCT/ISA/210 (continuation of second sheet) (April 2005)

EP 1 995 294 A1

## INTERNATIONAL SEARCH REPORT

International application No.

PCT/JP2007/052405

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III    Observations where unity of invention is lacking (Continuation of item 3 of first sheet)**

This International Searching Authority found multiple inventions in this international application, as follows:
        The invention of claim 1 relates to a phosphor satisfying the conditions (i)-(v), while the invention of claim 4 relates to a phosphor having a chemical composition represented by the formula [1] and having L*, a* and b* within specific ranges.  Although the technical feature common to both of the inventions is "a phosphor containing a metal element which can be divalent or trivalent", this technical feature is not a special technical feature within the meaning of PCT Rule 13.2 without the need of mentioning relevant documents.
        Consequently, this international application contains two inventions which are not so linked as to form a single general inventive concept.

1. ☐ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☒ No required additional search fees were timely paid by the applicant.   Consequently, this international search report is restricted to the invention first mentioned in the claims; it is covered by claims Nos.:  1-3

**Remark on Protest**
the

☐ The additional search fees were accompanied by the applicant's protest and, where applicable, payment of a protest fee..

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2005)

**EP 1 995 294 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6982045 B
- JP HEI2209989 B
- JP HEI2233794 B
- JP HEI3231987 B
- JP HEI6314593 B
- JP 2002223008 A
- JP 2005082788 A
- JP 2006028458 A
- JP 2006047274 A
- JP 2006047277 A
- JP 2006176468 A
- JP 2004300247 A
- JP 2005884506 A
- JP 2841377 B
- JP 3094113 B
- JP 3168850 B
- JP 2002169025 A
- JP 2003029030 A
- BR 042803 A
- JP 2006034393 A
- JP 2006243165 A
- JP 2007030442 A